# EUROPEAN PATENT SPECIFICATION

(11) **EP 4 243 055 B1**
(45) Date of publication and mention of the grant of the patent: **28.01.2026**
(21) Application number: 21888980.6
(22) Date of filing: 11.10.2021
(51) Int. Cl.: H01L 23/485, H01L 23/532, H10F 39/00, H04N 25/79, H01L 21/768

(54) **IMAGING DEVICE AND METHOD FOR MANUFACTURING IMAGING DEVICE**
BILDGEBUNGSVORRICHTUNG UND VERFAHREN ZUR HERSTELLUNG DER BILDGEBUNGSVORRICHTUNG
DISPOSITIF D'IMAGERIE ET SON PROCÉDÉ DE FABRICATION

(30) Priority: 09.11.2020 JP 2020186610; 11.08.2021 JP 2021131322
(43) Date of publication of application: 13.09.2023
(73) Proprietor: Sony Semiconductor Solutions Corporation, Atsugi-shi, Kanagawa 243-0014 (JP)
(72) Inventor: MOCHIZUKI, Takeya, Atsugi-shi, Kanagawa 243-0014 (JP); NAKAZAWA, Keiichi, Atsugi-shi, Kanagawa 243-0014 (JP); YOSHIDA, Shinichi, Atsugi-shi, Kanagawa 243-0014 (JP); NISHIO, Kenya, Atsugi-shi, Kanagawa 243-0014 (JP); FUJII, Nobutoshi, Atsugi-shi, Kanagawa 243-0014 (JP); SAITO, Suguru, Atsugi-shi, Kanagawa 243-0014 (JP); OKAMOTO, Masaki, Atsugi-shi, Kanagawa 243-0014 (JP); KAMATANI, Ryosuke, Atsugi-shi, Kanagawa 243-0014 (JP); YAMAMOTO, Yuichi, Atsugi-shi, Kanagawa 243-0014 (JP); IZUKASHI, Kazutaka, Atsugi-shi, Kanagawa 243-0014 (JP); MIYANAMI, Yuki, Atsugi-shi, Kanagawa 243-0014 (JP); YOSHIOKA, Hirotaka, Atsugi-shi, Kanagawa 243-0014 (JP); HORIKOSHI, Hiroshi, Atsugi-shi, Kanagawa 243-0014 (JP); KUROTORI, Takuya, Atsugi-shi, Kanagawa 243-0014 (JP); FURUSE, Shunsuke, Atsugi-shi, Kanagawa 243-0014 (JP); HONDA, Takayoshi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2021/037502
(87) International publication number: WO 2022/097427

(56) References cited:
- EP-A1- 3 734 660
- WO-A1-2016/009943
- WO-A1-2018/186197
- WO-A1-2018/186197
- WO-A1-2019/150981
- WO-A1-2020/105713
- JP-A- 2018 129 412
- US-A- 5 641 991

## Description

### Field

The present disclosure relates to an imaging device, a method of manufacturing an imaging device.

### Background

Conventionally, miniaturization of an area per pixel of an imaging device having a two-dimensional structure has been achieved by introduction of process shrink and improvement of mounting density. In recent years, an imaging device having a three-dimensional structure has been developed in order to achieve further downsizing of the imaging device and high density of pixels. In an imaging device having a three-dimensional structure, for example, a semiconductor substrate having a plurality of sensor pixels and a semiconductor substrate having a signal processing circuit that processes a signal obtained by each sensor pixel are stacked on each other.

### Citation List

### Patent Literature

Patent Literature 1: WO 2019/131965 A
Patent Literature 2: WO 2019/150981
Patent Literature 3: WO 2018/186197
Patent Literature 4: WO 2020/105713

### Summary

### Technical Problem

However, in the imaging device having a three-dimensional structure, there is a limit to downsizing and miniaturization of the imaging device. Therefore, the present disclosure proposes an imaging device, a method of manufacturing the imaging device, and an electronic device that enable further downsizing and miniaturization.

### Solution to Problem

According to a first aspect, the present invention provides an imaging device according to independent claim 1. According to a second aspect, the present invention provides a manufacturing method according to independent claim 15 Further aspects of the present invention are set forth in the dependent claims, the drawings and the following description.

According to the present disclosure, there is provided an imaging device including: a first semiconductor substrate provided with a photoelectric conversion element; a second semiconductor substrate stacked on the first semiconductor substrate with an interlayer insulating film interposed therebetween, the second semiconductor substrate being provided with a pixel circuit that reads out charges generated in the photoelectric conversion element as a pixel signal; and a via that penetrates the interlayer insulating film and electrically connects a first surface of the first semiconductor substrate facing the second semiconductor substrate and at least a part of a second surface of the second semiconductor substrate facing the first surface.

Furthermore, according to the present disclosure, there is provided a method of manufacturing an imaging device, including: stacking an interlayer insulating film on a first semiconductor substrate provided with a photoelectric conversion element; forming a through hole in the interlayer insulating film; embedding polysilicon in the through hole; removing a portion of the embedded polysilicon protruding from the through hole; and attaching a second semiconductor substrate on the interlayer insulating film in which the through hole has been formed, the second semiconductor substrate being provided with a pixel circuit that reads out charges generated in the photoelectric conversion element as a pixel signal. The electronic device equipped with the imaging device of the present invention is not part of the claimed invention. The description of the electronic device provided below is solely for illustrative purposes.

### Brief Description of Drawings

FIG. 1 is a block diagram illustrating an example of a functional configuration of an imaging device 1.
FIG. 2 is a schematic plan view illustrating a schematic configuration of the imaging device 1 illustrated in FIG. 1.
FIG. 3 is a schematic diagram illustrating a cross-sectional configuration taken along line III-III' illustrated in FIG. 2.
FIG. 4 is an equivalent circuit diagram of a pixel sharing unit 539 illustrated in FIG. 1.
FIG. 5 is a schematic cross-sectional view illustrating an example of a detailed configuration of an imaging device 1 according to a comparative example.
FIG. 6 is a schematic diagram illustrating an example of a planar configuration of a main part of a first semiconductor substrate 100 illustrated in FIG. 5.
FIG. 7 is a schematic diagram illustrating an example of a planar configuration of a main part of a second semiconductor substrate 200 illustrated in FIG. 5.
FIG. 8 is a schematic diagram illustrating a cross-sectional configuration of a main part of the imaging device 1 according to the comparative example.
FIG. 9 is a schematic diagram (part 1) illustrating a cross-sectional configuration of an example of a main part of the imaging device 1 according to a first embodiment of the present disclosure.
FIG. 10 is a schematic diagram (part 2) illustrating a cross-sectional configuration of an example of the main part of the imaging device 1 according to the first embodiment of the present disclosure.
FIG. 11 is a schematic diagram (part 1) illustrating a planar configuration of an example of the main part of the imaging device 1 according to the first embodiment of the present disclosure.
FIG. 12 is a schematic diagram (part 2) illustrating a planar configuration of an example of the main part of the imaging device 1 according to the first embodiment of the present disclosure.
FIG. 13 is a schematic diagram (part 3) illustrating a planar configuration of an example of the main part of the imaging device 1 according to the first embodiment of the present disclosure.
FIG. 14A is a schematic diagram (part 1) for explaining the method of manufacturing the imaging device 1 according to the first embodiment of the present disclosure.
FIG. 14B is a schematic diagram (part 2) for explaining the method of manufacturing the imaging device 1 according to the first embodiment of the present disclosure.
FIG. 14C is a schematic diagram (part 3) for explaining the method of manufacturing the imaging device 1 according to the first embodiment of the present disclosure.
FIG. 14D is a schematic diagram (part 4) for explaining the method of manufacturing the imaging device 1 according to the first embodiment of the present disclosure.
FIG. 14E is a schematic diagram (part 5) for explaining the method of manufacturing the imaging device 1 according to the first embodiment of the present disclosure.
FIG. 14F is a schematic diagram (part 6) for explaining the method of manufacturing the imaging device 1 according to the first embodiment of the present disclosure.
FIG. 14G is a schematic diagram (part 7) for explaining the method of manufacturing the imaging device 1 according to the first embodiment of the present disclosure.
FIG. 15 is a schematic diagram illustrating a cross-sectional configuration of an example of a main part of an imaging device 1 according to Modification 1 of the first embodiment of the present disclosure.
FIG. 16 is a schematic diagram illustrating a planar configuration of an example of the main part of the imaging device 1 according to Modification 1 of the first embodiment of the present disclosure.
FIG. 17 is a schematic diagram for explaining a manufacturing method of Modification 1 of the first embodiment of the present disclosure.
FIG. 18 is a schematic diagram illustrating a cross-sectional configuration of an example of a main part of an imaging device 1 according to Modification 2 of the first embodiment of the present disclosure.
FIG. 19 is a schematic diagram illustrating a cross-sectional configuration of an example of a main part of an imaging device 1 according to a second embodiment of the present disclosure.
FIG. 20A is a schematic diagram (part 1) for explaining a method of manufacturing the imaging device 1 according to the second embodiment of the present disclosure.
FIG. 20B is a schematic diagram (part 2) for explaining the method of manufacturing the imaging device 1 according to the second embodiment of the present disclosure.
FIG. 20C is a schematic diagram (part 3) for explaining the method of manufacturing the imaging device 1 according to the second embodiment of the present disclosure.
FIG. 20D is a schematic diagram (part 4) for explaining the method of manufacturing the imaging device 1 according to the second embodiment of the present disclosure.
FIG. 20E is a schematic diagram (part 5) for explaining the method of manufacturing the imaging device 1 according to the second embodiment of the present disclosure.
FIG. 20F is a schematic diagram (part 6) for explaining the method of manufacturing the imaging device 1 according to the second embodiment of the present disclosure.
FIG. 20G is a schematic diagram (part 7) for explaining the method of manufacturing the imaging device 1 according to the second embodiment of the present disclosure.
FIG. 20H is a schematic diagram (part 8) for explaining the method of manufacturing the imaging device 1 according to the second embodiment of the present disclosure.
FIG. 21 is a schematic diagram illustrating a cross-sectional configuration of an example of a main part of an imaging device 1 according to a modification of the second embodiment of the present disclosure.
FIG. 22 is a schematic diagram illustrating a cross-sectional configuration of an example of a main part of an imaging device 1 according to a third embodiment of the present disclosure.
FIG. 23A is a schematic diagram (part 1) for explaining a method of manufacturing the imaging device 1 according to the third embodiment of the present disclosure.
FIG. 23B is a schematic diagram (part 2) for explaining the method of manufacturing the imaging device 1 according to the third embodiment of the present disclosure.
FIG. 23C is a schematic diagram (part 3) for explaining the method of manufacturing the imaging device 1 according to the third embodiment of the present disclosure.
FIG. 24 is a schematic diagram (part 1) for explaining a manufacturing process of an imaging device 1 according to a comparative example.
FIG. 25 is a schematic diagram (part 2) for explaining the manufacturing process of the imaging device 1 according to the comparative example.
FIG. 26 is a schematic diagram (part 3) for explaining the manufacturing process of the imaging device 1 according to the comparative example.
FIG. 27 is a schematic diagram illustrating a configuration of an example of a main part of an imaging device 1 according to a fourth embodiment of the present disclosure.
FIG. 28 is a schematic diagram (part 1) for explaining a method of manufacturing the imaging device 1 according to the fourth embodiment of the present disclosure.
FIG. 29 is a schematic diagram (part 2) for explaining the method of manufacturing the imaging device 1 according to the fourth embodiment of the present disclosure.
FIG. 30A is a schematic diagram illustrating a cross-sectional configuration of an example of a main part of an imaging device 1 according to Modification 1 of the fourth embodiment of the present disclosure.
FIG. 30B is a schematic diagram illustrating a cross-sectional configuration of an example of a main part of an imaging device 1 according to Modification 2 of the fourth embodiment of the present disclosure.
FIG. 30C is a schematic diagram illustrating a cross-sectional configuration of an example of a main part of an imaging device 1 according to Modification 3 of the fourth embodiment of the present disclosure.
FIG. 31 is a schematic diagram (part 1) for explaining a background of a fifth embodiment of the present disclosure.
FIG. 32 is a schematic diagram (part 2) for explaining the background of the fifth embodiment of the present disclosure.
FIG. 33 is a schematic diagram illustrating a planar configuration of an example of a main part of an imaging device 1 according to the fifth embodiment of the present disclosure.
FIG. 34A is a schematic diagram (part 1) for explaining a method of manufacturing the imaging device 1 according to the fifth embodiment of the present disclosure.
FIG. 34B is a schematic diagram (part 2) for explaining the method of manufacturing the imaging device 1 according to the fifth embodiment of the present disclosure.
FIG. 34C is a schematic diagram (part 3) for explaining the method of manufacturing the imaging device 1 according to the fifth embodiment of the present disclosure.
FIG. 34D is a schematic diagram (part 4) for explaining the method of manufacturing the imaging device 1 according to the fifth embodiment of the present disclosure.
FIG. 35 is a schematic diagram illustrating a planar configuration of an example of a main part of the imaging device 1 according to a modification of the fifth embodiment of the present disclosure.
FIG. 36 is a schematic diagram illustrating a cross-sectional configuration of an example of a main part of an imaging device 1 according to a sixth embodiment of the present disclosure.
FIG. 37A is a schematic diagram (part 1) for explaining a method of manufacturing the imaging device 1 according to the sixth embodiment of the present disclosure.
FIG. 37B is a schematic diagram (part 2) for explaining the method of manufacturing the imaging device 1 according to the sixth embodiment of the present disclosure.
FIG. 37C is a schematic diagram (part 3) for explaining the method of manufacturing the imaging device 1 according to the sixth embodiment of the present disclosure.
FIG. 38 is a schematic diagram (part 1) illustrating a cross-sectional configuration of an example of a main part of an imaging device 1 according to a seventh embodiment of the present disclosure.
FIG. 39 is a schematic diagram (part 2) illustrating a cross-sectional configuration of an example of the main part of the imaging device 1 according to the seventh embodiment of the present disclosure.
FIG. 40 is a schematic diagram for explaining a method of manufacturing the imaging device 1 according to the seventh embodiment of the present disclosure.
FIG. 41 is a schematic diagram for explaining a background of an eighth embodiment of the present disclosure.
FIG. 42 is a schematic diagram illustrating a cross-sectional configuration of an example of a main part of an imaging device 1 according to the eighth embodiment of the present disclosure.
FIG. 43 is a schematic diagram (part 1) for explaining a method of manufacturing the imaging device 1 according to the eighth embodiment of the present disclosure.
FIG. 44 is a schematic diagram (part 2) for explaining the method of manufacturing the imaging device 1 according to the eighth embodiment of the present disclosure.
FIG. 45 is a schematic diagram illustrating a planar configuration of an example of a main part of the imaging device 1 according to the eighth embodiment of the present disclosure.
FIG. 46 is a schematic diagram (part 1) for explaining a background of a ninth embodiment of the present disclosure.
FIG. 47 is a schematic diagram (part 2) for explaining the background of the ninth embodiment of the present disclosure.
FIG. 48 is a schematic diagram (part 1) illustrating a cross-sectional configuration of an example of a main part of an imaging device 1 according to the ninth embodiment of the present disclosure.
FIG. 49 is a schematic diagram (part 2) illustrating a cross-sectional configuration of an example of the main part of the imaging device 1 according to the ninth embodiment of the present disclosure.
FIG. 50 is a schematic diagram illustrating a planar configuration of an example of the main part of the imaging device 1 according to the ninth embodiment of the present disclosure.
FIG. 51 is a schematic diagram (part 1) for explaining a method of manufacturing the imaging device 1 according to the ninth embodiment of the present disclosure.
FIG. 52 is a schematic diagram (part 2) for explaining the method of manufacturing the imaging device 1 according to the ninth embodiment of the present disclosure.
FIG. 53 is a schematic diagram for explaining a tenth embodiment of the present disclosure.
FIG. 54 is a schematic diagram illustrating a cross-sectional configuration of an example of a main part of an imaging device 1 according to the tenth embodiment of the present disclosure.
FIG. 55 is a schematic diagram (part 1) for explaining a method of manufacturing the imaging device 1 according to the tenth embodiment of the present disclosure.
FIG. 56 is a schematic diagram (part 2) for explaining the method of manufacturing the imaging device 1 according to the tenth embodiment of the present disclosure.
FIG. 57 is a schematic diagram (part 1) for explaining an eleventh embodiment of the present disclosure.
FIG. 58 is a schematic diagram (part 2) for explaining the eleventh embodiment of the present disclosure.
FIG. 59 is a schematic diagram (part 1) illustrating a cross-sectional configuration of an example of a main part of an imaging device 1 according to a twelfth embodiment of the present disclosure.
FIG. 60 is a schematic diagram (part 2) illustrating a cross-sectional configuration of an example of the main part of the imaging device 1 according to the twelfth embodiment of the present disclosure.
FIG. 61 is a schematic diagram (part 3) illustrating a cross-sectional configuration of an example of the main part of the imaging device 1 according to the twelfth embodiment of the present disclosure.
FIG. 62 is a schematic diagram for explaining a method of manufacturing the imaging device 1 according to the twelfth embodiment of the present disclosure.
FIG. 63 is a schematic diagram illustrating a cross-sectional configuration of an example of a main part of an imaging device 1 according to a thirteenth embodiment of the present disclosure.
FIG. 64 is a schematic diagram (part 1) for explaining a method of manufacturing the imaging device 1 according to the thirteenth embodiment of the present disclosure.
FIG. 65 is a schematic diagram (part 2) for explaining the method of manufacturing the imaging device 1 according to the thirteenth embodiment of the present disclosure.
FIG. 66 is a schematic diagram (part 1) illustrating a configuration of an example of a main part of a first semiconductor substrate 100 according to a fourteenth embodiment of the present disclosure.
FIG. 67 is a schematic diagram (part 2) illustrating a configuration of an example of the main part of the first semiconductor substrate 100 according to the fourteenth embodiment of the present disclosure.
FIG. 68 is a schematic diagram illustrating a configuration of an example of a main part of an imaging device 1 according to the fourteenth embodiment of the present disclosure.
FIG. 69 is an enlarged view (part 1) of region A in FIG. 68.
FIG. 70 is an enlarged view (part 2) of region A in FIG. 68.
FIG. 71 is an enlarged view (part 3) of region A in FIG. 68.
FIG. 72 is a schematic diagram for explaining a method of manufacturing the imaging device 1 according to the fourteenth embodiment of the present disclosure.
FIG. 73 is a schematic diagram for explaining a method of manufacturing the imaging device 1 according to a modification of the fourteenth embodiment of the present disclosure.
FIG. 74 is a schematic diagram for explaining a fifteenth embodiment of the present disclosure.
FIG. 75 is a schematic diagram illustrating a configuration of an example of a main part of an imaging device 1 according to the fifteenth embodiment of the present disclosure.
FIG. 76 is a diagram illustrating an example of a schematic configuration of an imaging system 7 including the imaging device 1 according to an embodiment of the present disclosure.
FIG. 77 is an example of a flowchart of an imaging operation in the imaging system 7 illustrated in FIG. 76.

### Description of Embodiments

Hereinafter, embodiments of the present disclosure will be described in detail with reference to the drawings. In each of the following embodiments, the same parts are denoted by the same reference numerals, and the duplicate description will be omitted.

In addition, in the present specification and the drawings, a plurality of components having substantially the same or similar functional configuration may be distinguished by attaching different numerals after the same reference numerals. However, if it is not particularly necessary to distinguish each of the plurality of components having substantially the same or similar functional configuration, only the same reference numeral is attached. In addition, similar components of different embodiments may be distinguished by adding different letters after the same reference numerals. However, if it is not particularly necessary to distinguish each of the similar components, only the same reference numeral is attached.

In addition, the drawings referred to in the following description are drawings for promoting the description of the embodiments of the present disclosure and the understanding thereof, and shapes, dimensions, ratios, and the like illustrated in the drawings may be different from actual ones for the sake of clarity. Furthermore, the imaging device illustrated in the drawings and components and the like included in the imaging device can be appropriately changed in design in consideration of the following description and known techniques. Furthermore, in the following description, the vertical direction of the stacked structure of the imaging device corresponds to a relative direction in a case where the imaging device is arranged such that light incident on the imaging device is directed from bottom to top unless otherwise specified.

The description of specific shapes in the following description does not mean only geometrically defined shapes. Specifically, the description of the specific shape in the following description includes a case where there is an allowable difference (error or distortion) in the imaging device, the manufacturing process thereof, and the use and operation thereof, and a shape similar to the shape. For example, in the following description, the expression "substantially circular shape" means that the shape is not limited to a perfect circle but includes a shape similar to a perfect circle such as an elliptical shape.

In the following description of circuits (electrical connections), unless otherwise specified, "electrically connected" means that a plurality of elements are connected such that electricity (signals) conducts. In addition, "electrically connected" in the following description includes not only a case of directly and electrically connecting a plurality of elements but also a case of indirectly and electrically connecting a plurality of elements via other elements.

In the present specification, a "gate" represents a gate electrode of a field effect transistor. In addition, "drain" represents a drain region of a field effect transistor, and "source" represents a source region of the field effect transistor. In addition, a "first conductivity type" represents either "p-type" or "n-type", and a "second conductivity type" represents the other of "p-type" or "n-type" different from the "first conductivity type".

In addition, in the following description, "provided in common" means that other elements are provided so as to be shared by a plurality of one elements, in other words, the other elements are shared by each of a predetermined number of the one elements, unless otherwise specified.

Hereinafter, modes for carrying out the present disclosure will be described in detail with reference to the drawings. Note that the description will be given in the following order.
1. Background to Creation of Embodiments of Present Disclosure by Inventors
1.1 Functional Configuration of Imaging Device 1
1.2 Schematic Configuration of Imaging Device 1
1.3 Detailed Configuration of Imaging Device 1 According to Comparative Example
1.4 Background
2. First Embodiment
2.1 Configuration
2.2 Manufacturing Method
2.3 Modification
3. Second Embodiment
3.1 Background
3.2 Configuration
3.3 Manufacturing Method
3.4 Modification
4. Third Embodiment
4.1 Configuration
4.2 Manufacturing Method
5. Fourth Embodiment
5.1 Background
5.2 Embodiment
5.3 Modification
6. Fifth Embodiment
6.1 Background
6.2 Embodiment
6.3 Manufacturing Method
6.4 Modification
7. Sixth Embodiment
7.1 Background
7.2 Embodiment
7.3 Manufacturing Method
8. Seventh Embodiment
8.1 Background
8.2 Embodiment
8.3 Manufacturing Method
9. Eighth Embodiment
9.1 Background
9.2 Embodiment
10. Ninth Embodiment
10.1 Background
10.2 Embodiment
10.3 Manufacturing Method
11. Tenth Embodiment
11.1 Background
11.2 Embodiment
11.3 Manufacturing Method
12. Eleventh Embodiment
13. Twelfth Embodiment
13.1 Background
13.2 Embodiment
14. Thirteenth Embodiment
14.1 Background
14.2 Embodiment
14.3 Manufacturing Method
15. Fourteenth Embodiment
15.1 Background
15.2 Embodiment
15.3 Manufacturing Method
15.4 Modification
16. Fifteenth Embodiment
16.1 Background
16.2 Embodiment
17. Summary
18. Application Example
19. Supplement

### <<1. Background to Creation of Embodiments of Present Disclosure by Inventors>>

### <1.1 Functional Configuration of Imaging Device 1>

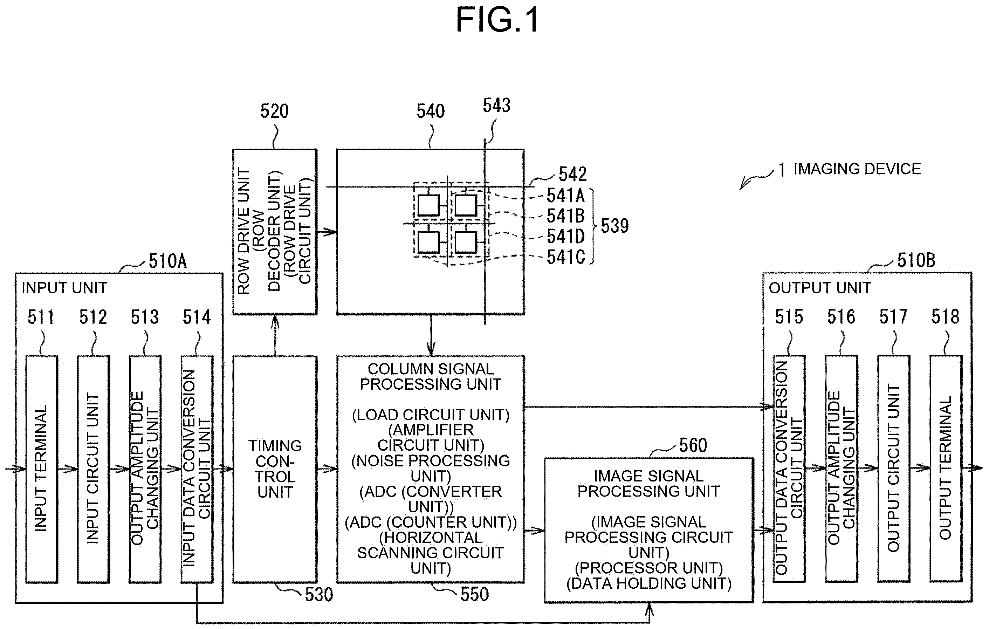

First, before describing the details of the embodiments of the present disclosure, the background until the present inventors have created the embodiments of the present disclosure will be described. First, an example of a functional configuration of an imaging device 1 to which an embodiment of the present disclosure can be applied will be described with reference to FIG. 1. FIG. 1 is a block diagram illustrating an example of a functional configuration of the imaging device 1.

As illustrated in FIG. 1, the imaging device 1 includes, for example, an input unit 510A, a row drive unit 520, a timing control unit 530, a pixel array unit 540, a column signal processing unit 550, an image signal processing unit 560, and an output unit 510B. Hereinafter, each functional unit of the imaging device 1 will be described.

### (Pixel Array Unit 540)

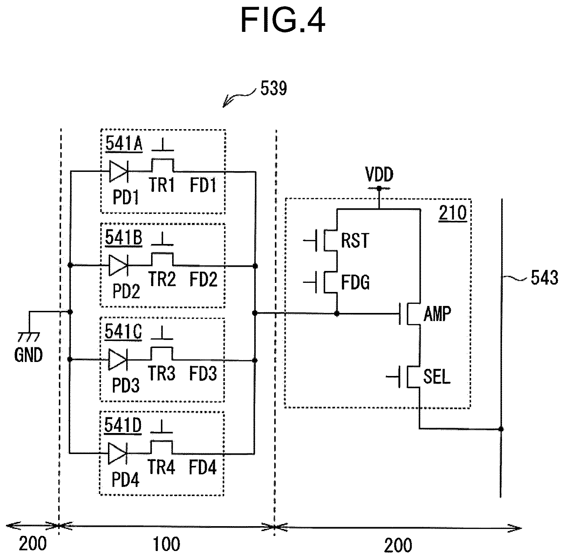

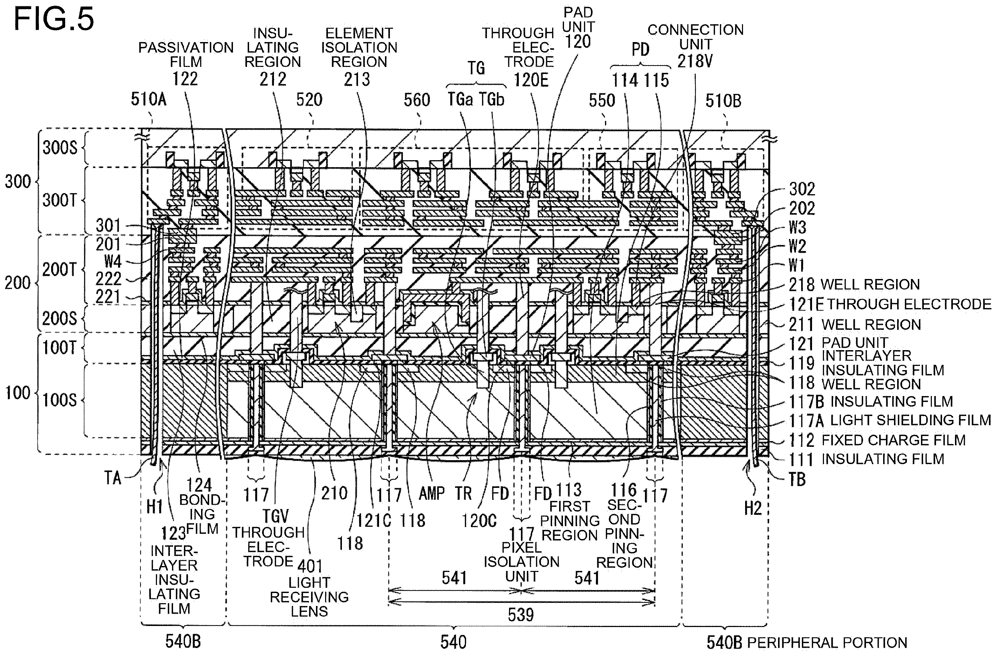

In the pixel array unit 540, pixels 541 are repeatedly arranged in an array. Specifically, a pixel sharing unit 539 including a plurality of pixels is a repeating unit, which is repeatedly arranged in an array in the row direction and the column direction. Note that, in the present specification, for convenience, the row direction may be referred to as an H direction, and the column direction orthogonal to the row direction may be referred to as a V direction. For example, in the example illustrated in FIG. 1, one pixel sharing unit 539 includes four pixels (pixels 541A, 541B, 541C, and 541D). Each of the pixels 541A, 541B, 541C, and 541D includes a photodiode (photoelectric conversion element) PD (illustrated in FIG. 5 and the like described later). The pixel sharing unit 539 is a unit that shares one pixel circuit (a pixel circuit 210 in FIG. 4 to be described later). In other words, in the imaging device 1, one pixel circuit (a pixel circuit 210 to be described later) is provided for every four pixels (pixels 541A, 541B, 541C, and 541D). For example, by operating this pixel circuit in a time division manner, the pixel signals of the respective pixels 541A, 541B, 541C, and 541D can be sequentially read out. The pixels 541A, 541B, 541C, and 541D are arranged in, for example, 2 rows × 2 columns. In the pixel array unit 540, a plurality of row drive signal lines 542 and a plurality of vertical signal lines (column readout lines) 543 are provided together with the pixels 541A, 541B, 541C, and 541D. The row drive signal line 542 drives the pixel 541 included in each of the plurality of pixel sharing units 539 arranged side by side in the row direction in the pixel array unit 540, that is, drives each pixel 541 arranged side by side in the row direction in the pixel sharing unit 539. Although details will be described later with reference to FIG. 4, the pixel sharing unit 539 is provided with a plurality of transistors. In order to drive each of the plurality of transistors, the plurality of row drive signal lines 542 are electrically connected to one pixel sharing unit 539. Furthermore, the pixel sharing unit 539 is electrically connected the vertical signal line (column readout line) 543. The pixel signal can be read from each of the pixels 541A, 541B, 541C, and 541D included in the pixel sharing unit 539 by the vertical signal line (column readout line) 543.

### (Row Drive Unit 520)

The row drive unit 520 can include, for example, a row address control unit that determines a position of a row for pixel drive, in other words, a row decoder unit, and a row drive circuit unit that generates a signal for driving the pixels 541A, 541B, 541C, and 541D.

### (Column Signal Processing Unit 550)

The column signal processing unit 550 includes, for example, a load circuit unit that is electrically connected to the vertical signal line 543 and forms a source follower circuit with the pixels 541A, 541B, 541C, and 541D (pixel sharing unit 539). Furthermore, the column signal processing unit 550 may include an amplifier circuit unit that amplifies a signal read from the pixel sharing unit 539 via the vertical signal line 543. In addition, the column signal processing unit 550 may include a noise processing unit. For example, the noise processing unit can remove the noise level of the system from the signal read from the pixel sharing unit 539 as a result of the photoelectric conversion.

In addition, the column signal processing unit 550 includes, for example, an analog-to-digital converter (ADC). The analog-to-digital converter can convert a signal read from the pixel sharing unit 539 or the noise-processed analog signal into a digital signal. The ADC includes, for example, a comparator unit and a counter unit. In the comparator unit, an analog signal to be converted is compared with a reference signal to be compared. In the counter unit, the time until the comparison result in the comparator unit is inverted is measured. Furthermore, the column signal processing unit 550 may include a horizontal scanning circuit unit that performs control to scan the read column.

### (Timing Control Unit 530)

The timing control unit 530 can supply a signal for controlling timing to the row drive unit 520 and the column signal processing unit 550 based on the reference clock signal and the timing control signal input to the device.

### (Image Signal Processing Unit 560)

The image signal processing unit 560 is a circuit that performs various types of signal processing on data obtained as a result of photoelectric conversion, in other words, data obtained as a result of an imaging operation in the imaging device 1. The image signal processing unit 560 includes, for example, an image signal processing circuit unit and a data holding unit. The image signal processing unit 560 may further include a processor unit. For example, as an example of the signal processing executed in the image signal processing unit 560, it is possible to exemplify tone curve correction processing of providing a large number of gradations if the imaging data subjected to analog-to-digital (AD) conversion is data obtained by imaging a dark subject, and reducing the gradations if the imaging data is data obtained by imaging a bright subject. In this case, it is desirable to store the characteristic data of the tone curve in the data holding unit of the image signal processing unit 560 in advance based on which tone curve the gradation of the imaging data is corrected.

### (Input Unit 510A)

The input unit 510A is, for example, a functional unit for inputting the reference clock signal, the timing control signal, the characteristic data, and the like from the outside of the device to the imaging device 1. The timing control signal is, for example, a vertical synchronization signal, a horizontal synchronization signal, or the like. The characteristic data is, for example, data to be stored in the data holding unit of the image signal processing unit 560. The input unit 510A can include, for example, an input terminal 511, an input circuit unit 512, an input amplitude changing unit 513, an input data conversion circuit unit 514, and a power supply unit (not illustrated).

Specifically, the input terminal 511 is an external terminal for inputting data. The input circuit unit 512 is a circuit for taking a signal input to the input terminal 511 into the imaging device 1. The input amplitude changing unit 513 can change the amplitude of the signal taken in by the input circuit unit 512 to an amplitude that can be easily used inside the imaging device 1. The input data conversion circuit unit 514 can change the arrangement of the data strings of the input data. The input data conversion circuit unit 514 includes, for example, a serial-to-parallel conversion circuit. The serial-to-parallel conversion circuit can convert a serial signal received as input data into a parallel signal. In the input unit 510A, the input amplitude changing unit 513 and the input data conversion circuit unit 514 may be omitted. The power supply unit can supply power set to various voltages required inside the imaging device 1 using power supplied from the outside to the imaging device 1. Furthermore, in a case where the imaging device 1 is electrically connected to an external memory device, the input unit 510A may be provided with a memory interface circuit that receives data from an external memory device. Examples of the external memory device include a flash memory, a static random access memory (SRAM), and a dynamic random access memory (DRAM).

### (Output Unit 510B)

The output unit 510B outputs the image data to the outside of the device. The image data is, for example, image data captured by the imaging device 1, image data subjected to signal processing by the image signal processing unit 560, and the like. The output unit 510B can include, for example, an output data conversion circuit unit 515, an output amplitude changing unit 516, an output circuit unit 517, and an output terminal 518.

Specifically, the output data conversion circuit unit 515 includes, for example, a parallel-to-serial conversion circuit, and the output data conversion circuit unit 515 can convert a parallel signal used inside the imaging device 1 into a serial signal. The output amplitude changing unit 516 can change the amplitude of a signal used inside the imaging device 1. By changing the amplitude, the signal whose amplitude has been changed can be easily used by an external device connected to the outside of the imaging device 1. The output circuit unit 517 is a circuit that outputs data from the inside of the imaging device 1 to the outside of the device, and the output circuit unit 517 can drive wiring outside the imaging device 1 electrically connected to the output terminal 518. Furthermore, the output terminal 518 can output data from the imaging device 1 to the outside of the device. In the output unit 510B, the output data conversion circuit unit 515 and the output amplitude changing unit 516 may be omitted. Furthermore, in a case where the imaging device 1 is electrically connected to an external memory device, the output unit 510B may be provided with a memory interface circuit that outputs data to an external memory device. Examples of the external memory device include a flash memory, an SRAM, and a DRAM.

### <1.2 Schematic Configuration of Imaging Device 1>

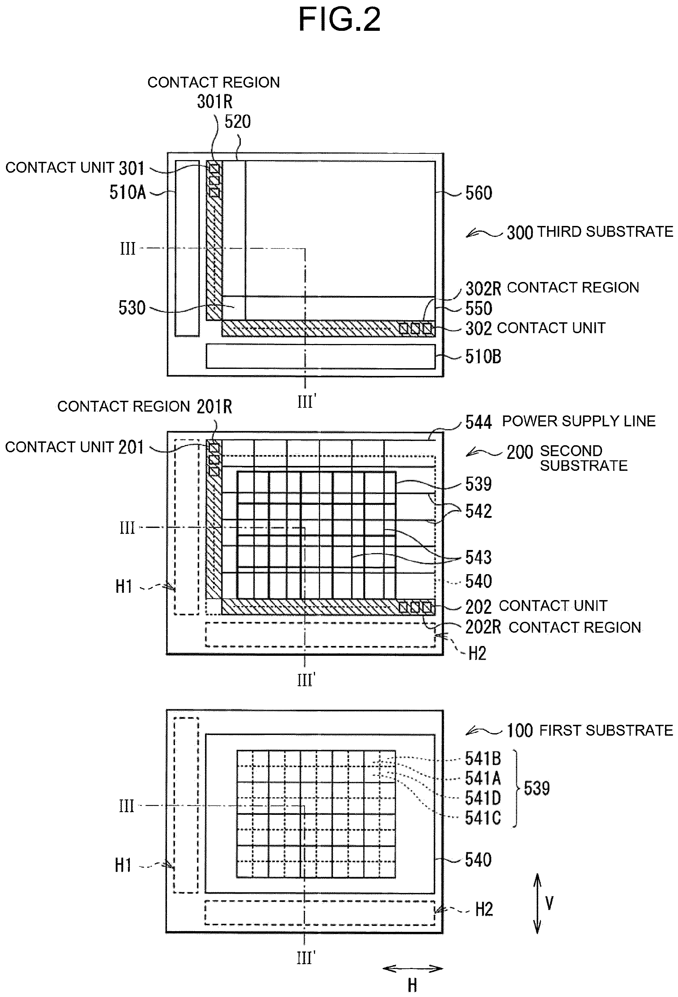

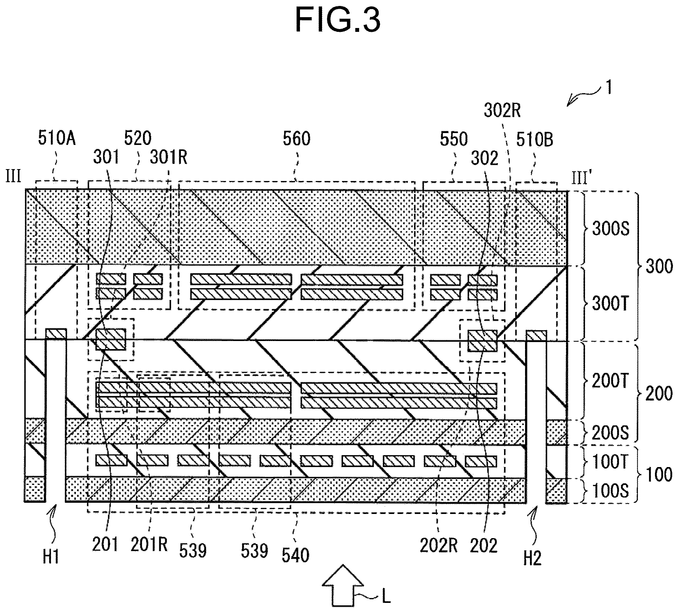

Next, an example of a schematic configuration of the imaging device 1 will be described with reference to FIGS. 2 to 4. FIG. 2 is a schematic plan view illustrating a schematic configuration of the imaging device 1 illustrated in FIG. 1, and is a view schematically illustrating a planar configuration of each of a first semiconductor substrate 100, a second semiconductor substrate 200, and a third semiconductor substrate 300 of the imaging device 1 including three semiconductor substrates (the first semiconductor substrate 100, the second semiconductor substrate 200, and the third semiconductor substrate 300). Further, FIG. 3 is a schematic diagram illustrating a cross-sectional configuration taken along line III-III' illustrated in FIG. 2. Furthermore, FIG. 4 is an equivalent circuit diagram illustrating an example of a configuration of the pixel sharing unit 539.

Specifically, it is assumed that the imaging device 1 is an imaging device having a three-dimensional structure formed by bonding three semiconductor substrates (the first semiconductor substrate 100, the second semiconductor substrate 200, and the third semiconductor substrate 300) illustrated in FIG. 2, and is, for example, a back-illuminated imaging device in which light is incident from a back surface (second surface) (light incident surface) side of the first semiconductor substrate 100 having a photodiode. The first semiconductor substrate 100 includes a semiconductor layer 100S and a wiring layer 100T. The second semiconductor substrate 200 includes a semiconductor layer 200S and a wiring layer 200T. The third semiconductor substrate 300 includes a semiconductor layer 300S and a wiring layer 300T. Here, the wiring included in each semiconductor substrate of the first semiconductor substrate 100, the second semiconductor substrate 200, and the third semiconductor substrate 300 and the interlayer insulating film therearound are collectively referred to as a wiring layer (100T, 200T, and 300T) provided on each semiconductor substrate (the first semiconductor substrate 100, the second semiconductor substrate 200, and the third semiconductor substrate 300) for convenience. As illustrated in FIG. 3, the first semiconductor substrate 100, the second semiconductor substrate 200, and the third semiconductor substrate 300 are stacked in this order, and the semiconductor layer 100S, the wiring layer 100T, the semiconductor layer 200S, the wiring layer 200T, the wiring layer 300T, and the semiconductor layer 300S are arranged in this order along the stacking direction. Specific configurations of the first semiconductor substrate 100, the second semiconductor substrate 200, and the third semiconductor substrate 300 will be described later. Note that the arrow illustrated in FIG. 3 indicates the incident direction of the light L on the imaging device 1. In the present specification, for convenience, in the following cross-sectional views, the light incident side in the imaging device 1 may be referred to as "lower", "lower side", and "lower direction", and the side opposite to the light incident side may be referred to as "upper", "upper side", and "upper direction". In addition, in the present specification, for convenience, in a semiconductor substrate including a semiconductor layer and a wiring layer, a side of the wiring layer may be referred to as a front surface (first surface), and a side of the semiconductor layer may be referred to as a back surface (second surface). Furthermore, the description of the specification is not limited to the above terms.

Both the pixel array unit 540 and the pixel sharing unit 539 included in the pixel array unit 540 are configured using both the first semiconductor substrate 100 and the second semiconductor substrate 200. Specifically, the first semiconductor substrate 100 is provided with the plurality of pixels 541A, 541B, 541C, and 541D included in the pixel sharing unit 539. Each of these pixels 541 includes a photodiode (a photodiode PD (photoelectric conversion element) to be described later) and a transfer transistor (a transfer transistor TR to be described later). Furthermore, the second semiconductor substrate 200 is provided with a pixel circuit (a pixel circuit 210 to be described later) included in the pixel sharing unit 539. The pixel circuit can read out the charge generated in the photodiode of each of the pixels 541A, 541B, 541C, and 541D as a pixel signal via the transfer transistor, or reset the photodiode. In addition to such a pixel circuit, the second semiconductor substrate 200 includes a plurality of row drive signal lines 542 extending in the row direction and a plurality of vertical signal lines 543 extending in the column direction. Further, the second semiconductor substrate 200 includes a power supply line 544 extending in the row direction.

The third semiconductor substrate 300 includes, for example, the input unit 510A, the row drive unit 520, the timing control unit 530, the column signal processing unit 550, the image signal processing unit 560, and the output unit 510B. The row drive unit 520 is provided, for example, in a region partially overlapping the pixel array unit 540 in the stacking direction of the first semiconductor substrate 100, the second semiconductor substrate 200, and the third semiconductor substrate 300 (hereinafter, simply referred to as the stacking direction). More specifically, the row drive unit 520 is provided in a region overlapping the vicinity of the end portion of the pixel array unit 540 in the H direction in the stacking direction (see FIG. 2). The column signal processing unit 550 is provided, for example, in a region partially overlapping the pixel array unit 540 in the stacking direction. More specifically, the column signal processing unit 550 is provided in a region overlapping the vicinity of the end portion of the pixel array unit 540 in the V direction in the stacking direction (see FIG. 2). Note that, although not illustrated, the input unit 510A and the output unit 510B may be disposed in a portion other than the third semiconductor substrate 300, for example, may be disposed on the second semiconductor substrate 200. Alternatively, the input unit 510A and the output unit 510B may be provided on the back surface (light incident surface) side of the first semiconductor substrate 100. Furthermore, the pixel circuit provided on the second semiconductor substrate 200 may also be referred to as a pixel transistor circuit, a pixel transistor group, a pixel transistor, a pixel readout circuit, or a readout circuit as another name. In the present specification, the term "pixel circuit" is used.

Furthermore, the first semiconductor substrate 100 and the second semiconductor substrate 200 are electrically connected by, for example, a through electrode (through electrodes 120E and 121E of FIG. 5 to be described later). In addition, as illustrated in FIG. 3, the second semiconductor substrate 200 and the third semiconductor substrate 300 are electrically connected via, for example, contact units 201, 202, 301, and 302. More specifically, the contact units 201 and 202 are provided on the second semiconductor substrate 200, and the contact units 301 and 302 are provided on the third semiconductor substrate 300. The contact unit 201 of the second semiconductor substrate 200 is in contact with the contact unit 301 of the third semiconductor substrate 300, and the contact unit 202 of the second semiconductor substrate 200 is in contact with the contact unit 302 of the third semiconductor substrate 300. The second semiconductor substrate 200 includes a contact region 201R provided with a plurality of contact units 201 and a contact region 202R provided with a plurality of contact units 202. The third semiconductor substrate 300 includes a contact region 301R provided with a plurality of contact units 301 and a contact region 302R provided with a plurality of contact units 302. The contact regions 201R and 301R are provided between the pixel array unit 540 and the row drive unit 520 in the stacking direction (see FIG. 3). In other words, the contact regions 201R and 301R are provided, for example, in a region where the row drive unit 520 (the third semiconductor substrate 300) and the pixel array unit 540 (the second semiconductor substrate 200) overlap in the stacking direction or in a region in the vicinity thereof. In addition, the contact regions 201R and 301R are disposed, for example, at end portions in the H direction in such regions (see FIG. 2). In the third semiconductor substrate 300, for example, the contact region 301R is provided at a position overlapping a part of the row drive unit 520, specifically, the end portion of the row drive unit 520 in the H direction (see FIGS. 2 and 3). Then, the contact units 201 and 301 connect, for example, the row drive unit 520 provided on the third semiconductor substrate 300 and the row drive signal line 542 provided on the second semiconductor substrate 200. The contact units 201 and 301 may connect, for example, the input unit 510A provided on the third semiconductor substrate 300 to the power supply line 544 and a reference potential line (reference potential line VSS to be described later). The contact regions 202R and 302R are provided between the pixel array unit 540 and the column signal processing unit 550 in the stacking direction (see FIG. 3). In other words, the contact regions 202R and 302R are provided, for example, in a region where the column signal processing unit 550 (the third semiconductor substrate 300) and the pixel array unit 540 (the second semiconductor substrate 200) overlap in the stacking direction or in a region in the vicinity thereof. The contact regions 202R and 302R are disposed, for example, at end portions in the V direction in such regions (see FIG. 2). In the third semiconductor substrate 300, for example, the contact region 301R is provided at a position overlapping a part of the column signal processing unit 550, specifically, the end portion of the column signal processing unit 550 in the V direction (see FIGS. 2 and 3). For example, the contact units 202 and 302 ensure electrical connection in order to transmit pixel signals (signals corresponding to the amount of charges generated as a result of photoelectric conversion in the photodiode) output from each of the plurality of pixel sharing units 539 included in the pixel array unit 540 to the column signal processing unit 550 provided in the third semiconductor substrate 300.

As illustrated in FIG. 3, the first semiconductor substrate 100, the second semiconductor substrate 200, and the third semiconductor substrate 300 are electrically connected via the wiring layers 100T, 200T, and 300T. For example, the imaging device 1 includes an electrical connection unit that electrically connects the second semiconductor substrate 200 and the third semiconductor substrate 300. Specifically, the contact units 201, 202, 301, and 302 are formed by electrodes made of a conductive material. The conductive material is formed of, for example, a metal material such as copper (Cu), aluminum (Al), or gold (Au). The contact regions 201R, 202R, 301R, and 302R electrically connect the second semiconductor substrate 200 and the third semiconductor substrate 300 by directly bonding wirings formed as electrodes, for example, and enable signal input and/or output between the second semiconductor substrate 200 and the third semiconductor substrate 300.

The electrical connection unit that electrically connects the second semiconductor substrate 200 and the third semiconductor substrate 300 can be provided at a desired location. For example, as described as the contact regions 201R, 202R, 301R, and 302R with reference to FIG. 2, the electrical connection unit may be provided in a region overlapping the pixel array unit 540 in the stacking direction. Furthermore, the electrical connection unit may be provided in a region not overlapping the pixel array unit 540 in the stacking direction. Specifically, the electrical connection unit may be provided in a region overlapping a peripheral portion arranged outside the pixel array unit 540 in the stacking direction.

Further, referring back to FIG. 3 and continuing the description, the first semiconductor substrate 100 and the second semiconductor substrate 200 are provided with, for example, connection holes H1 and H2. As illustrated in FIG. 3, the connection holes H1 and H2 penetrate the first semiconductor substrate 100 and the second semiconductor substrate 200. Then, the connection holes H1 and H2 are provided outside the pixel array unit 540 (or a portion overlapping the pixel array unit 540) (see FIG. 2). For example, the connection hole H1 is arranged outside the pixel array unit 540 in the H direction, and the connection hole H2 is arranged outside the pixel array unit 540 in the V direction. For example, the connection hole H1 reaches the input unit 510A provided in the third semiconductor substrate 300, and the connection hole H2 reaches the output unit 510B provided in the third semiconductor substrate 300. The connection holes H1 and H2 may be hollow or partially or entirely contain a conductive material. For example, the conductive material may be formed on the side walls of the connection holes H1 and H2. In the imaging device 1, for example, a bonding wire may be connected to an electrode formed as the input unit 510A and/or the output unit 510B. Alternatively, the electrode formed as the input unit 510A and/or the output unit 510B may be connected to the conductive material provided in the connection holes H1 and H2.

Note that, in the example illustrated in FIG. 3, the input unit 510A and the output unit 510B are provided on the third semiconductor substrate 300, but the present disclosure is not limited thereto in the embodiment to be described later. For example, by transmitting a signal of the third semiconductor substrate 300 to the second semiconductor substrate 200 via the wiring layers 200T and 300T, the input unit 510A and/or the output unit 510B can be provided on the second semiconductor substrate 200. Similarly, by transmitting a signal of the second semiconductor substrate 200 to the first semiconductor substrate 100 via the wiring layers 100T and 200T, the input unit 510A and/or the output unit 510B can be provided on the first semiconductor substrate 100.

As illustrated in FIG. 4, the pixel sharing unit 539 includes the plurality of pixels 541 (FIG. 4 illustrates four pixels 541 including pixels 541A, 541B, 541C, and 541D), one pixel circuit 210 connected to the plurality of pixels 541, and the vertical signal line 543 connected to the pixel circuit 210. The pixel circuit 210 includes, for example, four transistors, specifically, an amplification transistor AMP, a selection transistor SEL, a reset transistor RST, and an FD conversion gain switching transistor FD. As described above, the pixel sharing unit 539 can sequentially output the pixel signals of the four pixels 541 (pixels 541A, 541B, 541C, and 541D) included in the pixel sharing unit 539 to the vertical signal line 543 by operating one pixel circuit 210 in a time division manner. An aspect in which one pixel circuit 210 is connected to the plurality of pixels 541, and pixel signals of the plurality of pixels 541 are output by one pixel circuit 210 in a time division manner is referred to as "the plurality of pixels 541 shares one pixel circuit 210" in the present specification.

The pixels 541A, 541B, 541C, and 541D have common components. Therefore, in the following description, in order to distinguish the components of the pixels 541A, 541B, 541C, and 541D from each other, an identification number 1 may be denoted to the end of the reference code of the component of the pixel 541A, an identification number 2 may be denoted to the end of the reference code of the component of the pixel 541B, an identification number 3 may be denoted to the end of the reference code of the component of the pixel 541C, and an identification number 4 may be denoted to the end of the reference code of the component of the pixel 541D (for example, the photodiodes PD are referred to as PD1, PD2, PD3, and PD4). Note that, in the present specification, when it is not necessary to distinguish the components of the pixels 541A, 541B, 541C, and 541D from each other, identification numbers at the ends of the reference codes of the components of the pixels 541A, 541B, 541C, and 541D are omitted.

The pixels 541A, 541B, 541C, and 541D include, for example, the photodiode PD, a transfer transistor TR electrically connected to the photodiode PD, and a floating diffusion FD electrically connected to the transfer transistor TR. In the photodiode PD (PD1, PD2, PD3, and PD4), a cathode is electrically connected to a source of the transfer transistor TR, and an anode is electrically connected to the reference potential line (for example, ground). The photodiode PD photoelectrically converts incident light and generates a charge corresponding to the amount of received light. The transfer transistor TR (transfer transistors TR1, TR2, TR3, and TR4) is, for example, an n-type (second conductivity type) complementary metal oxide semiconductor (CMOS) transistor. In the transfer transistor TR, a drain is electrically connected to the floating diffusion FD, and a gate is electrically connected to the drive signal line. The drive signal line is a part of the plurality of row drive signal lines 542 (see FIG. 1) connected to one pixel sharing unit 539. The transfer transistor TR transfers the charge generated in the photodiode PD to the floating diffusion FD. The floating diffusion FD (floating diffusions FD1, FD2, FD3, and FD4) is an n-type (second conductivity type) diffusion layer region formed in a p-type (first conductivity type) semiconductor layer. The floating diffusion FD is charge holding means that temporarily holds the charge transferred from the photodiode PD, and is charge-voltage conversion means that generates a voltage corresponding to the charge amount.

The four floating diffusions FD (floating diffusions FD1, FD2, FD3, and FD4) included in one pixel sharing unit 539 are electrically connected to each other, and are electrically connected to a gate of the amplification transistor AMP and a source of the FD conversion gain switching transistor FDG. A drain of the FD conversion gain switching transistor FDG is electrically connected to a source of the reset transistor RST, and a gate of the FD conversion gain switching transistor FDG is electrically connected to the drive signal line. The drive signal line is a part of the plurality of row drive signal lines 542 connected to one pixel sharing unit 539. A drain of the reset transistor RST is electrically connected to the power supply line VDD, and a gate of the reset transistor RST is electrically connected to the drive signal line. The drive signal line is a part of the plurality of row drive signal lines 542 connected to one pixel sharing unit 539. The gate of the amplification transistor AMP is electrically connected to the floating diffusion FD, a drain of the amplification transistor AMP is electrically connected to the power supply line VDD, and a source of the amplification transistor AMP is electrically connected to a drain of the selection transistor SEL. A source of the selection transistor SEL is electrically connected to the vertical signal line 543, and a gate of the selection transistor SEL is electrically connected to the drive signal line. This drive signal line is a part of the plurality of row drive signal lines 542 connected to one pixel sharing unit 539.

When the transfer transistor TR is turned on, the transfer transistor TR transfers the charge of the photodiode PD to the floating diffusion FD. The gate (transfer gate TG) of the transfer transistor TR may include, for example, a so-called vertical electrode, and is provided to extend from the surface of the semiconductor layer (semiconductor layer 100S in FIG. 5 to be described later) to a depth reaching the photodiode PD as illustrated in FIG. 5 to be described later. The reset transistor RST resets the potential of the floating diffusion FD to a predetermined potential. When the reset transistor RST is turned on, the potential of the floating diffusion FD is reset to the potential of the power supply line VDD. The selection transistor SEL controls an output timing of the pixel signal from the pixel circuit 210. The amplification transistor AMP generates a signal of a voltage corresponding to the level of the charge held in the floating diffusion FD as a pixel signal. The amplification transistor AMP is connected to the vertical signal line 543 via the selection transistor SEL. The amplification transistor AMP constitutes a source follower together with the load circuit unit (see FIG. 1) connected to the vertical signal line 543 in the column signal processing unit 550. When the selection transistor SEL is turned on, the amplification transistor AMP outputs the voltage of the floating diffusion FD to the column signal processing unit 550 via the vertical signal line 543. The reset transistor RST, the amplification transistor AMP, and the selection transistor SEL are, for example, n-type (second conductivity type) CMOS transistors.

The FD conversion gain switching transistor FDG is used to change the gain of charge-voltage conversion in the floating diffusion FD. In general, a pixel signal is small at the time of photographing in a dark place. If the capacitance (FD capacitance C) of the floating diffusion FD is large at the time of performing charge-voltage conversion on the basis of the relational expression of Q (charge amount) = CV, the voltage value V when converted into a voltage by the amplification transistor AMP becomes small. On the other hand, in a bright place, since the pixel signal becomes large, the floating diffusion FD cannot receive the charge of the photodiode PD unless the FD capacitance C is large. Furthermore, the FD capacitance C needs to be large so that V when converted into a voltage by the amplification transistor AMP does not become too large (in other words, so as to become small). In view of these, when the FD conversion gain switching transistor FDG is turned on, the gate capacitance of the FD conversion gain switching transistor FDG increases, and thus, the entire FD capacitance C increases. On the other hand, when the FD conversion gain switching transistor FDG is turned off, the entire FD capacitance C decreases. In this manner, by switching the FD conversion gain switching transistor FDG on and off, the FD capacitance C can be made variable, and the conversion efficiency can be switched. The FD conversion gain switching transistor FDG is, for example, an n-type (second conductivity type) CMOS transistor. Note that, in an embodiment of the present disclosure to be described later, a configuration in which the FD conversion gain switching transistor FDG is not provided is also possible. At this time, for example, the pixel circuit 210 is configured of three transistors including, for example, an amplification transistor AMP, a selection transistor SEL, and a reset transistor RST.

Further, the selection transistor SEL may be provided between the power supply line VDD and the amplification transistor AMP. In this case, the drain of the reset transistor RST is electrically connected to the power supply line VDD and the drain of the selection transistor SEL. The source of the selection transistor SEL is electrically connected to the drain of the amplification transistor AMP, and the gate of the selection transistor SEL is electrically connected to the row drive signal line 542 (see FIG. 1). The source of the amplification transistor AMP (the output end of the pixel circuit 210) is electrically connected to the vertical signal line 543, and the gate of the amplification transistor AMP is electrically connected to the source of the reset transistor RST. Note that, although not illustrated, the number of pixels 541 sharing one pixel circuit 210 may be other than four. For example, two or eight pixels 541 may share one pixel circuit 210.

### <1.3 Detailed Configuration of Imaging Device 1 According to Comparative Example>

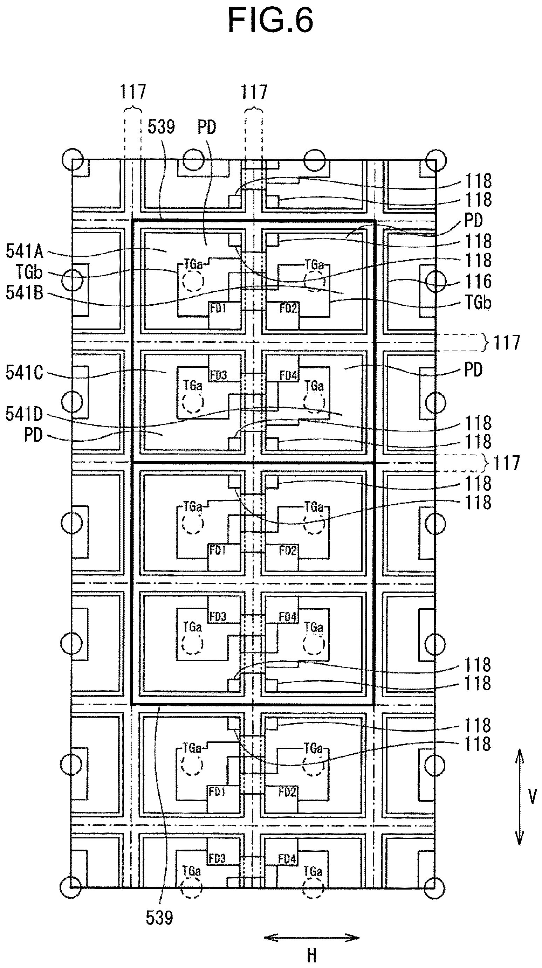

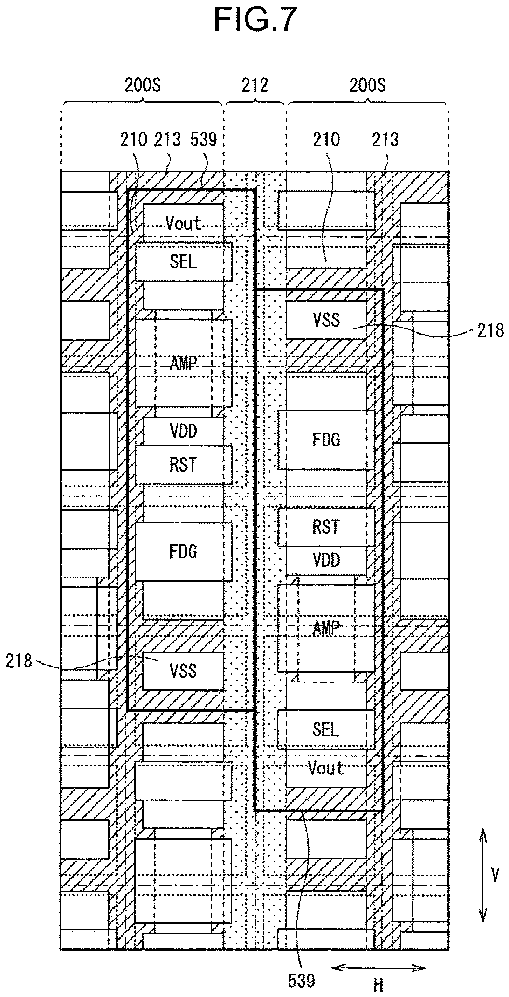

Next, an example of a detailed configuration of an imaging device 1 according to a comparative example compared with the embodiment of the present disclosure will be described with reference to FIGS. 5 to 7. FIG. 5 is a schematic cross-sectional view illustrating an example of a detailed configuration of the imaging device 1 according to the comparative example, and specifically illustrates an example of a cross-sectional configuration in a direction perpendicular to main surfaces of the first semiconductor substrate 100, the second semiconductor substrate 200, and the third semiconductor substrate 300 of the imaging device 1. In FIG. 5, the positional relationship of the components is schematically illustrated for easy understanding, and may be different from the actual cross section. Further, FIG. 6 is a schematic diagram illustrating an example of a planar configuration of a main part of the first semiconductor substrate 100 illustrated in FIG. 5. FIG. 6 mainly illustrates a planar configuration of a pixel isolation unit 117, the photodiode PD, the floating diffusion FD, a well region 118, and the transfer transistor TR of the first semiconductor substrate 100. FIG. 7 is a schematic diagram illustrating an example of a planar configuration of a main part of the second semiconductor substrate 200 illustrated in FIG. 5, and FIG. 7 illustrates the configuration of the pixel circuit 210 provided in the vicinity of the surface of the semiconductor layer 200S. Note that, in FIG. 7, the outer shape of the photodiode PD (the boundary between the pixel isolation unit 117 and the photodiode PD) is indicated by a broken line, and the boundary between the semiconductor layer 200S and an element isolation region 213 or an insulating region 214 in a portion overlapping the gate electrode of each transistor constituting the pixel circuit 210 is indicated by a dotted line. In a portion overlapping the gate electrode of the amplification transistor AMP, a boundary between the semiconductor layer 200S and the element isolation region 213 and a boundary between the element isolation region 213 and an insulating region 212 are provided on one side in the channel width direction. Note that, here, the comparative example means the imaging device 1 that has been repeatedly studied by the present inventors before the embodiment of the present disclosure is made.

As illustrated in FIG. 5, in the imaging device 1, the first semiconductor substrate 100, the second semiconductor substrate 200, and the third semiconductor substrate 300 are stacked in this order. Furthermore, the imaging device 1 includes a light receiving lens 401 on the back surface side (light incident surface side) of the first semiconductor substrate 100. A color filter layer (not illustrated) may be provided between the light receiving lens 401 and the first semiconductor substrate 100. The light receiving lens 401 is provided in each of the pixels 541A, 541B, 541C, and 541D, for example. Then, the imaging device 1 includes the pixel array unit 540 arranged in a central portion and a peripheral portion 540B arranged outside the pixel array unit 540.

The first semiconductor substrate 100 includes an insulating film 111, a fixed charge film 112, the semiconductor layer 100S, and the wiring layer 100T in this order from the light receiving lens 401 side. The semiconductor layer 100S is formed of, for example, a silicon substrate. The semiconductor layer 100S includes, for example, a p-well layer 115 containing, for example, p-type (first conductivity type) impurities at a part of a surface (surface on the wiring layer 100T side) and in the vicinity thereof, that is, the p-well layer 115 is a p-type (first conductivity type) semiconductor region. Then, the semiconductor layer 100S includes an n-type (first conductivity type) semiconductor region 114 containing impurities of n-type (second conductivity type) which is a conductivity type opposite to the p-type in a region other than the p-well layer (a region deeper than the p-well layer 115). For example, the n-type semiconductor region 114 and the p-well layer 115 constitute a p-n junction type photodiode PD.

The floating diffusion FD and the well region 118 are provided in the vicinity of the surface of the semiconductor layer 100S. The floating diffusion FD includes an n-type semiconductor region provided in the p-well layer 115. As illustrated in FIG. 6, the floating diffusion FD (floating diffusions FD1, FD2, FD3, and FD4) of each of the pixels 541A, 541B, 541C, and 541D is provided, for example, close to each other in the central portion of the pixel sharing unit 539. Although details will be described later, the four floating diffusions (floating diffusions FD1, FD2, FD3, and FD4) included in the pixel sharing unit 539 are electrically connected to each other via electrical connection means (pad unit 120 to be described later) in the first semiconductor substrate 100 (more specifically, in the wiring layer 100T). Further, the floating diffusion FD is connected from the first semiconductor substrate 100 to the second semiconductor substrate 200 (more specifically, from the wiring layer 100T to the wiring layer 200T) via electrical means (through electrode 120E to be described later). In the second semiconductor substrate 200 (more specifically, inside the wiring layer 200T), the floating diffusion FD is electrically connected to the gate of the amplification transistor AMP and the source of the FD conversion gain switching transistor FDG by this electrical means.

The well region 118 is a region electrically connected to the reference potential line VSS, and is disposed apart from the floating diffusion FD. For example, as illustrated in FIG. 6, in the pixels 541A, 541B, 541C, and 541D, the floating diffusion FD is arranged at one end of each pixel in the V direction, and the well region 118 is arranged at the other end. The well region 118 is configured of, for example, a p-type (first conductivity type) semiconductor region. The well region 118 is connected to, for example, a ground potential or a fixed potential. As a result, the reference potential is supplied to the semiconductor layer 100S.

The transfer transistor TR is provided on the first semiconductor substrate 100 together with the photodiode PD, the floating diffusion FD, and the well region 118. The photodiode PD, the floating diffusion FD, the well region 118, and the transfer transistor TR are provided in each of the pixels 541A, 541B, 541C, and 541D. The transfer transistor TR is provided on the front surface side (the side opposite to light incident surface side, the second semiconductor substrate 200 side) of the semiconductor layer 100S. The transfer transistor TR includes a transfer gate TG. The transfer gate TG includes, for example, a horizontal portion TGb facing the surface of the semiconductor layer 100S and a vertical portion TGa provided in the semiconductor layer 100S. The vertical portion TGa extends in the thickness direction of the semiconductor layer 100S. One end of the vertical portion TGa is in contact with the horizontal portion TGb, and the other end is provided in the n-type semiconductor region 114. By configuring the transfer transistor TR with such a vertical transistor, transfer failure of the pixel signal hardly occurs, and the readout efficiency of the pixel signal can be improved.

As illustrated in FIG. 6, the horizontal portion TGb of the transfer gate TG extends from a position facing the vertical portion TGa toward, for example, the central portion of the pixel sharing unit 539 in the H direction. As a result, the position in the H direction of the through electrode (through electrode TGV to be described later) reaching the transfer gate TG can be brought close to the position in the H direction of the through electrodes (through electrodes 120E and 121E to be described later) connected to the floating diffusion FD and the well region 118. For example, the plurality of pixel sharing units 539 provided on the first semiconductor substrate 100 has the same configuration.

The semiconductor layer 100S is provided with the pixel isolation unit 117 that isolates the pixels 541A, 541B, 541C, and 541D from each other. The pixel isolation unit 117 is formed to extend in the normal direction of the semiconductor layer 100S (direction perpendicular to the surface of the semiconductor layer 100S). As illustrated in FIG. 6, the pixel isolation unit 117 is provided so as to partition the pixels 541A, 541B, 541C, and 541D from each other, and has, for example, a grid-like planar shape. For example, the pixel isolation unit 117 electrically and optically isolates the pixels 541A, 541B, 541C, and 541D from each other. The pixel isolation unit 117 may include, for example, a light shielding film 117A and an insulating film 117B. The light shielding film 117A can be formed of, for example, tungsten (W) or the like. The insulating film 117B is provided between the light shielding film 117A and the p-well layer 115 or the n-type semiconductor region 114, and can be formed of, for example, silicon oxide (SiO₂). The pixel isolation unit 117 has, for example, a full trench isolation (FTI) structure and penetrates the semiconductor layer 100S. Note that, in the embodiment of the present disclosure described later, the pixel isolation unit 117 is not limited to the FTI structure penetrating the semiconductor layer 100S, and may have, for example, a deep trench isolation (DTI) structure not penetrating the semiconductor layer 100S. Then, the pixel isolation unit 117 extends in the normal direction of the semiconductor layer 100S and is formed in a partial region of the semiconductor layer 100S.

In the semiconductor layer 100S, for example, a first pinning region 113 and a second pinning region 116 are provided. The first pinning region 113 is provided in the vicinity of the back surface of the semiconductor layer 100S, and is disposed between the n-type semiconductor region 114 and the fixed charge film 112. The second pinning region 116 is provided on a side surface of the pixel isolation unit 117, specifically, between the pixel isolation unit 117 and the p-well layer 115 or the n-type semiconductor region 114. The first pinning region 113 and the second pinning region 116 are made of, for example, a p-type (first conductivity type) semiconductor region. Then, the fixed charge film 112 having a negative fixed charge is provided between the semiconductor layer 100S and the insulating film 111. The first pinning region 113 of the hole accumulation layer is formed at the interface on the light receiving surface (back surface) side of the semiconductor layer 100S by the electric field induced by the fixed charge film 112. As a result, generation of dark current due to the interface state on the light receiving surface side of the semiconductor layer 100S is reduced. The fixed charge film 112 is formed of, for example, an insulating film having the negative fixed charge. Examples of the material of the insulating film having a negative fixed charge include hafnium oxide (HfO₂), zirconium oxide (ZrO), aluminum oxide (Al₂O₃), titanium oxide (TiO₂), and tantalum oxide (Ta₂O₅).

Furthermore, the light shielding film 117A is provided between the fixed charge film 112 and the insulating film 111. The light shielding film 117A may be provided continuously with the light shielding film 117A constituting the pixel isolation unit 117. The light shielding film 117A between the fixed charge film 112 and the insulating film 111 is selectively provided, for example, at a position facing the pixel isolation unit 117 in the semiconductor layer 100S. The insulating film 111 is provided so as to cover the light shielding film 117A. The insulating film 111 can be formed of, for example, silicon oxide (SiO₂) or the like.

As illustrated in FIG. 5, the wiring layer 100T provided between the semiconductor layer 100S and the second semiconductor substrate 200 includes an interlayer insulating film 119, pad units 120 and 121, a passivation film 122, an interlayer insulating film 123, and a bonding film 124 in this order from the semiconductor layer 100S side. The horizontal portion TGb of the transfer gate TG is provided in the wiring layer 100T, for example. The interlayer insulating film 119 is provided over the entire surface of the semiconductor layer 100S and is in contact with the semiconductor layer 100S. The interlayer insulating film 119 is formed of, for example, silicon oxide (SiO₂) or the like. Note that the configuration of the wiring layer 100T is not limited to the above, and may be a configuration including wiring and an insulating film.

The pad unit 120 is for connecting the floating diffusions FD (floating diffusions FD1, FD2, FD3, and FD4) of the pixels 541A, 541B, 541C, and 541D to each other. For example, the pad unit 120 is arranged at the central portion of the pixel sharing unit 539 in plan view for each pixel sharing unit 539. The pad unit 120 is provided so as to straddle the pixel isolation unit 117, and is arranged so as to overlap at least a part of each of the floating diffusions FD1, FD2, FD3, and FD4. Specifically, the pad unit 120 is formed in a region overlapping at least a part of each of the plurality of floating diffusions FD (Floating diffusion FD1, FD2, FD3, FD4) sharing the pixel circuit 210 and at least a part of the pixel isolation unit 117 formed between the plurality of photodiodes PD (Photodiodes PD1, PD2, PD3, PD4) sharing the pixel circuit 210 in a direction perpendicular to the surface of the semiconductor layer 100S.

Furthermore, the interlayer insulating film 119 is provided with a connection via 120C for electrically connecting the pad unit 120 and the floating diffusions FD1, FD2, FD3, and FD4. The connection via 120C is provided in each of the pixels 541A, 541B, 541C, and 541D. For example, by embedding a part of the pad unit 120 in the connection via 120C, the pad unit 120 and the floating diffusions FD1, FD2, FD3, and FD4 are electrically connected.

The pad unit 121 is an electrode for connecting the plurality of well regions 118 to each other. For example, the well region 118 provided in the pixels 541C and 541D of one pixel sharing unit 539 and the well region 118 provided in the pixels 541A and 541B of the other pixel sharing unit 539 adjacent in the V direction are electrically connected by the pad unit 121. The pad unit 121 is provided, for example, so as to straddle the pixel isolation unit 117, and is arranged to overlap at least a part of each of the four well regions 118. Specifically, the pad unit 121 is formed in a region overlapping at least a part of each of the plurality of well regions 118 and at least a part of the pixel isolation unit 117 formed between the plurality of well regions 118 in a direction perpendicular to the surface of the semiconductor layer 100S. The interlayer insulating film 119 is provided with a connection via 121C for electrically connecting the pad unit 121 and the well region 118. The connection via 121C is provided in each of the pixels 541A, 541B, 541C, and 541D. For example, by embedding a part of the pad unit 121 in the connection via 121C, the pad unit 121 and the well region 118 are electrically connected. For example, the pad unit 120 and the pad unit 121 of each of the plurality of pixel sharing units 539 arranged in the V direction are arranged at substantially the same position in the H direction in plan view.

Furthermore, the pad units 120 and 121 can be provided at desired positions on the first semiconductor substrate 100 and the second semiconductor substrate 200. Specifically, the pad units 120 and 121 can be provided in either the wiring layer 100T or the insulating region 212 of the semiconductor layer 200S. When provided in the wiring layer 100T, the pad units 120 and 121 may be brought into direct contact with the semiconductor layer 100S. Specifically, the pad units 120 and 121 may be directly connected to at least a part of each of the floating diffusions FD and/or the well regions 118. In addition, the connection vias 120C and 121C may be provided in the floating diffusion FD connected to the pad units 120 and 121 and/or the well region 118, respectively, and the pad units 120 and 121 may be provided at desired positions of the wiring layer 100T and the insulating region 212 of the semiconductor layer 200S.

In particular, if the pad units 120 and 121 are provided in the wiring layer 100T, the wiring connected to the floating diffusion FD in the insulating region 212 of the semiconductor layer 200S and/or the well region 118 can be reduced. As a result, in the second semiconductor substrate 200 forming the pixel circuit 210, the area of the insulating region 212 for forming the through wiring for connecting the floating diffusion FD to the pixel circuit 210 can be reduced. Therefore, it is possible to secure a large area of the second semiconductor substrate 200 forming the pixel circuit 210. By securing the area of the pixel circuit 210, it is possible to form a large pixel transistor and contribute to image quality improvement by noise reduction or the like.

In particular, if the FTI structure is used for the pixel isolation unit 117, it is preferable to provide the floating diffusion FD and/or the well region 118 in each pixel 541. Therefore, by using the configurations of the pad units 120 and 121, the wiring connecting the first semiconductor substrate 100 and the second semiconductor substrate 200 can be significantly reduced.

The pad units 120 and 121 are made of, for example, polysilicon (Poly Si), more specifically, doped polysilicon to which impurities are added. In addition, the pad units 120 and 121 are preferably made of a conductive material having high heat resistance such as polysilicon, tungsten, titanium (Ti), or titanium nitride (TiN). As a result, the pixel circuit 210 can be formed after the semiconductor layer 200S of the second semiconductor substrate 200 is bonded to the first semiconductor substrate 100.

As illustrated in FIG. 5, the passivation film 122 is provided over the entire surface of the semiconductor layer 100S so as to cover the pad units 120 and 121, for example. The passivation film 122 is made of, for example, silicon nitride (SiN) or the like. The interlayer insulating film 123 covers the pad units 120 and 121 with the passivation film 122 interposed therebetween. The interlayer insulating film 123 is provided over the entire surface of the semiconductor layer 100S, for example. The interlayer insulating film 123 can be formed of, for example, silicon oxide, silicon nitride, a stack thereof, or the like. Further, the bonding film 124 is provided on a bonding surface between the first semiconductor substrate 100 (specifically, the wiring layer 100T) and the second semiconductor substrate 200. That is, the bonding film 124 is in contact with the second semiconductor substrate 200. The bonding film 124 is provided over the entire main surface of the first semiconductor substrate 100, and can be formed of, for example, silicon nitride or the like.

As illustrated in FIG. 5, the light receiving lens 401 faces the semiconductor layer 100S with the fixed charge film 112 and the insulating film 111 interposed therebetween, for example. The light receiving lens 401 is provided, for example, at a position facing the photodiode PD of each of the pixels 541A, 541B, 541C, and 541D.

As illustrated in FIG. 5, the second semiconductor substrate 200 includes the semiconductor layer 200S and the wiring layer 200T in this order from the first semiconductor substrate 100 side. The semiconductor layer 200S is formed of a silicon substrate. In the semiconductor layer 200S, a well region 211 is provided over the thickness direction. The well region 211 is, for example, a p-type (first conductivity type) semiconductor region. The second semiconductor substrate 200 is provided with the pixel circuit 210 arranged for each pixel sharing unit 539. The pixel circuit 210 is provided, for example, on the front surface side (wiring layer 200T side) of the semiconductor layer 200S. In the imaging device 1, the second semiconductor substrate 200 is bonded to the first semiconductor substrate 100 such that the back surface side (semiconductor layer 200S side) of the second semiconductor substrate 200 faces the front surface side (wiring layer 100T side) of the first semiconductor substrate 100. That is, the second semiconductor substrate 200 is bonded to the first semiconductor substrate 100 in a face-to-back manner.

As illustrated in FIG. 5, the second semiconductor substrate 200 is provided with the insulating region 212 that divides the semiconductor layer 200S, and the element isolation region 213 provided in a part of the semiconductor layer 200S in the thickness direction. For example, the through electrodes 120E and 121E and the through electrodes TGV (Through electrode TGV1, TGV2, TGV3, and TGV4) of the two pixel sharing units 539 connected to the two pixel circuits 210 are arranged in the insulating region 212 provided between the two pixel circuits 210 adjacent in the H direction.

As illustrated in FIG. 5, the insulating region 212 has substantially the same thickness as the thickness of the semiconductor layer 200S. The semiconductor layer 200S is divided by the insulating region 212. The through electrodes 120E and 121E and the through electrode TGV are arranged in the insulating region 212. The insulating region 212 can be formed of, for example, silicon oxide or the like.

The through electrodes 120E and 121E are provided to penetrate the insulating region 212 in the thickness direction. The upper ends of the through electrodes 120E and 121E are connected to wiring (first wiring layer W1, second wiring layer W2, third wiring layer W3, and fourth wiring layer W4) of the wiring layer 200T. The through electrodes 120E and 121E are provided to penetrate the insulating region 212, the bonding film 124, the interlayer insulating film 123, and the passivation film 122, and lower ends thereof are connected to the pad units 120 and 121. The through electrode 120E is an electrode for electrically connecting the pad unit 120 and the pixel circuit 210. That is, the floating diffusion FD of the first semiconductor substrate 100 is electrically connected to the pixel circuit 210 of the second semiconductor substrate 200 by the through electrode 120E. The through electrode 121E is an electrode for electrically connecting the pad unit 121 and the reference potential line VSS of the wiring layer 200T. That is, the through electrode 121E electrically connects the well region 118 of the first semiconductor substrate 100 to the reference potential line VSS of the second semiconductor substrate 200.

The through electrode TGV is provided to penetrate the insulating region 212 in the thickness direction. The upper end of the through electrode TGV is connected to the wiring of the wiring layer 200T. The through electrode TGV is provided to penetrate the insulating region 212, the bonding film 124, the interlayer insulating film 123, the passivation film 122, and the interlayer insulating film 119, and the lower end thereof is connected to the transfer gate TG. Such a through electrode TGV is for electrically connecting the transfer gate TG (transfer gates TG1, TG2, TG3, and TG4) of each of the pixels 541A, 541B, 541C, and 541D to the wiring (a part of the row drive signal line 542) of the wiring layer 200T. That is, the transfer gate TG of the first semiconductor substrate 100 is electrically connected to the wiring of the second semiconductor substrate 200 by the through electrode TGV, and can transmit a drive signal to each of the transfer transistors TR (transfer transistors TR1, TR2, TR3, and TR4) .

The insulating region 212 is a region for insulating the through electrodes 120E and 121E and the through electrode TGV for electrically connecting the first semiconductor substrate 100 and the second semiconductor substrate 200 from the semiconductor layer 200S. For example, in the insulating region 212 provided between two pixel circuits 210 (pixel sharing units 539) adjacent in the H direction, the through electrodes 120E and 121E and through electrodes TGV (through electrodes TGV1, TGV2, TGV3, and TGV4) connected to the two pixel circuits 210 are arranged. The insulating region 212 is provided, for example, to extend in the V direction (see FIG. 7). Here, by devising the arrangement of the horizontal portion TGb of the transfer gate TG, the through electrode TGV is arranged such that the position of the through electrode TGV in the H direction approaches the positions of the through electrodes 120E and 121E in the H direction as compared with the position of the vertical portion TGa. For example, the through electrode TGV is disposed at substantially the same position as the through electrodes 120E and 120E in the H direction. As a result, the through electrodes 120E and 121E and the through electrode TGV can be collectively provided in the insulating region 212 extending in the V direction (see FIG. 5).

As described with reference to FIG. 4, the pixel sharing unit 539 has a structure in which the floating diffusions FD provided in the plurality of pixels 541 are electrically connected to each other, and the plurality of pixels 541 shares one pixel circuit 210. Then, the floating diffusions FD are electrically connected by the pad unit 120 provided on the first semiconductor substrate 100 (see FIG. 5). The electrical connection unit (pad unit 120) provided on the first semiconductor substrate 100 and the pixel circuit 210 provided on the second semiconductor substrate 200 are electrically connected via one through electrode 120E.

The element isolation region 213 is provided on the front surface side of the semiconductor layer 200S. The element isolation region 213 has a shallow trench isolation (STI) structure. In the element isolation region 213, the semiconductor layer 200S is dug in the thickness direction (direction perpendicular to the main surface of the second semiconductor substrate 200), and an insulating film is embedded in the dug. The insulating film is made of, for example, silicon oxide, or the like. The element isolation region 213 isolates the plurality of transistors constituting the pixel circuit 210 from each other in accordance with the layout of the pixel circuit 210. The semiconductor layer 200S (specifically, the well region 211) extends below the element isolation region 213 (deep portion of the semiconductor layer 200S).

As illustrated in FIG. 7, the amplification transistor AMP is provided in the semiconductor layer 200S, and the amplification transistor AMP may have a three-dimensional structure such as a Fin type (see FIG. 5). As a result, the magnitude of the effective gate width increases, and noise can be reduced. On the other hand, the selection transistor SEL, the reset transistor RST, and the FD conversion gain switching transistor FDG provided in the semiconductor layer 200S may have, for example, a planar structure. In an embodiment of the present disclosure described later, the amplification transistor AMP may have a planar structure. Alternately, the selection transistor SEL, the reset transistor RST, or the FD conversion gain switching transistor FDG may have a three-dimensional structure.

The wiring layer 200T includes, for example, a passivation film 221, an interlayer insulating film 222, and a plurality of wirings (first wiring layer W1, second wiring layer W2, third wiring layer W3, and fourth wiring layer W4). The passivation film 221 is, for example, in contact with the surface of the semiconductor layer 200S and covers the entire surface of the semiconductor layer 200S. The passivation film 221 covers the respective gate electrodes of the selection transistor SEL, the amplification transistor AMP, the reset transistor RST, and the FD conversion gain switching transistor FDG. The interlayer insulating film 222 is provided between the passivation film 221 and the third semiconductor substrate 300. The plurality of wirings (the first wiring layer W1, the second wiring layer W2, the third wiring layer W3, and the fourth wiring layer W4) are separated by the interlayer insulating film 222. The interlayer insulating film 222 can be formed of, for example, silicon oxide or the like.

In the wiring layer 200T, for example, the first wiring layer W1, the second wiring layer W2, the third wiring layer W3, the fourth wiring layer W4, and the contact units 201 and 202 are provided in this order from the semiconductor layer 200S side, and these are insulated from each other by the interlayer insulating film 222. The interlayer insulating film 222 is provided with a plurality of connection units that connect the first wiring layer W1, the second wiring layer W2, the third wiring layer W3, or the fourth wiring layer W4 and the lower layers thereof. The connection unit is a portion in which a conductive material is embedded in a connection hole provided in the interlayer insulating film 222. For example, the interlayer insulating film 222 is provided with a connection unit 218V that connects the first wiring layer W1 and a well region 218 of the semiconductor layer 200S. For example, the hole diameter of the connection unit connecting the elements of the second semiconductor substrate 200 is different from the hole diameters of the through electrodes 120E and 121E and the through electrode TGV. Specifically, the hole diameter of the connection hole connecting the elements of the second semiconductor substrate 200 is preferably smaller than the hole diameters of the through electrodes 120E and 121E and the through electrode TGV.

For example, the through electrode 120E, the gate of the amplification transistor AMP, and the source (specifically, a connection hole reaching the source of the FD conversion gain switching transistor FDG) of the FD conversion gain switching transistor FDG are connected by the first wiring layer W1. The first wiring layer W1 connects, for example, the through electrode 121E and the connection unit 218V, whereby the well region 218 of the semiconductor layer 200S and the well region 118 of the semiconductor layer 100S are electrically connected.

For example, the third wiring layer W3 includes some of the plurality of row drive signal lines 542 described with reference to FIG. 3. Some of the plurality of row drive signal lines 542 are electrically connected to the transfer gates TG1, TG2, TG3, and TG4 via the second wiring layer W2, the first wiring layer W1, and the through electrode 120E, respectively.

In addition, for example, the fourth wiring layer W4 includes the power supply line VDD, the reference potential line VSS, and the vertical signal line 543 extending in the V direction (column direction). The power supply line VDD is electrically connected to the drain of the amplification transistor AMP and the drain of the reset transistor RST via the third wiring layer W3, the second wiring layer W2, the first wiring layer W1, and the connection unit. The reference potential line VSS is electrically connected to the well region 218 via the third wiring layer W3, the second wiring layer W2, the first wiring layer W1, and the connection unit 218V. In addition, the reference potential line VSS is electrically connected to the well region 118 of the first semiconductor substrate 100 via the third wiring layer W3, the second wiring layer W2, the first wiring layer W1, the through electrode 121E, and the pad unit 121. The vertical signal line 543 is electrically connected to the source (Vout) of the selection transistor SEL via the third wiring layer W3, the second wiring layer W2, the first wiring layer W1, and the connection unit.

The contact units 201 and 202 may be provided at positions overlapping the pixel array unit 540 in plan view, or may be provided in the peripheral portion 540B outside the pixel array unit 540. The contact units 201 and 202 are provided on the surface (surface on the wiring layer 200T side) of the second semiconductor substrate 200, and can be formed of metal such as copper or aluminum, for example. The contact units 201 and 202 are exposed to the surface (surface on the third semiconductor substrate 300 side) of the wiring layer 200T. The contact units 201 and 202 are used for electrical connection between the second semiconductor substrate 200 and the third semiconductor substrate 300 and bonding between the second semiconductor substrate 200 and the third semiconductor substrate 300.

Furthermore, the third semiconductor substrate 300 includes, for example, the wiring layer 300T and the semiconductor layer 300S in this order from the second semiconductor substrate 200 side. For example, the surface of the semiconductor layer 300S is provided on the second semiconductor substrate 200 side. The semiconductor layer 300S is formed of a silicon substrate. A circuit is provided in a portion on the front surface side of the semiconductor layer 300S. Specifically, for example, at least a part of the input unit 510A, the row drive unit 520, the timing control unit 530, the column signal processing unit 550, the image signal processing unit 560, and the output unit 510B is provided in the portion on the front surface side of the semiconductor layer 300S. The wiring layer 300T provided between the semiconductor layer 300S and the second semiconductor substrate 200 includes, for example, an interlayer insulating film, a plurality of wiring layers separated by the interlayer insulating film, and contact units 301 and 302. The contact units 301 and 302 are exposed on the surface (the surface on the second semiconductor substrate 200 side) of the wiring layer 300T, the contact unit 301 is in contact with the contact unit 201 of the second semiconductor substrate 200, and the contact unit 302 is in contact with the contact unit 202 of the second semiconductor substrate 200. The contact units 301 and 302 are electrically connected to the circuit (for example, at least one of the input unit 510A, the row drive unit 520, the timing control unit 530, the column signal processing unit 550, the image signal processing unit 560, and the output unit 510B) formed in the semiconductor layer 300S. The contact units 301 and 302 can be formed of, for example, a metal such as copper or aluminum.

### <1.4 Background>

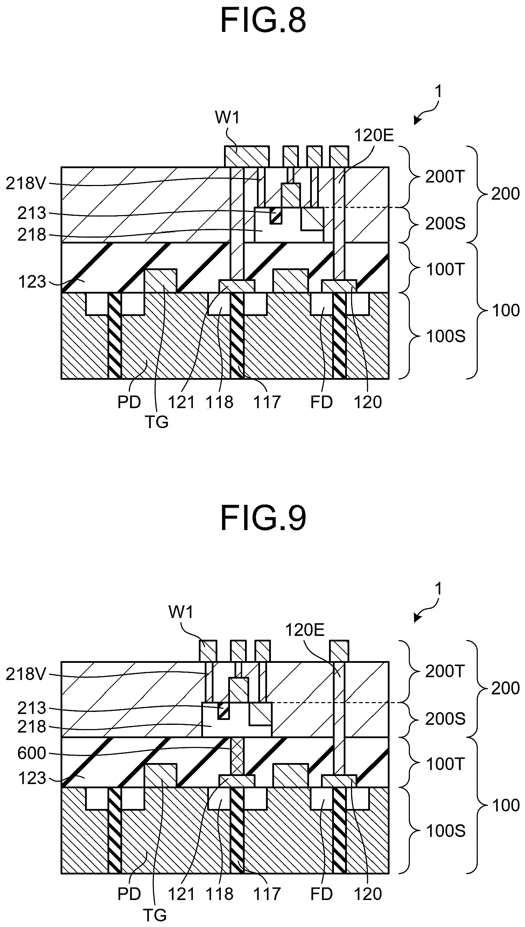

Next, details of the background in which the present inventors have created the embodiment of the present disclosure on the basis of the above-described configuration of the imaging device 1 will be described with reference to FIGS. 8 and 9. FIG. 8 is a schematic diagram illustrating a cross-sectional configuration of a main part of the imaging device 1 according to a comparative example, and FIG. 9 is a schematic diagram illustrating a cross-sectional configuration of an example of the main part of the imaging device 1 according to the first embodiment of the present disclosure created by the present inventors. Note that, here, as described above, the comparative example means the imaging device 1 that has been repeatedly studied by the present inventors before forming the embodiment of the present disclosure.

As illustrated in FIG. 8, in the imaging device 1 according to the comparative example, as described above, the well region 118 of the semiconductor layer 100S is electrically connected to the well region 218 of the semiconductor layer 200S via the through electrode 121E and the connection unit 218V. Then, in the imaging device 1 according to the comparative example, the through electrode 121E and the connection unit 218V are required to be surrounded by an insulating region (not illustrated) to be electrically separated (insulated) from other elements. However, in such a configuration, in order to provide the through electrode 121E penetrating the semiconductor layer 200S and the insulating region surrounding the periphery thereof, use of the region of the semiconductor layer 200S such as provision of a transistor is limited. As a result, in the imaging device 1 according to the comparative example, there is a limit to further downsizing and miniaturization of the imaging device 1.

Therefore, in view of the above-described circumstances, the present inventors have intensively studied means that enables further downsizing and miniaturization of the imaging device 1, and have created the first embodiment of the present disclosure described below. In the imaging device 1 according to the present embodiment created by the present inventors, as illustrated in FIG. 9, instead of the through electrode 121E penetrating the semiconductor layer 200S and the wiring layer 100T in the comparative example, a via 600 penetrating the wiring layer 100T and electrically connecting the back surface (second surface) of the second semiconductor substrate 200 and the well region 118 of the first semiconductor substrate 100 is provided. The via 600 can electrically connect the well region 218 on the back surface side of the semiconductor layer 200S of the second semiconductor substrate 200 and the well region 118 of the semiconductor layer 100S of the first semiconductor substrate 100.

According to the first embodiment of the present disclosure as described above, since the through electrode 121E penetrating the semiconductor layer 200S and the insulating region surrounding the periphery thereof are not provided, the use of the region of the semiconductor layer 200S is not limited. As a result, according to the present embodiment, since the degree of freedom of the layout of the second semiconductor substrate 200 on the semiconductor layer 200S is improved, the imaging device 1 can be further downsized and miniaturized. Hereinafter, details of such a first embodiment of the present disclosure will be sequentially described.

### <<2. First Embodiment>>

### <2.1 Configuration>

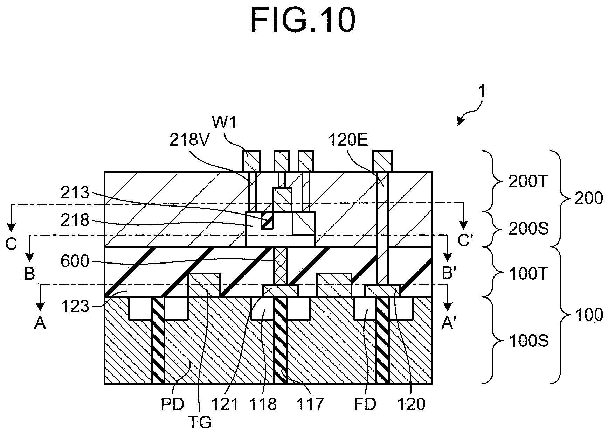

A detailed configuration of an imaging device 1 according to a first embodiment of the present disclosure created by the present inventors will be described with reference to FIG. 10. FIG. 10 is a schematic diagram illustrating a cross-sectional configuration of an example of a main part of the imaging device 1 according to the first embodiment of the present disclosure.

As described above, the imaging device 1 according to the first embodiment of the present disclosure includes the via 600 that penetrates the interlayer insulating film 123 of the wiring layer 100T and electrically connects the back surface (second surface) of the second semiconductor substrate 200 and the well region 118 of the first semiconductor substrate 100, instead of the through electrode 121E of the comparative example, as illustrated in FIG. 10. The via 600 electrically connects the well region (second well region) 218 on the back surface side of the semiconductor layer 200S of the second semiconductor substrate 200 and the well region (first well region) 118 of the semiconductor layer 100S of the first semiconductor substrate 100. In the present embodiment, the cross-sectional shape of the via 600 cut along the surface of the first semiconductor substrate 100 may be substantially circular or substantially rectangular, and is not particularly limited. Furthermore, in the present embodiment, the cross-sectional shape of the via 600 cut in the direction perpendicular to the surface of the first semiconductor substrate 100 may be a substantially rectangular shape, a substantially tapered shape in which the width decreases from the second semiconductor substrate 200 toward the first semiconductor substrate 100, or a substantially tapered shape in which the width decreases from the first semiconductor substrate 100 toward the second semiconductor substrate 200, and is not particularly limited. Note that, if the cross section of the via 600 has a substantially tapered shape in which the width decreases from the first semiconductor substrate 100 toward the second semiconductor substrate 200, the bonding surface between the via 600 and the well region 118 of the first semiconductor substrate 100 increases, so that the contact resistance can be reduced. In addition, a case where the cross section of the via 600 has a substantially tapered shape in which the width decreases from the second semiconductor substrate 200 toward the first semiconductor substrate 100 will be described in the description of the manufacturing method.

The well region 218 on the back surface side of the semiconductor layer 200S of the second semiconductor substrate 200 and the well region 118 of the semiconductor layer 100S of the first semiconductor substrate 100, which are electrically connected by the via 600, have the same conductivity type (for example, p-type). Therefore, the via 600 can be formed of, for example, polysilicon or amorphous silicon (BDAS) containing p-type (first conductivity type) impurities (for example, boron (B) or the like) so as to have the same conductivity type as the well regions 118 and 218. Note that a p-type (first conductivity type) impurity is also preferably implanted into the back surface side of the second semiconductor substrate 200 electrically connected to the via 600 in order to reduce an increase in resistance value due to connection.

Furthermore, the via 600 may be formed of a metal material such as aluminum, titanium (Ti), tantalum (Ta), tungsten, ruthenium (Ru), or molybdenum (Mo), or a compound material. Furthermore, the outer peripheral portion of the via 600 may be covered with a protective film (not illustrated) formed of silicon nitride (SiN), nitrogen-doped silicon carbide (SiCN), carbon-doped silicon oxide (SiOC), aluminum oxide, hafnium oxide, or the like. In the present embodiment, the position where the via 600 is provided is not particularly limited.

In the present embodiment, the via 600 is preferably formed of polysilicon. When formed of polysilicon, for example, metal atoms are not diffused by heating as compared with a case where formed of a metal material such as copper, and thus, for example, it is possible to avoid that metal atoms are diffused into the photodiode PD to deteriorate the photodiode PD.

Furthermore, in the present embodiment, as illustrated in FIG. 10, the via 600 can further include the pad unit (first pad unit) 121 provided on the front surface (first surface) of the semiconductor layer 100S of the first semiconductor substrate 100 and electrically connected to the via 600. For example, as described above, the plurality of photodiodes (photoelectric conversion elements) PD is provided in the semiconductor layer 100S of the first semiconductor substrate 100. Therefore, the pad unit 121 is provided so as to straddle the well region 118 provided in each section corresponding to each photodiode (photoelectric conversion element) PD. Further, the via 600 is electrically connected to the pad unit 121 provided so as to straddle, and thus, the plurality of well regions 118 can be electrically connected so as to be bundled.

As described above, according to the present embodiment, since the through electrode 121E penetrating the semiconductor layer 200S and the insulating region surrounding the periphery thereof are not provided, the use of the region of the semiconductor layer 200S is not limited. As a result, according to the present embodiment, since the degree of freedom of the layout of the second semiconductor substrate 200 on the semiconductor layer 200S is improved, the imaging device 1 can be further downsized and miniaturized.

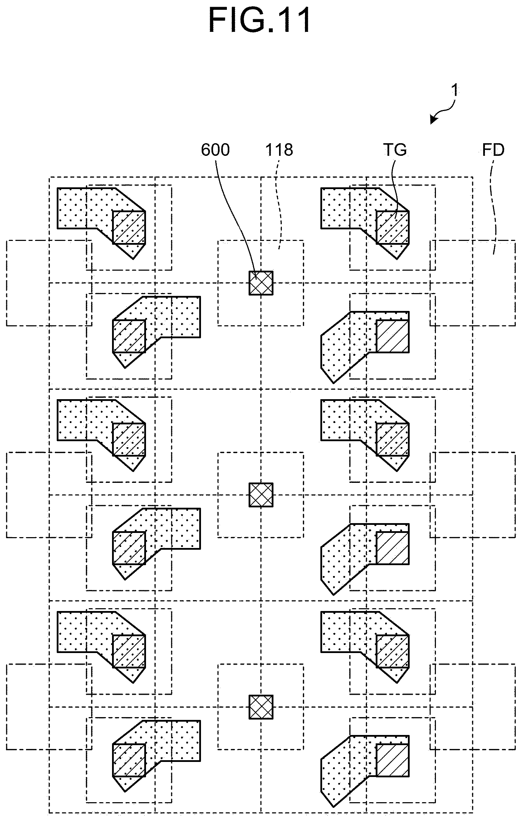

Furthermore, as described below, according to the present embodiment, the use of the region of the semiconductor layer 200S is not limited, and thus two amplification transistors AMP can be provided on the semiconductor layer 200S. Hereinafter, an example of such a planar configuration will be described with reference to FIGS. 11 to 13. FIGS. 11 to 13 are schematic diagrams illustrating a planar configuration of an example of a main part of the imaging device 1 according to the first embodiment of the present disclosure. Specifically, FIGS. 11 to 13 are a schematic diagram of a plane obtained by cutting the imaging device 1 along A-A' illustrated in FIG. 10, a schematic diagram of a plane obtained by cutting the imaging device 1 along B-B' illustrated in FIG. 10, and a schematic diagram of a plane obtained by cutting the imaging device 1 along C-C' illustrated in FIG. 10, respectively.

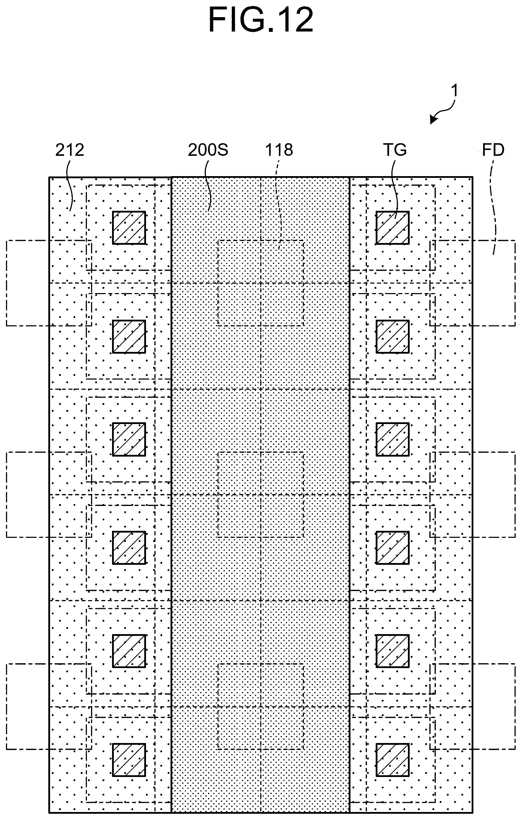

As illustrated in FIG. 11, the via 600 electrically connected to the pad unit 121 is formed on the pad unit 121 (in FIG. 11, illustration is omitted) that straddles the four well regions 118 and electrically connects these well regions. Then, as illustrated in FIG. 12 corresponding to the planar configuration in the upper part of FIG. 11, the semiconductor layer 200S on which a transistor or the like can be formed and the insulating region (DTI) 212 electrically separating the semiconductor layer 200S are alternately arranged. In the present embodiment, the via 600 does not penetrate the semiconductor layer 200S, and further, an insulating region is not formed around the via 600 in order to electrically separate the via 600 and the semiconductor layer 200S. Therefore, in the present embodiment, as illustrated in FIG. 12, a region on the semiconductor layer 200S that can be used to form a transistor or the like has a large area.

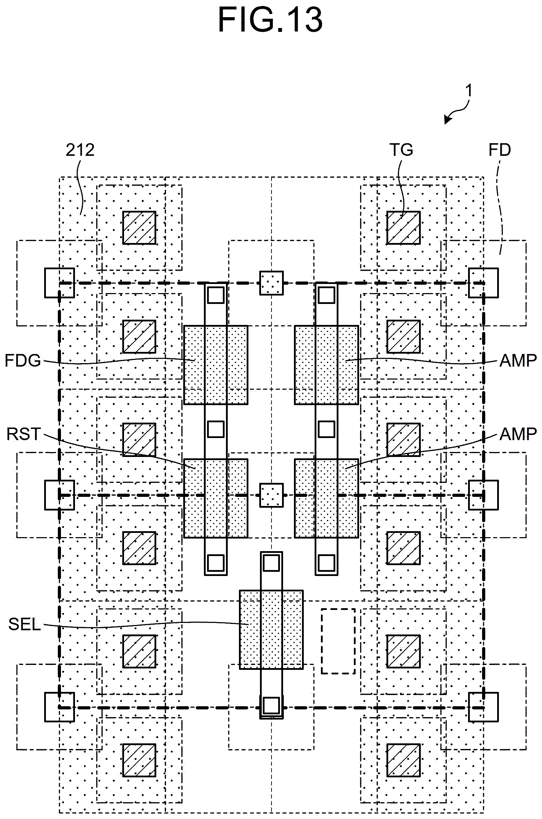

Then, as illustrated in FIG. 13 corresponding to the planar configuration in the upper part of FIG. 12, since the available area on the semiconductor layer 200S is large, the reset transistor RST, the selection transistor SEL, the amplification transistor AMP, the FD conversion gain switching transistor FDG, and the like can be freely provided on the semiconductor layer 200S. Furthermore, in the example illustrated in FIG. 13, since the available area is large, for example, two amplification transistors AMP can be provided on the semiconductor layer 200S. In this way, since the channel length of the amplification transistor AMP can be increased, noise on the pixel signal can be reduced. Note that, in the present embodiment, it is not limited to providing two amplification transistors, and an amplification transistor AMP having a large size can be used, and the number and size of other transistors can be freely changed.

### <2.2 Manufacturing Method>

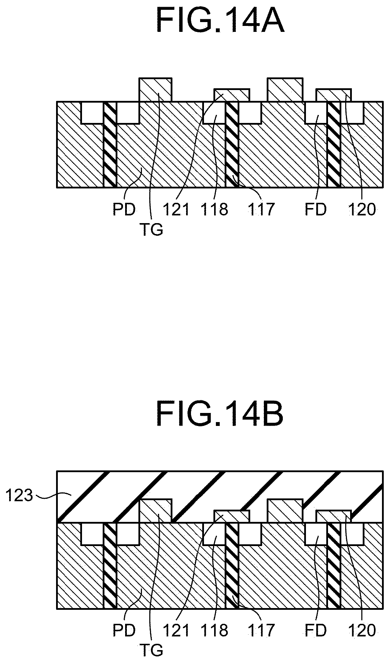

Next, a method of manufacturing the imaging device 1 according to the present embodiment will be described with reference to FIGS. 14A to 14G. FIGS. 14A to 14G are schematic diagrams for explaining the method of manufacturing the imaging device 1 according to the present embodiment, and in detail, each drawing is a cross-sectional view corresponding to the schematic diagram of the cross-sectional configuration of the imaging device 1 of FIG. 10 at each stage in a manufacturing process.

First, as illustrated in FIG. 14A, the gate (transfer gate) TG of the transfer transistor TR and the pad unit 121 are formed on the front surface (first surface) of the first semiconductor substrate 100 on which the photodiode PD (photoelectric conversion element), the pixel isolation unit 117, the well region 118, the floating diffusion FD, and the like are formed.

Next, as illustrated in FIG. 14B, the interlayer insulating film 123 made of silicon oxide or the like is stacked on the front surface (first surface) of the first semiconductor substrate 100, and the surface (upper surface in the drawing) is planarized by chemical mechanical polish (CMP) or the like.

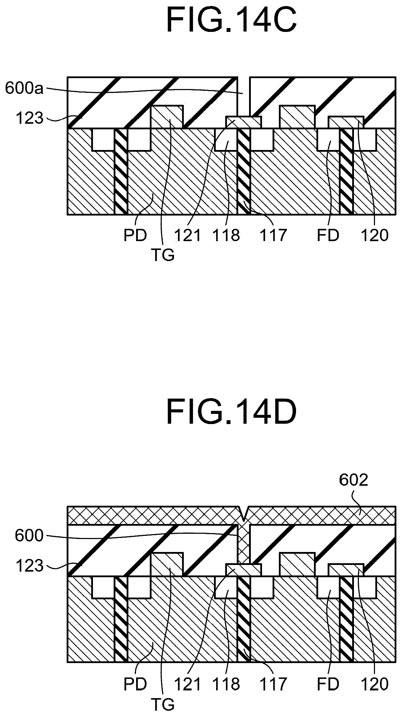

Next, as illustrated in FIG. 14C, a through hole 600a penetrating the interlayer insulating film 123 from the surface of the interlayer insulating film 123 to the pad unit 121 is formed. For example, the through hole 600a can be formed by dry etching using plasma or the like.

Next, as illustrated in FIG. 14D, polysilicon 602 is formed so as to fill the through hole 600a. When the cross-sectional shape of the through hole 600a cut in the direction perpendicular to the surface of the first semiconductor substrate 100 is a substantially tapered shape in which the width decreases from the upper side to the lower side in the drawing, the polysilicon 602 is easily embedded in the through hole 600a. In other words, in this case, the embedding property of the polysilicon 602 in the through hole 600a is improved. Furthermore, p-type (first conductivity type) impurities such as boron are implanted into the embedded polysilicon 602 by an ion implantation method.

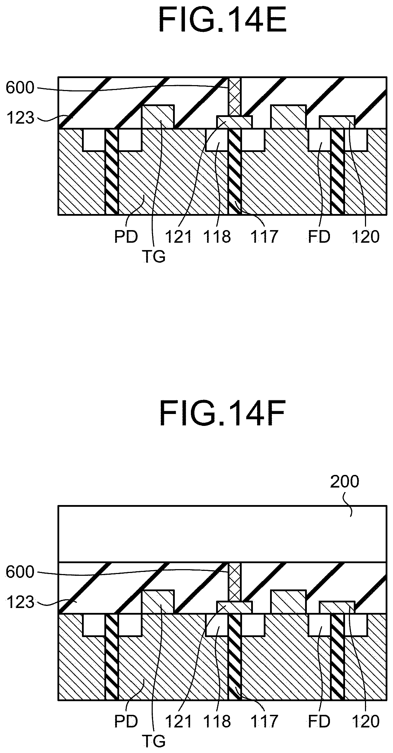

Next, as illustrated in FIG. 14E, a portion of the polysilicon 602 protruding from the through hole 600a is removed by CMP or the like, and the surface of the interlayer insulating film 123 is planarized. Furthermore, annealing is performed.

Next, as illustrated in FIG. 14F, the second semiconductor substrate 200 is stacked and attached on the surface of the interlayer insulating film 123, and the second semiconductor substrate 200 is thinned. Before bonding, p-type (first conductivity type) impurities are preferably implanted into the back surface side of the second semiconductor substrate 200 to be a bonding surface in order to ensure electrical connection with the via 600.

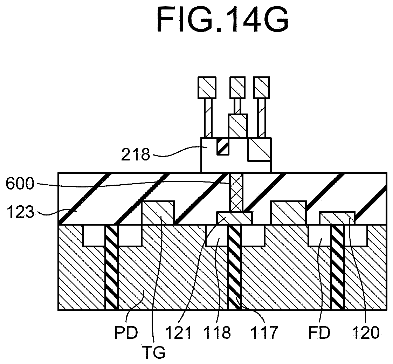

Then, as illustrated in FIG. 14G, transistors and wirings are formed on the second semiconductor substrate 200. As described above, the imaging device 1 according to the present embodiment is formed.

### <2.3 Modification>

### (Modification 1)

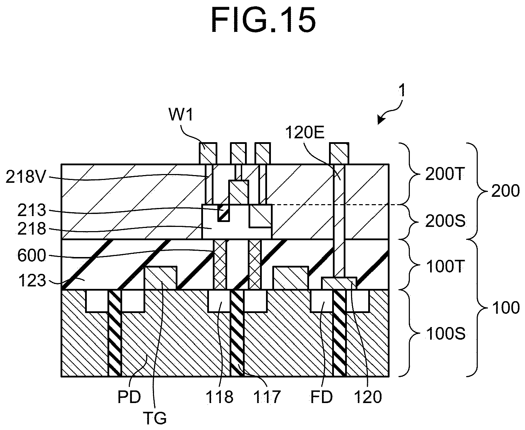

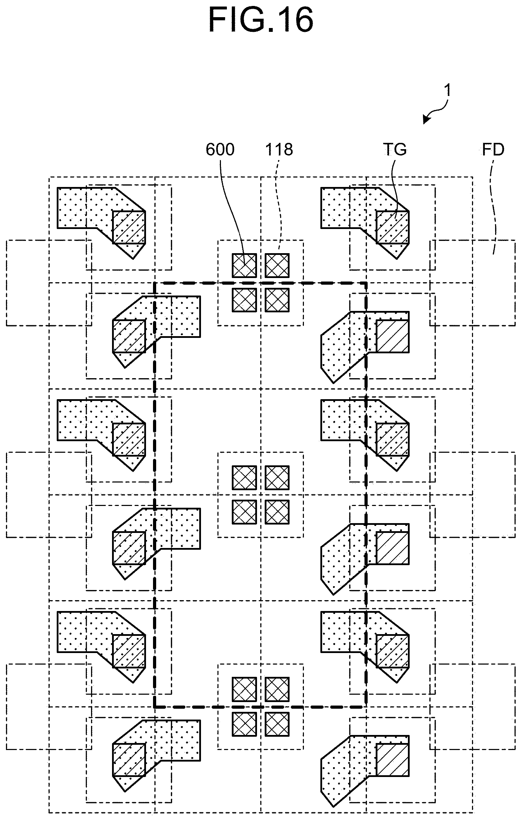

Next, Modification 1 of the present embodiment will be described with reference to FIGS. 15 and 16. FIG. 15 is a schematic diagram illustrating a cross-sectional configuration of an example of a main part of an imaging device 1 according to Modification 1 of the present embodiment. Furthermore, FIG. 16 is a schematic diagram illustrating a planar configuration of an example of the main part of the imaging device 1 according to Modification 1 of the present embodiment, and corresponds to the diagram of FIG. 11.

As illustrated in FIGS. 15 and 16, in the present modification, the imaging device 1 may include a plurality of vias 600. Specifically, in the present modification, as illustrated in FIGS. 15 and 16, each via 600 is electrically connected to the well region 118 provided in a section corresponding to each photodiode (photoelectric conversion element) PD on a one-to-one basis. Furthermore, in the present modified body, as illustrated in FIG. 15, the pad unit 121 may not be provided.

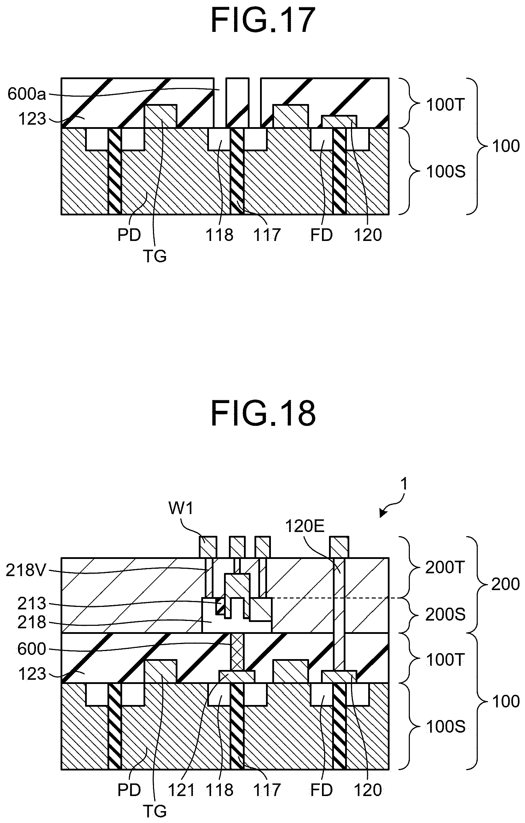

Next, a method of manufacturing the imaging device 1 according to the present modification will be described with reference to FIG. 17. FIG. 17 is a schematic diagram for explaining the manufacturing method of Modification 1 of the present embodiment, and specifically, is a cross-sectional view corresponding to the schematic diagram of the cross-sectional configuration of the imaging device 1 of FIG. 15 in one stage in the manufacturing process.

First, similarly to the manufacturing method of the first embodiment illustrated in FIG. 14A, the gate TG of the transfer transistor TR is formed on the surface of the first semiconductor substrate 100 on which the photodiode PD, the pixel isolation unit 117, the well region 118, the floating diffusion FD, and the like are formed. Then, similarly to the manufacturing method of the first embodiment illustrated in FIG. 14B, the interlayer insulating film 123 made of silicon oxide or the like is stacked on the surface of the first semiconductor substrate 100, and the surface (surface on the upper side in the drawing) is planarized by CMP or the like.

Then, as illustrated in FIG. 17, a plurality of through holes 600a penetrating the interlayer insulating film 123 from the surface of the interlayer insulating film 123 to the surface of the first semiconductor substrate 100 in which the well region 118 is located below is formed.

Subsequently, the polysilicon 602 is formed in the through hole 600a, but since the subsequent steps are similar to those in the manufacturing method of the first embodiment illustrated in FIGS. 14D to 14G, the descriptions thereof are omitted here.

### (Modification 2)

Next, Modification 2 of the present embodiment will be described with reference to FIG. 18. FIG. 18 is a schematic diagram illustrating a cross-sectional configuration of an example of a main part of an imaging device 1 according to Modification 2 of the present embodiment.

As illustrated in FIG. 18, the transistor provided on the semiconductor layer 200S of the second semiconductor substrate 200 is not limited to a transistor having a planar structure, and may be a transistor having a fin structure having a pair of vertical gates. In the present modification, since the degree of freedom of the layout of the second semiconductor substrate 200 on the semiconductor layer 200S is high, transistors having various structures can be formed.

### <<3. Second Embodiment>>

### <3.1 Background>

First, a background for creating the second embodiment of the present disclosure will be described. In the first embodiment of the present disclosure described above, when the via 600 is formed of polysilicon, as described above, impurities having p-type (first conductivity type) are implanted into the polysilicon 602 in the through hole 600a by ion implantation. However, if the interlayer insulating film 123 is thick, since the through hole 600a is deep, it is difficult to sufficiently implant impurities into the polysilicon 602 in the through hole 600a to a deep portion.

Therefore, the present inventors have conceived to form the via 600 by repeating the stacking of the interlayer insulating film 123, formation of the through hole 600a in the interlayer insulating film 123, embedding of the polysilicon 602 in the through hole 600a, and implantation of impurities into the embedded polysilicon 602 in order to sufficiently implant impurities deep into the polysilicon 602 in the through hole 600a. Since the depth of the through hole 600a is shallow in one implantation of the impurity by repeating in this manner, the impurity can be sufficiently implanted to the deep portion of the polysilicon 602 in the through hole 600a. By repeating such a process, impurities can be sufficiently implanted into the embedded polysilicon 602 in the entire through hole 600a. Hereinafter, details of such a second embodiment will be sequentially described.

### <3.2 Configuration>

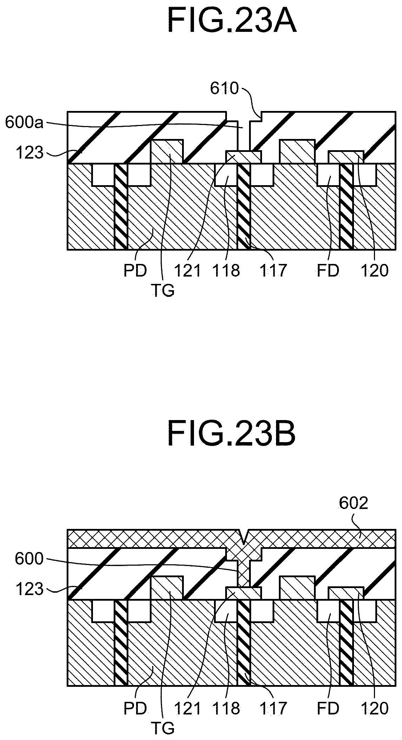

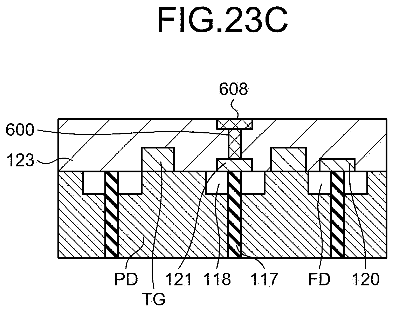

First, a detailed configuration of an imaging device 1 according to the second embodiment of the present disclosure will be described with reference to FIG. 23. FIG. 23 is a schematic diagram illustrating a cross-sectional configuration of an example of a main part of the imaging device 1 according to the present embodiment.

Specifically, as illustrated in FIG. 23, the via 600 according to the present embodiment includes a plurality of columns 604 penetrating a part of the interlayer insulating film 123 in the film thickness direction, and one or a plurality of connection pad units 606 provided in the interlayer insulating film 123 and electrically connecting the columns 604 to each other. In other words, in the example illustrated in FIG. 23, the connection pad unit 606 is sandwiched between the two columns 604 from the vertical direction in the drawing. Note that, in the present embodiment, the number of columns 604 of the via 600 is not limited to two, and may be two or more. Furthermore, the number of connection pad units 606 is not limited to one as long as it is a number necessary for electrically connecting the plurality of columns 604.

In the present embodiment, the cross-sectional shape of the column 604 and the connection pad unit 606 cut along the surface of the first semiconductor substrate 100 may be a substantially circular shape or a substantially rectangular shape, and is not particularly limited. Furthermore, the two columns 604 sandwiching the connection pad unit 606 can be provided at positions overlapping each other in a plane obtained by cutting the interlayer insulating film 123 in parallel with the front surface (first surface) of the first semiconductor substrate 100. In this way, since the back surface (second surface) of the second semiconductor substrate 200 and the well region 118 of the first semiconductor substrate 100 can be connected by shorter routing, the resistance value between the back surface (second surface) of the second semiconductor substrate 200 and the well region 118 of the first semiconductor substrate 100 can be reduced. In addition, it is preferable that the area of the connection pad unit 606 is wider than the cross section of the column 604. When the via 600 according to the present embodiment is formed, the through hole 600a is formed a plurality of times. However, even if the positions of the through holes 600a are misaligned, the columns 604 do not overlap, and the positions are misaligned, the misaligned columns 604 can be electrically connected by the wide connection pad units 606.

Also in the present embodiment, similarly to the first embodiment, the column 604 can be formed of polysilicon containing p-type (first conductivity type) impurities (for example, boron or the like). Furthermore, the connection pad unit 606 can also be formed of polysilicon containing p-type (first conductivity type) impurities or a metal material such as aluminum, titanium, tantalum, tungsten, ruthenium, or molybdenum (Mo).

### <3.3 Manufacturing Method>

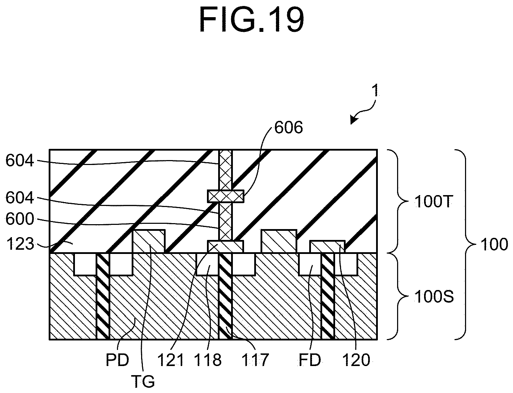

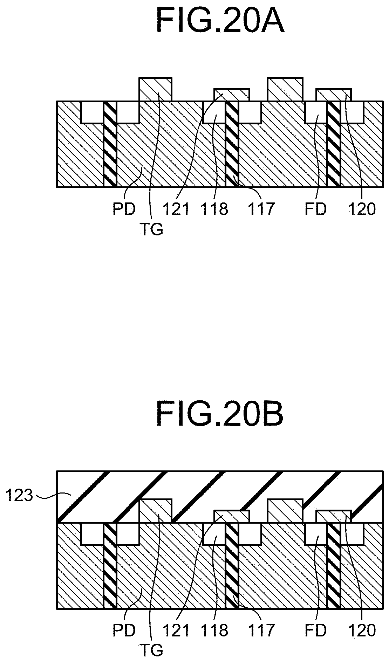

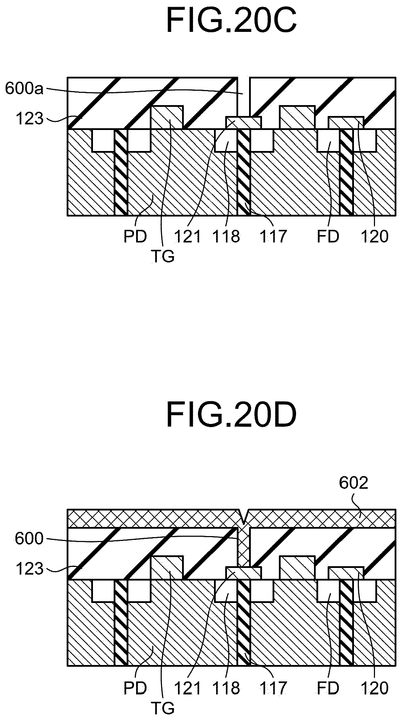

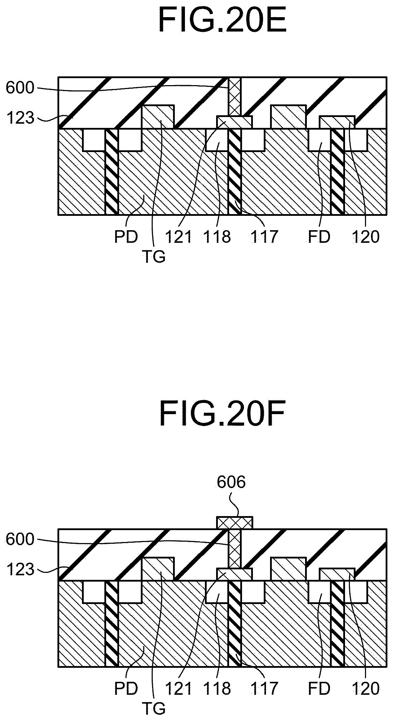

Next, a method of manufacturing the imaging device 1 according to the present embodiment will be described with reference to FIGS. 20A to 20H. FIGS. 20A to 20H are schematic diagrams for explaining the method of manufacturing the imaging device 1 according to the present embodiment, and in detail, each drawing is a cross-sectional view corresponding to a schematic diagram of a cross-sectional configuration of the imaging device 1 of FIG. 19 at each stage in a manufacturing process.

Note that FIGS. 20A to 20E are similar to FIGS. 14A to 14E illustrating the manufacturing method according to the first embodiment of the present disclosure, and thus the descriptions thereof are omitted here.

Next, as illustrated in FIG. 20F, the connection pad unit 606 is formed on the interlayer insulating film 123.

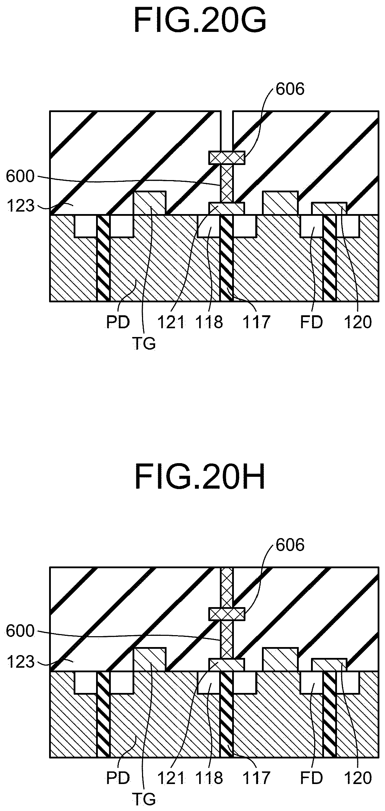

Then, the interlayer insulating film 123 is further stacked on the connection pad unit 606 and the interlayer insulating film 123, and the surface thereof is planarized by CMP or the like. Further, as illustrated in FIG. 20G, the through hole 600a penetrating the interlayer insulating film 123 from the surface of the interlayer insulating film 123 to the connection pad unit 606 is formed.

Next, as illustrated in FIG. 20H, the polysilicon 602 is formed so as to fill the through hole 600a. Furthermore, p-type (first conductivity type) impurities are implanted into the embedded polysilicon 602. Then, a portion of the polysilicon 02 protruding from the through hole 600a is removed by CMP or the like, and the surface of the interlayer insulating film 123 is planarized.

Subsequently, the second semiconductor substrate 200 is stacked and bonded on the surface of the interlayer insulating film 123, but the subsequent steps are similar to those in the manufacturing method of the first embodiment illustrated in FIGS. 14F to 14G, and thus the descriptions thereof are omitted here.

### <3.4 Modification>

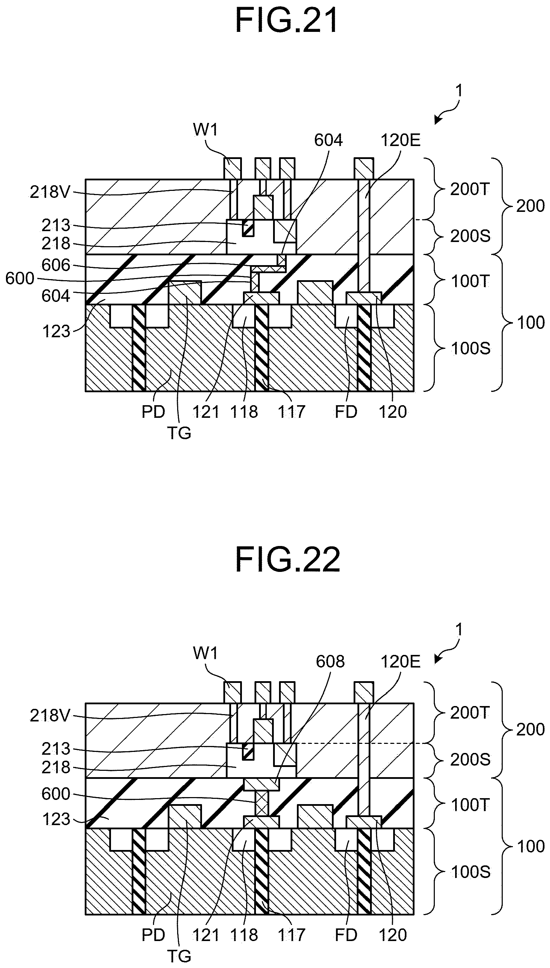

Next, a modification of the present embodiment will be described with reference to FIG. 21. FIG. 21 is a schematic diagram illustrating a cross-sectional configuration of an example of a main part of an imaging device 1 according to the modification of the present embodiment. Specifically, in the present modification, as illustrated in FIG. 21, the two columns 604 sandwiching the connection pad unit 606 may be provided at positions not overlapping each other in a plane obtained by cutting the interlayer insulating film 123 in parallel with the front surface (first surface) of the first semiconductor substrate 100.

### <<4. Third Embodiment>>

### <4.1 Configuration>

Next, a detailed configuration of an imaging device 1 according to a third embodiment of the present disclosure will be described with reference to FIG. 22. FIG. 22 is a schematic diagram illustrating a cross-sectional configuration of an example of a main part of the imaging device 1 according to the present embodiment.

As illustrated in FIG. 22, in the present embodiment, the via 600 is provided on the back surface (second surface) of the second semiconductor substrate 200 and includes a pad unit (second pad unit) 608 electrically connected to the via 600. In the present embodiment, since the contact area between the via 600 and the back surface of the second semiconductor substrate 200 is increased by providing the pad unit 608, the contact resistance between the via 600 and the back surface can be reduced. In the present embodiment, the shape of the pad unit 608 may be substantially circular or substantially rectangular, and is not particularly limited.

Furthermore, also in the present embodiment, similarly to the first embodiment, the pad unit 608 can be formed of polysilicon containing p-type (first conductivity type) impurities (for example, boron or the like). Furthermore, the pad unit 608 can also be formed of a metal material such as aluminum, titanium, tantalum, tungsten, ruthenium, or molybdenum (Mo).

### <4.2 Manufacturing Method>

Next, a method of manufacturing the imaging device 1 according to the present embodiment will be described with reference to FIGS. 23A to 23C. FIGS. 23A to 23C are schematic diagrams for explaining the method of manufacturing the imaging device 1 according to the present embodiment, and in detail, each drawing is a cross-sectional view corresponding to the schematic diagram of the cross-sectional configuration of the imaging device 1 of FIG. 22 at each stage in a manufacturing process.

First, in the present embodiment, the steps illustrated in FIGS. 14A to 14B illustrating the manufacturing method of the first embodiment of the present disclosure are performed.

Then, as illustrated in FIG. 23A, the through hole 600a penetrating the interlayer insulating film 123 from the surface of the interlayer insulating film 123 to the pad unit 121 is formed, and a groove 610 wider than the cross section of the through hole 600a is dug on the upper surface side thereof in order to form the pad unit 608.

Next, as illustrated in FIG. 23B, the polysilicon 602 is formed so as to fill the through hole 600a and the groove 610. Furthermore, p-type (first conductivity type) impurities are implanted into the embedded polysilicon 602.

Then, as illustrated in FIG. 23C, a portion of the polysilicon 602 protruding from the through hole 600a and the groove 610 is removed by CMP or the like, and the surface of the interlayer insulating film 123 is planarized.

Subsequently, the second semiconductor substrate 200 is stacked and bonded on the surface of the interlayer insulating film 123, but the subsequent steps are similar to those in the manufacturing method of the first embodiment illustrated in FIGS. 14F to 14G, and thus the descriptions thereof are omitted here.

### <<5. Fourth Embodiment>>

### <5.1 Background>

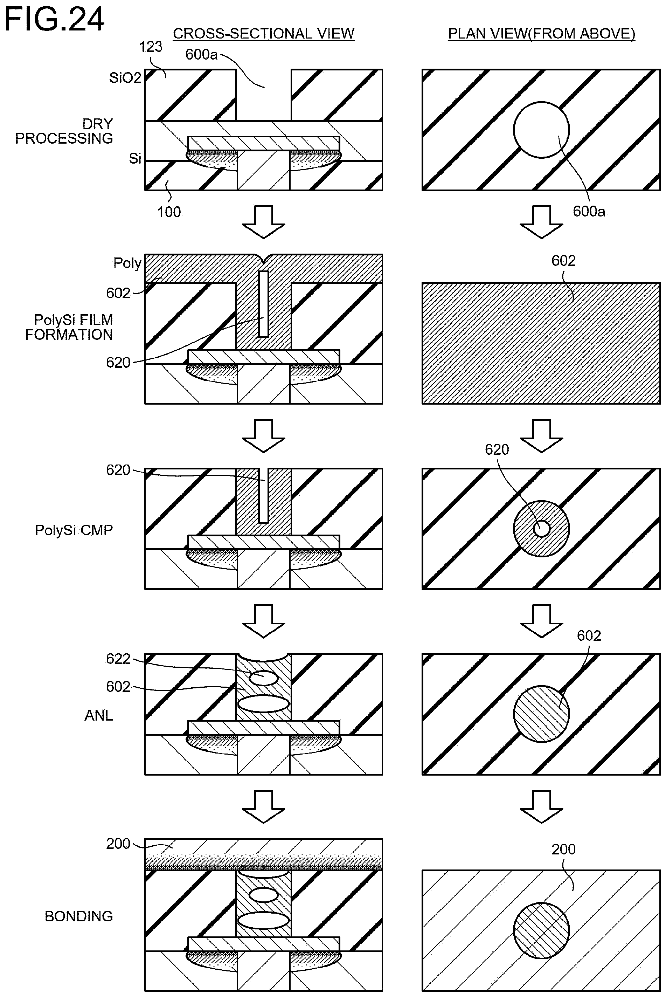

First, a background for creating a fourth embodiment of the present disclosure will be described with reference to FIGS. 24 to 26. FIGS. 24 to 26 are schematic diagrams for explaining a manufacturing process of the imaging device 1 according to the comparative example of the present embodiment. Here, here, the comparative example is the imaging device 1 that has been repeatedly studied by the present inventors before forming the fourth embodiment of the present disclosure, and means the first embodiment described above.

FIG. 24 illustrates a manufacturing process when the via 600 of the imaging device 1 according to the comparative example is formed. As described above, when the via 600 is formed, after the through hole 600a is formed, the polysilicon 602 is formed so as to fill the through hole 600a, a part of the polysilicon 602 protruding from the via 600 is removed by CMP, and then, annealing is performed.

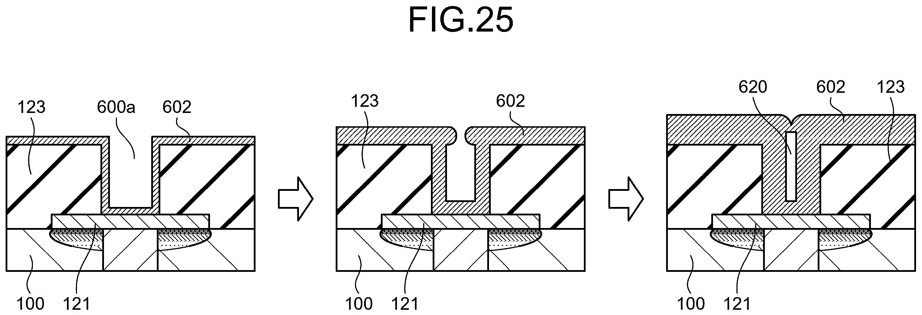

However, as illustrated in FIG. 25, when the polysilicon 602 is embedded in the through hole 600a, since the film formation of the polysilicon 602 isotropically proceeds from the bottom surface and the side surface of the through hole 600a, the polysilicon 602 may close the through hole 600a so as to cover the upper portion of the through hole 600a, and a cavity 620 may enter the inside of the polysilicon 602. Note that, here, a hollow generated in the central portion of the polysilicon 602 before annealing is expressed as "cavity", and a fine hollow (closed pore) generated in the entire polysilicon after annealing is expressed as "void".

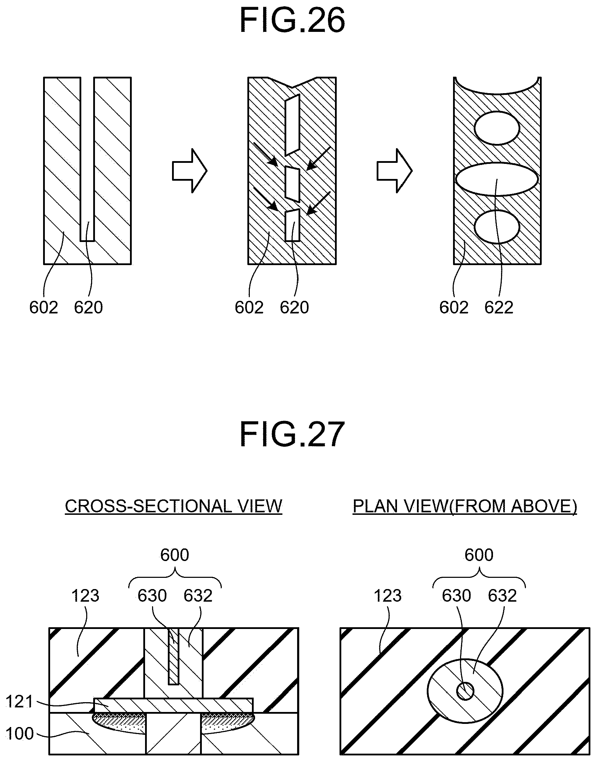

Furthermore, as illustrated in FIG. 26, the polysilicon 602 moves to the portion of the cavity 620 due to heat generated by annealing, and thus, a plurality of voids 622 may be generated inside the polysilicon 602. Then, due to the generation of such a void 622, the polysilicon 602 in the through hole 600a is disconnected, or disconnection between the well region 218 on the back surface side of the semiconductor layer 200S of the second semiconductor substrate 200 and the well region 118 of the semiconductor layer 100S of the first semiconductor substrate 100 occurs, so that conduction of the via 600 may not be ensured.

Therefore, the present inventors have created the fourth embodiment of the present disclosure described below in order to ensure via conduction with good yield even when mass production of the imaging device 1 is performed. Hereinafter, details of the present embodiment will be sequentially described.

### <5.2 Embodiment>

Next, a detailed configuration of an imaging device 1 according to the fourth embodiment of the present disclosure will be described with reference to FIG. 27. FIG. 27 is a schematic diagram illustrating a cross-sectional configuration of an example of a main part of the imaging device 1 according to the present embodiment.

As illustrated in FIG. 27, the via 600 according to the present embodiment includes a central portion 630 extending in a direction substantially perpendicular to the front surface (first surface) of the first semiconductor substrate 100, and an outer peripheral portion 632 provided so as to surround the central portion 630.

In the present embodiment, the cross-sectional shape of the central portion 630 cut along the surface of the first semiconductor substrate 100 may be substantially circular or substantially rectangular, and is not particularly limited. Furthermore, in the present embodiment, the cross-sectional shape of the central portion 630 cut in the direction perpendicular to the surface of the first semiconductor substrate 100 may be a substantially rectangular shape, a substantially tapered shape in which the width decreases from the second semiconductor substrate 200 toward the first semiconductor substrate 100, or a substantially tapered shape in which the width decreases from the first semiconductor substrate 100 toward the second semiconductor substrate 200, and is not particularly limited. The details thereof will be described later.

Further, in the present embodiment, the central portion 630 is preferably formed from an embedded film that has good embedding properties, specifically, is less likely to generate cavities due to heat shrinkage. More specifically, for example, the central portion 630 can be formed of silicon oxide, silicon nitride, nitrogen-doped silicon carbide, carbon-doped silicon oxide, aluminum oxide, hafnium oxide, or the like. Alternatively, the central portion 630 may be formed of a polyimide-based resin material, or may be formed of a metal material or a compound material containing any one metal selected from aluminum, titanium, tantalum, tungsten, ruthenium, and molybdenum.

Also in the present embodiment, the outer peripheral portion 632 can be formed of polysilicon containing p-type (first conductivity type) impurities (for example, boron or the like). Further, a bottom portion 632a provided on the outer peripheral portion 632 of the via 600 and the front surface (first surface) of the first semiconductor substrate 100 may be further provided.

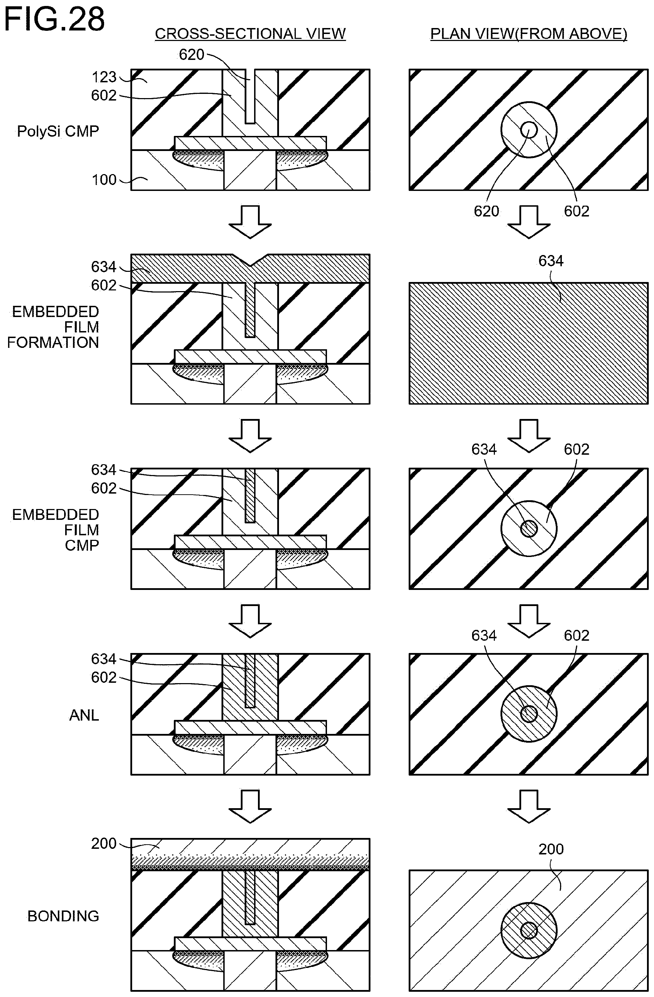

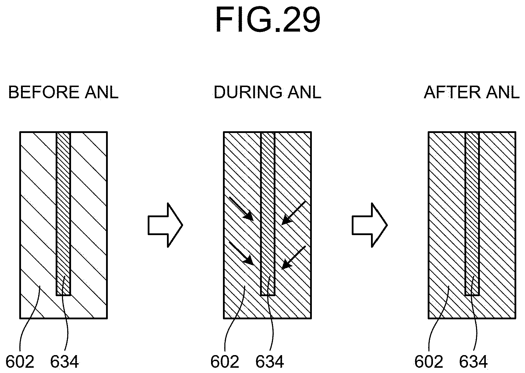

Next, a method of manufacturing the imaging device 1 according to the present embodiment will be described with reference to FIGS. 28 to 29. FIGS. 28 and 29 are schematic diagrams for explaining the method of manufacturing the imaging device 1 according to the present embodiment.

First, similarly to FIGS. 14A to 14E illustrating the method of manufacturing the imaging device 1 according to the first embodiment of the present disclosure, a portion of the polysilicon 602 protruding from the through hole 600a is removed by CMP or the like, and the surface of the interlayer insulating film 123 is planarized.

Then, at this stage, as described above, the cavity 620 may be generated in the polysilicon 602. Therefore, in the present embodiment, as illustrated in FIG. 28, an embedded film (for example, silicon oxide or the like) 634 is formed so as to embed the cavity 620 generated at the center of the polysilicon 602. Note that the shape of the cavity 620 to be embedded is not limited here. In addition, in order to improve the embedding property, the size of the cavity 620 may be expanded by etching (dry etching or wet etching) before embedding the cavity 620. Furthermore, as described above, the cavity 620 is preferably embedded in the embedded film 634 in which the cavity is hardly generated by thermal shrinkage. Therefore, in the present embodiment, as a method for forming the embedded film 634, it is preferable to use high density plasma (HDP)-chemical vapor deposition (CVD), Flowable CVD, or a coating method. Here, the Flowable CVD means a technique capable of forming a film having fluidity such as a liquid. In addition, in a case where the above-described metal material or compound material is used as the embedded film 634, sputtering or a CVD method can be used, but it is preferable to select a method capable of forming the embedded film 634 by bottom-up in which film formation proceeds from the bottom of the through hole 600a.

Then, a portion of the embedded film 634 protruding from the through hole 600a is removed by CMP or the like, and the surface of the interlayer insulating film 123 is planarized. Furthermore, annealing processing is performed.

In the present embodiment, by forming the via 600 having the above configuration by the above manufacturing process, as illustrated in FIG. 28, since the cavity 620 in the polysilicon 602 does not exist due to the embedding of the embedded film 634, the movement of the polysilicon 602 is restricted even if annealing is performed, and the generation of the void 622 can be reduced. As a result, in the present embodiment, it is possible to avoid a case where conduction of the via 600 is not ensured due to disconnection of the polysilicon 602 in the through hole 600a or disconnection between the well region 218 on the back surface side of the semiconductor layer 200S of the second semiconductor substrate 200 and the well region 118 of the semiconductor layer 100S of the first semiconductor substrate 100.

In the present embodiment, very fine voids 622 that cannot cause disconnection or contact failure may be present in the via 600.

### <5.3 Modification>

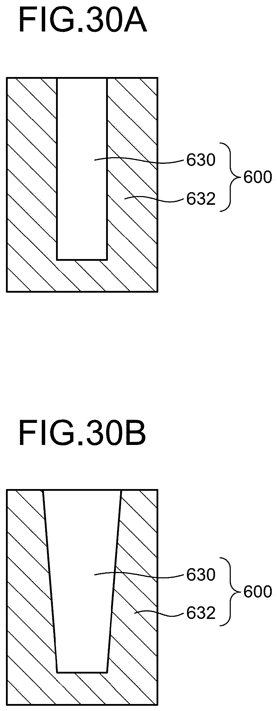

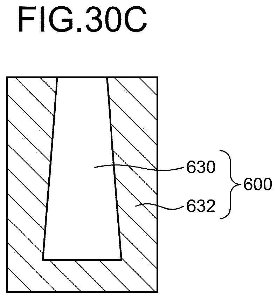

Next, a modification of the present embodiment will be described with reference to FIGS. 30A to 30C. FIGS. 30A to 30C are schematic diagrams illustrating a cross-sectional configuration of an example of a main part of an imaging device 1 according to Modification 1 of the present embodiment. Specifically, FIGS. 30A to 30C illustrate the via 600 according to a modification of the present embodiment, a lower side in the drawing is the first semiconductor substrate 100 side, and an upper side in the drawing is the second semiconductor substrate 200 side.

As illustrated in FIGS. 30A to 30C, the cross-sectional shape of the central portion 630 cut in the direction perpendicular to the surface of the first semiconductor substrate 100 may be a substantially rectangular shape, a substantially tapered shape in which the width decreases from the second semiconductor substrate 200 toward the first semiconductor substrate 100, or a substantially tapered shape in which the width decreases from the first semiconductor substrate 100 toward the second semiconductor substrate 200, and is not particularly limited.

Note that, if the cross section of the central portion 630 has a substantially tapered shape in which the width decreases from the first semiconductor substrate 100 toward the second semiconductor substrate 200, the bonding surface between the via 600 and the well region 118 of the first semiconductor substrate 100 increases, so that if the central portion 630 is formed of a metal material or the like, the contact resistance can be reduced.

Furthermore, if the cross section of the central portion 630 has a substantially tapered shape in which the width decreases from the second semiconductor substrate 200 toward the first semiconductor substrate 100, this means that the embedded film 634 is easily embedded in the cavity 620. In other words, if the shape of the cavity 620 is a substantially tapered shape in which the width decreases from the second semiconductor substrate 200 toward the first semiconductor substrate 100, the embedding properties of the embedded film 634 with respect to the cavity 620 are improved.

### <<6. Fifth Embodiment>>

### <6.1 Background>

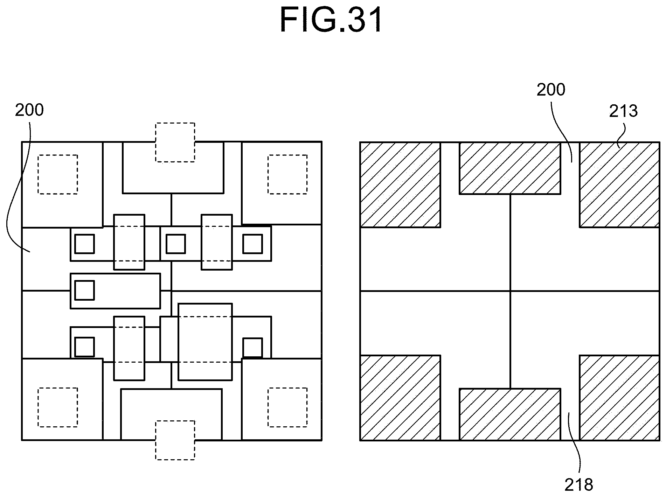

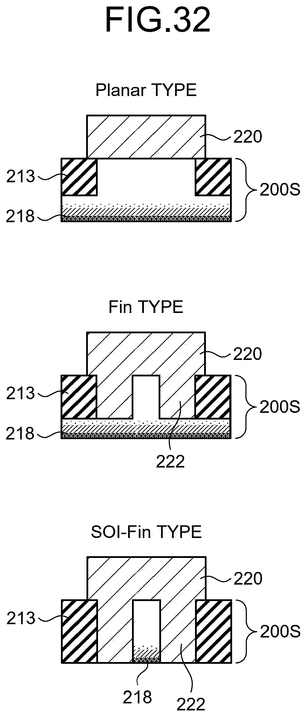

First, a background of the present embodiment will be described with reference to FIGS. 31 and 32. FIGS. 31 and 32 are schematic diagrams for explaining a background of a fifth embodiment of the present disclosure. In the first embodiment described above, the first semiconductor substrate 100 and the second semiconductor substrate 200 are directly bonded. Specifically, for example, as illustrated on the right side of FIG. 31, on the back surface (second surface) of the second semiconductor substrate 200, the well region 218 containing impurities (p-type (first conductivity type) impurities (for example, boron (B) or the like)) widely exists so as to electrically and reliably bond the well region 218 on the back surface (second surface) side of the semiconductor layer 200S of the second semiconductor substrate 200 and the via 600 even if misalignment occurs at the time of bonding.

In addition, a plurality of transistors is formed on the second semiconductor substrate 200 as illustrated on the left side of FIG. 31. In the embodiment of the present disclosure, it is conceivable to use various types of transistors as the transistors provided on the second semiconductor substrate 200. For example, as illustrated in FIG. 32, a planar transistor in which the flat gate electrode 220 is provided on the second semiconductor substrate 200 (specifically, the semiconductor layer 200S) via an insulating film (not illustrated), a Fin-type transistor having a fin 222 in which the gate electrode 220 is embedded in the second semiconductor substrate, and the like are exemplified. Further, examples of the transistor used in the present embodiment include a fully depleted (FD-SOI: Fully Depletion-Silicon on Insulator) transistor having fins 222 in which the gate electrode 220 extends deep into the second semiconductor substrate 200 as illustrated in FIG. 32.

By the way, if it is attempted to form a fully depleted transistor having fins 222 illustrated in FIG. 32 on the second semiconductor substrate 200 having a back surface form as illustrated on the right side of FIG. 31, impurities exist in a location to be a channel between the fins 222, and there is a possibility that the transistor does not perform a desired operation. In addition, even in the case of the Fin-type transistor, when the fin 222 does not extend deep into the second semiconductor substrate 200, a problem hardly occurs, but when the fin extends deep, there is a possibility that the transistor does not perform a desired operation, similarly to the case of the fully depleted transistor.

Therefore, in the fifth embodiment of the present disclosure, a non-doped region not containing impurities is provided at a location corresponding to the transistor as described above on the back surface (second surface) of the second semiconductor substrate 200. In this way, a transistor of a desired type can be formed at a desired location. Hereinafter, details of the present embodiment will be described.

### <6.2 Embodiment>

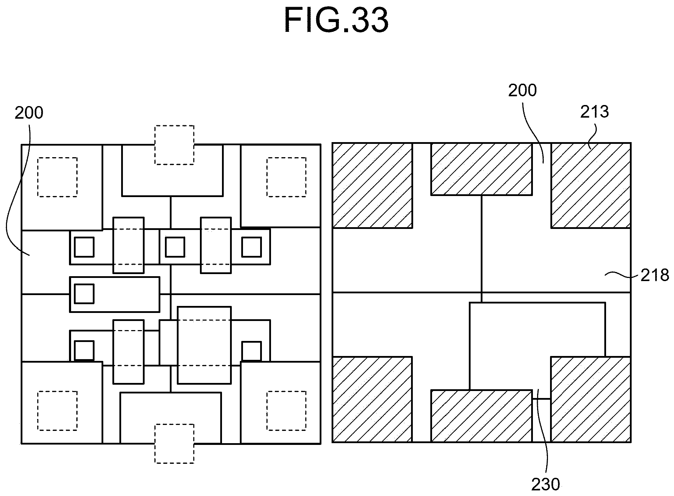

The fifth embodiment of the present disclosure will be described with reference to FIG. 33. FIG. 33 is a schematic diagram illustrating a planar configuration of an example of a main part of an imaging device 1 according to the present embodiment, and illustrates an upper surface side and a back surface side of the second semiconductor substrate 200. Specifically, in a case where the amplification transistor AMP is a fully depleted transistor having fins 222, or the like, as illustrated on the right side of FIG. 33, a non-doped region 230 not doped with impurities is provided on the back surface (second surface) of the second semiconductor substrate 200 corresponding to the amplification transistor AMP. In this way, even in a case where the amplification transistor AMP is a fully depleted transistor having fins 222, or the like, since there is no impurity in a location to be a channel between the fins 222, the transistor can function as a fully depleted transistor.

Note that, in the present embodiment, the transistor provided on the opposite side of the non-doped region 230 is not limited to the fully depleted transistor having fins 222, and may be a planar type fully depleted transistor or a Fin-type transistor. That is, in the present embodiment, the transistor provided on the opposite side of the non-doped region 230 is not particularly limited as long as the transistor can be provided such that the channel region corresponds to the non-doped region 230 not containing impurities. In addition, around these transistors, an element isolation region (interlayer insulating film) 123 having an FTI structure that penetrates the semiconductor layer 200S of the second semiconductor substrate 200 and an element isolation region 123 having a DTI structure that does not penetrate the semiconductor layer 200S are preferably provided. In the case of the element isolation region 123 having the DTI structure, impurities may be present on the back surface side of the second semiconductor substrate 200 in the element isolation region 123.

### <6.3 Manufacturing Method>

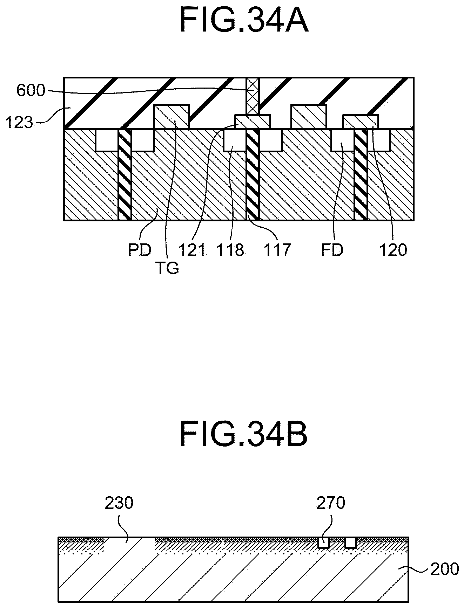

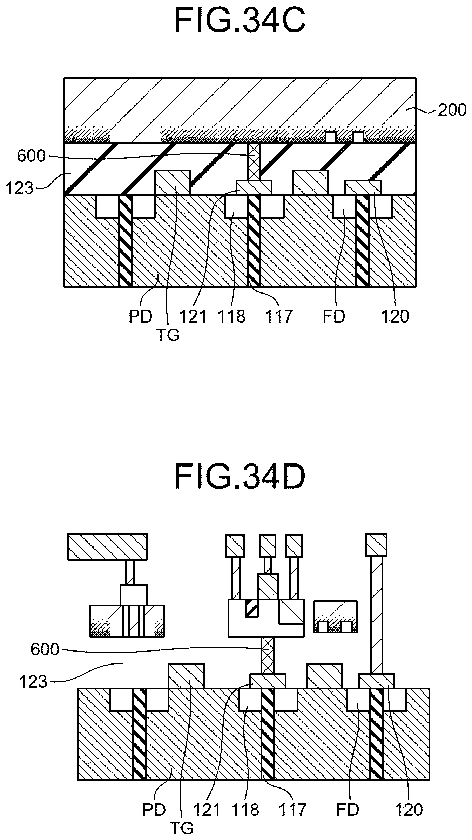

Next, a method of manufacturing the imaging device 1 of the present embodiment will be described with reference to FIGS. 34A to 34D. FIGS. 34A and 34D are explanatory diagrams for explaining the method of manufacturing the imaging device 1 according to the present embodiment.

First, as described with reference to FIGS. 14A to 14E, the first semiconductor substrate 100 is formed to obtain a form as illustrated in FIG. 34A. Next, in the present embodiment, an alignment mark 270 for bonding the first semiconductor substrate 100 and the second semiconductor substrate 200 is formed on the back surface of the second semiconductor substrate 200. Normally, such an alignment mark 270 is generally arranged outside the pixel array unit 540. For example, the alignment mark 270 can be formed by embedding an insulating film in the back surface of the second semiconductor substrate 200 and planarizing the insulating film.

Then, a mask covering a location to be the non-doped region 230 is formed with reference to the formed alignment mark 270, and ion implantation is performed. At this time, it is preferable to form a region not containing impurities widely by making the mask wider than the size required by the non-doped region 230 in consideration of misalignment. Specifically, for example, in the case of the non-doped region 230 of the region corresponding to the amplification transistor AMP, it is preferable to form the non-doped region 230 larger than the amplification transistor AMP.

Then, as illustrated in FIG. 34C, the first semiconductor substrate 100 and the second semiconductor substrate 200 are bonded using the alignment mark 270. At this time, a deviation may occur due to a problem of bonding accuracy, but correction can be performed by forming the element isolation region 123 having the FTI structure at the deviated location.

Thereafter, a fully depleted transistor having fins 222 is formed as the amplification transistor AMP on the second semiconductor substrate 200. The semiconductor layer 200S is removed from the periphery of the fin 222, and the periphery is divided by the element isolation region 123 having the FTI structure. In addition, impurities are introduced into a part of the semiconductor layer 200S of the second semiconductor substrate 200 by ion implantation, and become source/drain regions of the transistor.

Note that a DTI type element isolation region 123 may be formed around the amplification transistor AMP. In this case, no impurity exists under the element isolation region 123, and it is assumed that a bad influence is caused by the interface state. In order to prevent such an influence, shallow impurities may be implanted into the back surface of the second semiconductor substrate 200 under the element isolation region 123 after the element isolation region 123 is formed.

### <6.4 Modification>

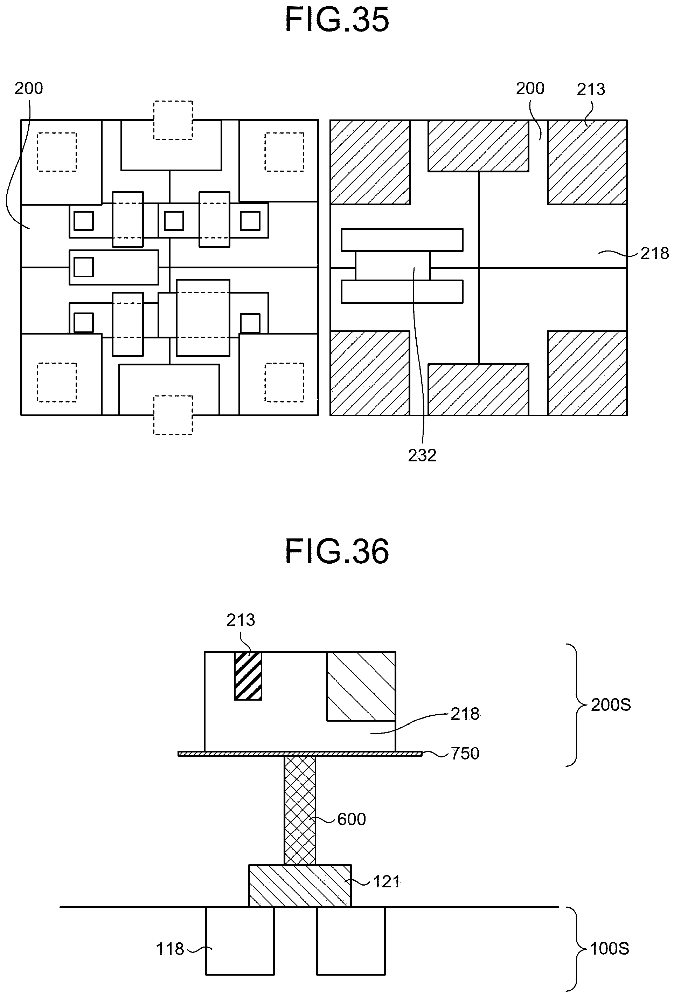

In addition, in the present embodiment described above, the non-doped region 230 is formed on the back surface of the second semiconductor substrate 200, but in the modification of the present embodiment, a high-concentration region (first region) 232 containing impurities at a concentration higher than that of the well region (second region) 218 may be formed on the back surface of the second semiconductor substrate 200. Hereinafter, the present modification will be described in detail with reference to FIG. 35. FIG. 35 is a schematic diagram illustrating a planar configuration of an example of a main part of an imaging device 1 according to the modification of the present embodiment.

As illustrated in FIG. 35, on the back surface of the second semiconductor substrate 200, the high-concentration region (first region) 232 containing impurities at a higher concentration than that of the well region (second region) 218 may be formed so as to correspond to the location where the via 600 electrically connecting the well region 118 of the first semiconductor substrate 100 and the well region 218 of the second semiconductor substrate 200 is formed (for example, the via 600 is provided on the high-concentration region 232). In the present modification, by forming the high-concentration region 232, the contact resistance regarding the connection between the well region 118 of the first semiconductor substrate 100 and the well region 218 of the second semiconductor substrate 200 can be reduced. Furthermore, as illustrated in FIG. 35, it is preferable to provide an FTI type element isolation region 123 and the like around the high-concentration region 232 so as not to electrically connect the via 600 to an unnecessary portion.

### <<7. Sixth Embodiment>>

### <7.1 Background>

In the embodiment of the present disclosure, the contact resistance between the via 600 and the well region 218 on the back surface (second surface) side of the semiconductor layer 200S of the second semiconductor substrate 200 is preferably low. However, a natural oxide film is formed on the back surface of the second semiconductor substrate 200 by being exposed to the atmosphere before bonding. Since the via 600 and the back surface (second surface) of the second semiconductor substrate 200 are bonded via the natural oxide film, the contact resistance between the via 600 and the back surface of the second semiconductor substrate 200 increases. Furthermore, when the contact resistance increases, the well region 118 of the first semiconductor substrate 100 and the well region 218 of the second semiconductor substrate 200 do not have the same potential, the PD and the transistor do not perform desired operations, and pixel variation occurs in light conversion efficiency, charge transmission speed, and the like. Therefore, in order to reduce the contact resistance, it is conceivable to perform processing of removing the natural oxide film on the back surface of the second semiconductor substrate 200 and bond the second semiconductor substrate 200 to the first semiconductor substrate 100. However, when such processing is performed, the contact resistance between the via 600 and the back surface of the second semiconductor substrate 200 can be reduced, but the bonding strength between the back surface of the second semiconductor substrate 200 and the upper surface of the interlayer insulating film 123 is deteriorated.

Therefore, in the sixth embodiment of the present disclosure, a bonding film made of an insulating film containing impurities at a high concentration is provided between the first semiconductor substrate 100 and the second semiconductor substrate 200. In the present embodiment, the impurities in the bonding film are locally diffused to the upper surface of the via 600 and the back surface (second surface) of the second semiconductor substrate 200 by the heat treatment at the time of forming the transistor of the second semiconductor substrate 200. Therefore, according to the present embodiment, the contact resistance between the via 600 and the back surface of the second semiconductor substrate 200 can be reduced without deteriorating the bonding strength between the back surface of the second semiconductor substrate 200 and the upper surface of the interlayer insulating film 123. Hereinafter, details of the present embodiment will be described.

### <7.2 Embodiment>

First, a detailed configuration of the imaging device 1 according to the present embodiment will be described with reference to FIG. 36. FIG. 36 is a schematic diagram illustrating a cross-sectional configuration of an example of a main part of the imaging device 1 according to the present embodiment.

In the present embodiment, as illustrated in FIG. 36, a bonding film 750 is provided between the first semiconductor substrate 100 and the second semiconductor substrate 200. The bonding film 750 can be formed of an insulating film containing impurities (p-type (first conductivity type) impurity (for example, boron (B) or the like)) and made of silicon oxide (SiO₂) or the like. Specifically, the bonding film 750 can be formed of, for example, boro-silicate-glass (BSG) made of silicon oxide (SiO₂) and boron oxide (BxO_{y}), phosphosilicate-glass (PSG) made of silicon oxide (SiO₂) and phosphorus oxide (PₓO_{y}), or the like. In the present embodiment, by providing such a bonding film 750, impurities are thermally diffused from the bonding film 750 to the via 600 or the back surface of the second semiconductor substrate 200 by heat treatment after bonding the first semiconductor substrate 100 and the second semiconductor substrate 200. Therefore, in the present embodiment, the impurities in the semiconductor layer 200S of the second semiconductor substrate 200 are distributed so as to be lower along the stacking direction from the back surface (second surface), while the impurities in the via 600 are distributed so as to be higher along the stacking direction from the front surface (first surface) of the semiconductor layer 100S of the first semiconductor substrate 100.

As described above, in the present embodiment, the bonding film 750 is provided between the first semiconductor substrate 100 and the second semiconductor substrate 200, and impurities are thermally diffused from the bonding film 750 by heat treatment after bonding the first semiconductor substrate 100 and the second semiconductor substrate 200. Therefore, in the present embodiment, the contact resistance between the via 600 and the back surface of the second semiconductor substrate 200 can be reduced due to diffusion of impurities by the bonding film 750 without deteriorating the bonding strength between the first semiconductor substrate 100 and the second semiconductor substrate 200.

### <7.3 Manufacturing Method>

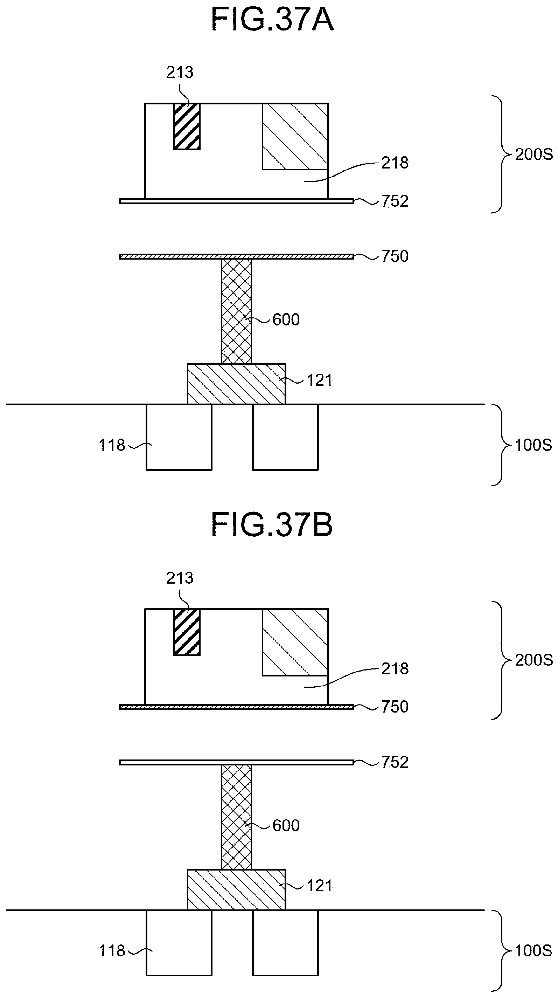

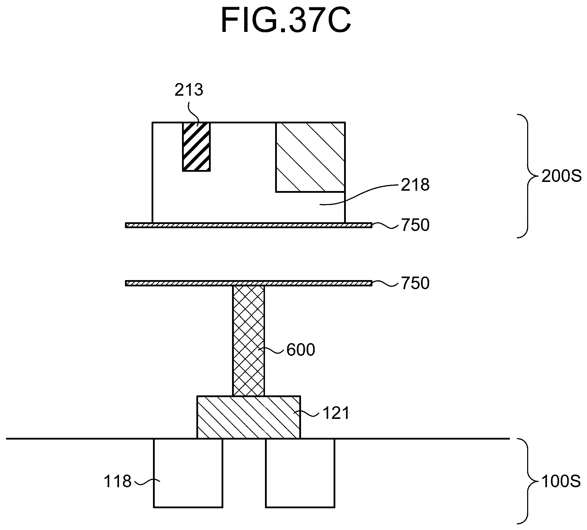

Next, a method of manufacturing the imaging device 1 of the present embodiment will be described with reference to FIGS. 37A to 37C. FIGS. 37A to 37C are explanatory diagrams for explaining the method of manufacturing the imaging device 1 according to the present embodiment.

In the present embodiment, as illustrated in FIG. 37A, before the first semiconductor substrate 100 and the second semiconductor substrate 200 are bonded, the bonding film 750 containing impurities may be provided on the interlayer insulating film 123 of the first semiconductor substrate 100, and a bonding film 752 not containing impurities may be provided on the back surface of the second semiconductor substrate 200 (specifically, the semiconductor layer 200S). Then, at the time of bonding, the first semiconductor substrate 100 and the second semiconductor substrate 200 are bonded by the bonding films 750 and 752. Furthermore, as illustrated in FIG. 37B, before the first semiconductor substrate 100 and the second semiconductor substrate 200 are bonded, the bonding film 750 containing impurities may be provided on the back surface of the second semiconductor substrate 200 (specifically, the semiconductor layer 200S), and the bonding film 752 not containing impurities may be provided on the interlayer insulating film 123 of the first semiconductor substrate 100. Furthermore, in the present embodiment, the bonding film 750 containing impurities may be provided on the back surface of the second semiconductor substrate 200 (specifically, the semiconductor layer 200S) and on the interlayer insulating film 123 of the first semiconductor substrate 100.

Further, in the present embodiment, the bonding film 750 can be formed by an atomic layer deposition (ALD), but may be formed by other methods. The impurity is not limited to phosphorus (P) and boron (B), and other elements in Group 3 or Group 5 can be used. Furthermore, in the present embodiment, the impurity implantation does not need to be performed simultaneously with the formation of the bonding film 750, and may be performed after the formation of the bonding film 750. In such a case, a method of driving atoms of impurities as plasma or ions (for example, an ion implantation method) can be used.

### <<8. Seventh Embodiment>>

### <8.1 Background>

As described in the above embodiment, it is effective to introduce and diffuse impurities in order to improve the electrical connectivity, that is, to reduce the contact resistance. However, when impurities are thermally diffused in single crystal silicon such as a semiconductor layer, the impurities are diffused to unnecessary portions depending on the processing content of the thermal process, and as a result, characteristics of the transistor may be adversely affected.

Therefore, in the seventh embodiment of the present disclosure, by thermally diffusing the impurities from the polysilicon containing the impurities, diffusion of the impurities is stopped at the polysilicon/silicon interface, and diffusion of the impurities to unnecessary portions is prevented. Hereinafter, details of the present embodiment will be described.

### <8.2 Embodiment>

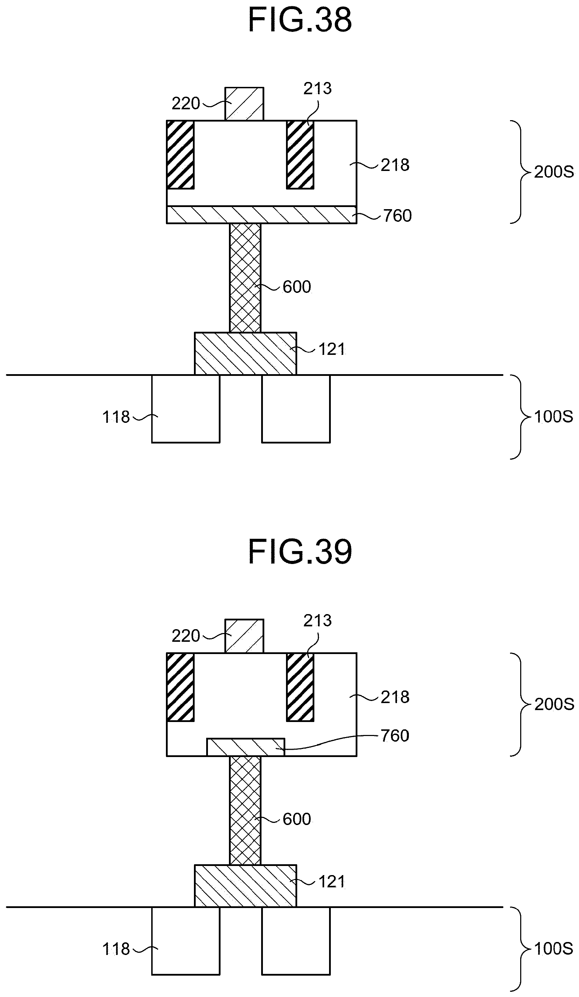

Next, a detailed configuration of an imaging device 1 according to the seventh embodiment of the present disclosure will be described with reference to FIGS. 38 and 39. FIGS. 38 and 39 are schematic diagrams illustrating a cross-sectional configuration of an example of a main part of the imaging device 1 according to the present embodiment.

In the present embodiment, as illustrated in FIG. 38, a bonding film 760 is provided between the first semiconductor substrate 100 and the second semiconductor substrate 200. The bonding film 760 is made of polysilicon containing impurities (p-type (first conductivity type) impurity (for example, boron (B) or the like)). Furthermore, in the present embodiment, as illustrated in FIG. 39, the bonding film 760 may be provided so as to be embedded in a part of the semiconductor layer 200S of the second semiconductor substrate 200. In the present embodiment, the shape of the embedded bonding film 760 in a plan view may be a circular shape, a rectangular shape, or a frame shape, and is not particularly limited.

In the present embodiment, since the bonding film 760 is made of polysilicon and the semiconductor layer 200S is made of single crystal silicon, an interface exists between the bonding film 760 and the semiconductor layer 200S. Therefore, due to the heat treatment at the time of forming the transistor of the second semiconductor substrate 200, the impurity contained in the bonding film 760 is hindered by the interface, and diffusion into the semiconductor layer 200S hardly occurs. As a result, in the present embodiment, since the impurities from the bonding film 760 are not widely diffused into the semiconductor layer 200S, it is possible to avoid an adverse effect on the transistor provided in the semiconductor layer 200S. On the other hand, since the via 600 is formed of polysilicon, the impurities contained in the bonding film 760 can be diffused to the via 600, and the contact resistance between the via 600 and the bonding film 760 can be reduced.

### <8.3 Manufacturing Method>

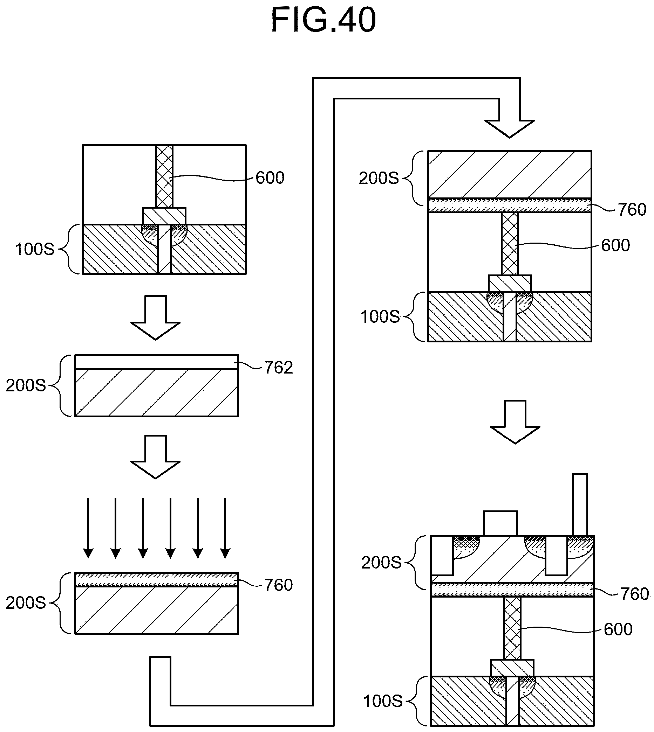

Next, a method of manufacturing the imaging device 1 of the present embodiment will be described with reference to FIG. 40. FIG. 40 is an explanatory diagram for explaining the method of manufacturing the imaging device 1 according to the present embodiment.

First, as described with reference to FIGS. 14A to 14E, the first semiconductor substrate 100 is formed, and the first semiconductor substrate 100 as illustrated at the top on the left side of FIG. 40 is obtained. Next, as illustrated second from the top on the left side of FIG. 40, a polysilicon film 762 having a film thickness of 100 nm to several nm is formed on the back surface side of the second semiconductor substrate 200. Next, as illustrated at the bottom on the left side of FIG. 40, impurities are ion-implanted into the polysilicon film 762, and the surface is planarized by CMP to obtain the bonding film 760.

Then, as illustrated at the top on the right side of FIG. 40, the second semiconductor substrate 200 and the first semiconductor substrate 100 are bonded. Furthermore, as illustrated at the bottom on the right side of FIG. 40, a transistor and the like are formed on the second semiconductor substrate 200.

Furthermore, in the present embodiment, it is not limited to forming the bonding film 760 using ion implantation, and for example, the bonding film 760 may be formed by introducing impurities simultaneously with the formation of the polysilicon film.

### <<9. Eighth Embodiment>>

### <9.1 Background>

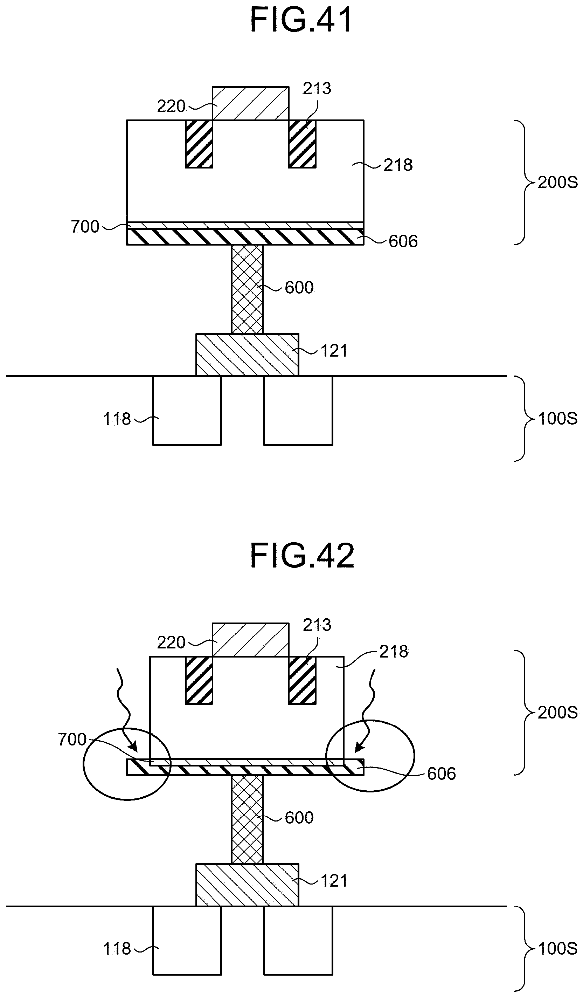

First, a background and an outline of an eighth embodiment of the present disclosure will be described with reference to FIGS. 41 and 42. FIG. 41 is a schematic diagram for explaining the background of the present embodiment, and FIG. 42 is a schematic diagram illustrating a cross-sectional configuration of an example of a main part of an imaging device 1 according to the present embodiment.

In the third embodiment of the present disclosure described above, by providing the pad unit 608 between the via 600 and the back surface of the second semiconductor substrate 200, the contact area is increased, and the contact resistance between the via 600 and the back surface of the second semiconductor substrate 200 is reduced. As illustrated in FIG. 41, an oxide film 700 is formed on the back surface of the second semiconductor substrate 200 by being exposed to the atmosphere before bonding the first semiconductor substrate 100 and the second semiconductor substrate 200, or by being subjected to heat treatment for bonding. Therefore, due to the presence of such an oxide film, the contact resistance between the pad unit 608 and the back surface of the second semiconductor substrate 200 (that is, the contact resistance between the via 600 and the back surface of the second semiconductor substrate 200) increases, and as a result, characteristic deterioration of the imaging device 1 such as variation and an increase in noise is caused.

Therefore, in the eighth embodiment of the present disclosure, as illustrated in FIG. 42, the contact resistance between the via 600 and the back surface of the second semiconductor substrate 200 is reduced by locally reducing the end portion of the oxide film 700 (in FIG. 42, an arrow indicates the reduction treatment). Hereinafter, details of the present embodiment will be described.

### <9.2 Embodiment>

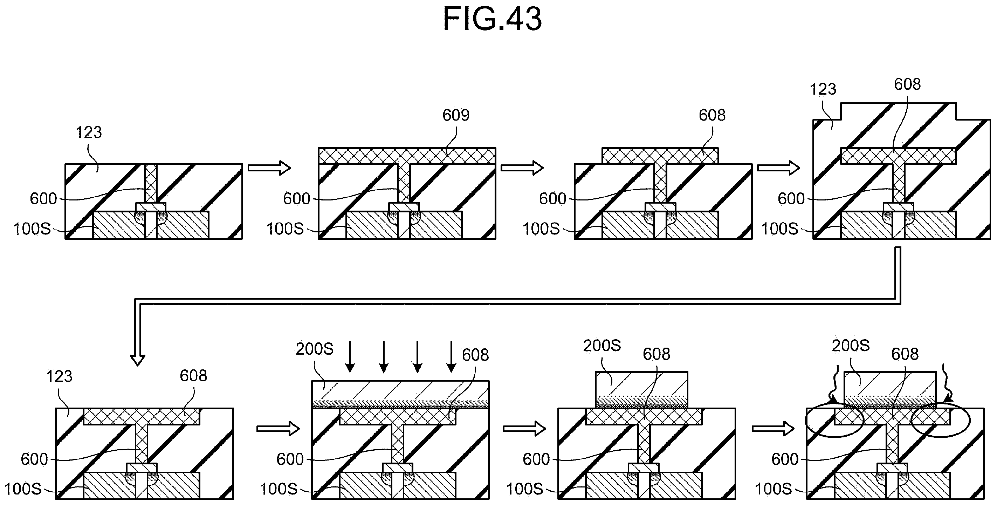

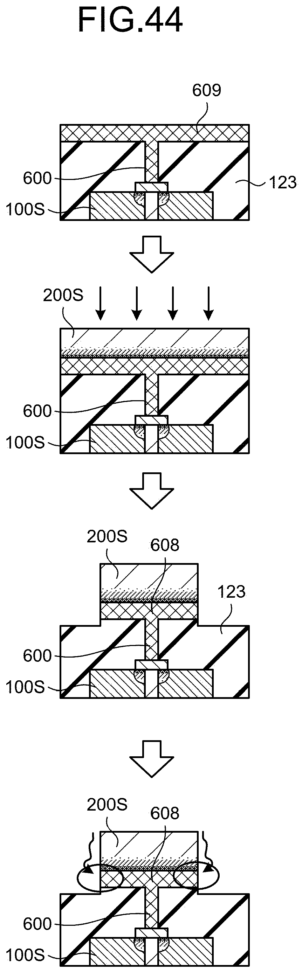

Next, a method of manufacturing the imaging device 1 of the present embodiment will be described with reference to FIGS. 43 and 44. FIGS. 43 and 44 are schematic diagrams for explaining the method of manufacturing the imaging device 1 according to the present embodiment.

First, as illustrated in the upper left side of FIG. 43, the via 600 is formed on the first semiconductor substrate 100 side. Since the method for forming the via 600 has been described above, the details thereof will be omitted. Next, as illustrated second from the upper left side of FIG. 43, a film 609 made of polysilicon is formed on the interlayer insulating film 123 and the via 600. Impurities may be introduced into the film 609 by ion implantation, and at this time, annealing may be performed for thermal diffusion of impurities or the like. Then, as illustrated third from the upper left side of FIG. 43, a pattern is formed on the film 609 using lithography, dry etching, or the like, thereby forming the pad unit 608 on the via 600. Furthermore, as illustrated in the upper right side of FIG. 43, the interlayer insulating film 123 made of a silicon oxide film (SiO₂) is formed on the pad unit 608 by using CVD or the like. Next, the interlayer insulating film is planarized by CMP to obtain a form as illustrated on the lower left side of FIG. 43.

Next, as illustrated second from the lower left side of FIG. 43, the first semiconductor substrate 100 on which the via 600, the pad unit 608, and the like are formed and the second semiconductor substrate 200 (the semiconductor layer 200S is illustrated in FIG. 43) are bonded. Impurities can be introduced into the back surface of the second semiconductor substrate 200 by ion implantation before or after bonding. Furthermore, as described above, an oxide film of several nm is generated on the bonding surface between the first semiconductor substrate 100 and the second semiconductor substrate 200 at the time of bonding. Next, after bonding, the film thickness of the second semiconductor substrate 200 is reduced to several hundred nm. Specifically, the film thickness of the second semiconductor substrate 200 is preferably about 200 to 600 nm. The film can be thinned to a desired film thickness by, for example, polishing to a thickness of about several µm with a grinder, and then using wet etching or surface polishing by a CMP method.

Next, as illustrated third from the lower left side of FIG. 43, elements are isolated by forming a trench in the semiconductor layer 200S of the second semiconductor substrate 200 using lithography, dry etching, or the like. At this time, it is preferable to form the trench so that the end portion of the pad unit 608 is exposed from the trench. In the present embodiment, at least the side surface of the pad unit 608 is exposed. At the time of dry etching, the degree of exposure of the pad unit 608 can be controlled by detecting an end point using a waveform of optical emission spectroscopy (OES).

In the present embodiment, the width of the trench is preferably 100 to 300 nm. Furthermore, in the present embodiment, it is preferable to set the aspect ratio, which is the ratio between the depth and the width of the trench, to about 5 or less in order to make the gas and the like easily flow around in the reduction treatment of the end portion of the pad unit 608.

Next, as illustrated in the lower right side of FIG. 43, the oxide films at the end portion of the semiconductor layer 200S and the end portion of the pad unit 608 exposed from the trench are subjected to reduction treatment by plasma irradiation using NH₃ or H₂ gas. At this time, at least a part located inward from the end portions of the semiconductor layer 200S and the pad unit 608 may be reduced. Furthermore, in the present embodiment, after the plasma irradiation, the inside may be reduced by performing high-temperature annealing.

Thereafter, although not illustrated, a transistor or the like is formed on the semiconductor layer 200S of the second semiconductor substrate 200.

Furthermore, in the present embodiment, as illustrated in FIG. 44, patterning of the pad unit 608 may be performed after bonding. Specifically, when a trench is formed in the semiconductor layer 200S of the second semiconductor substrate 200 to separate elements, the pad unit 608 may be patterned at the same time. Then, as in FIG. 43, the oxide films at the end portion of the semiconductor layer 200S and the end portion of the pad unit 608 exposed from the trench are subjected to reduction treatment.

Note that, in the above description, the case where the present embodiment is applied to the pad unit 608 between the via 600 and the back surface of the second semiconductor substrate 200 has been described. However, the present embodiment can be applied to a pad unit or the semiconductor layer 200S provided at a portion electrically conducted between the first semiconductor substrate 100 and the second semiconductor substrate 200.

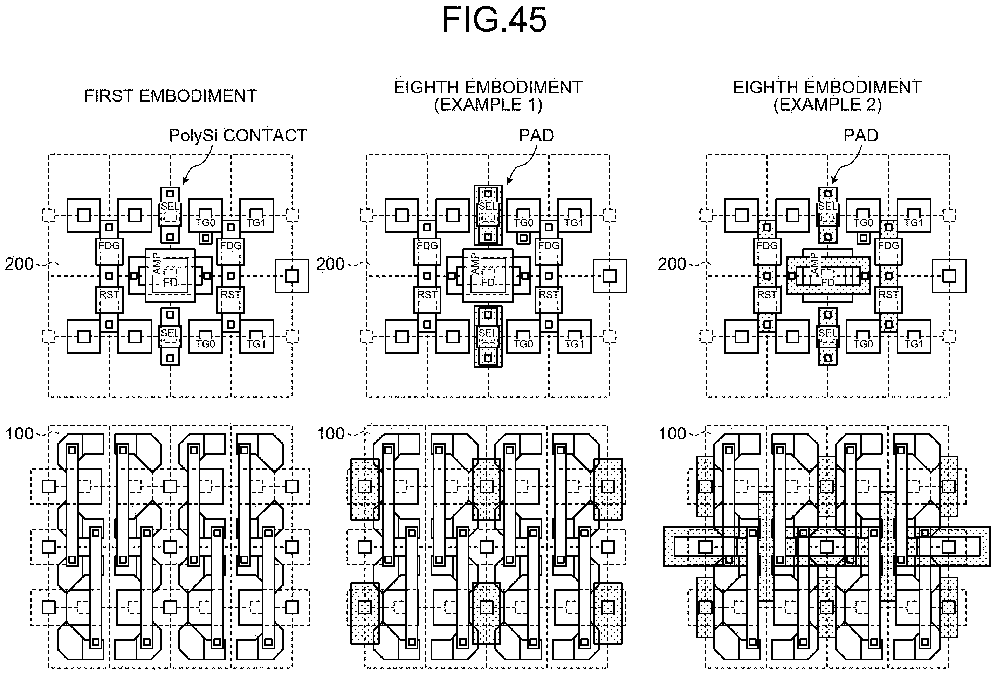

Next, a planar layout according to the present embodiment will be described with reference to FIG. 45. FIG. 45 is a schematic diagram illustrating a planar configuration of an example of a main part of the imaging device 1 according to the present embodiment, in which the upper part is the back surface of the second semiconductor substrate 200 and the lower part is the upper surface of the first semiconductor substrate 100. Furthermore, a layout example of the first embodiment, a layout example (Example 1) of the present embodiment, and a layout example (Example 2) of the present embodiment of the present disclosure are illustrated in this order from the left side of FIG. 45. In particular, in Example 2, the pad unit exists so as to be self-aligned with the pattern of the trench. Note that, in the present embodiment, a pad unit may also be present at a portion that does not need to be electrically conducted to the back surface of the second semiconductor substrate 200. In this case, the pad unit may be formed in an isolated state without connecting a wiring to the pad unit.

### <<10. Ninth Embodiment>>

### <10.1 Background>

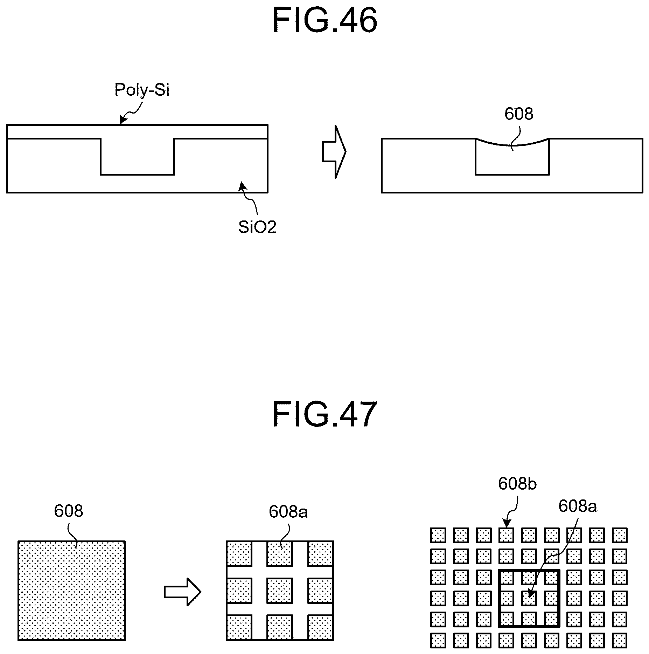

First, a background of the present embodiment will be described with reference to FIGS. 46 and 47. FIGS. 46 and 47 are schematic diagrams for explaining a background of the present embodiment. In the third embodiment of the present disclosure described above, by providing the pad unit 608 between the via 600 and the back surface of the second semiconductor substrate 200, the contact area is increased, and the contact resistance between the via 600 and the back surface of the second semiconductor substrate 200 is reduced. Therefore, the contact resistance can be further reduced by increasing the size of the pad unit 608.

For example, as illustrated in FIG. 46, the pad unit 608 can be formed by forming a trench in an insulating film of silicon oxide (SiO₂) or the like, embedding polysilicon so as to embed the trench, and removing polysilicon protruding from the trench by CMP. However, when the size of the pad unit 608 is increased, recession, that is, dishing is likely to occur after CMP, and in a case where the via 600 is formed so as to be in contact with the pad unit 608 having such dishing, it becomes electrically open, and it becomes difficult to electrically reliably connect the via 600 and the pad unit 608. In addition, even if the via 600 and the pad unit 608 can be electrically connected to each other, since there is a void due to dishing, it is inevitable that the contact resistance increases.

Therefore, in the present embodiment, as illustrated in FIG. 47, by providing a plurality of small pad units (second pad unit) 608a instead of the large pad unit 608, the density difference can be reduced, and the occurrence of dishing at the time of surface polishing by CMP can be reduced. In addition, in the present embodiment, by forming a dummy pad unit (third pad unit) 608b not used for connection around the pad unit 608a used for connection, the density difference can be further reduced, and the occurrence of dishing can be further reduced. Therefore, the via 600 and the pad unit 608a can be electrically connected, and an increase in contact resistance can be reduced. Furthermore, in the present embodiment, by electrically connecting the via 600 and the back surface of the second semiconductor substrate 200 via the plurality of pad units 608a, even if a connection failure occurs in one pad unit 608a, it is possible to reduce the contact resistance while maintaining the connection between the via 600 and the back surface of the second semiconductor substrate 200 with the other pad units 608a. Hereinafter, details of the present embodiment will be described.

### <10.2 Embodiment>

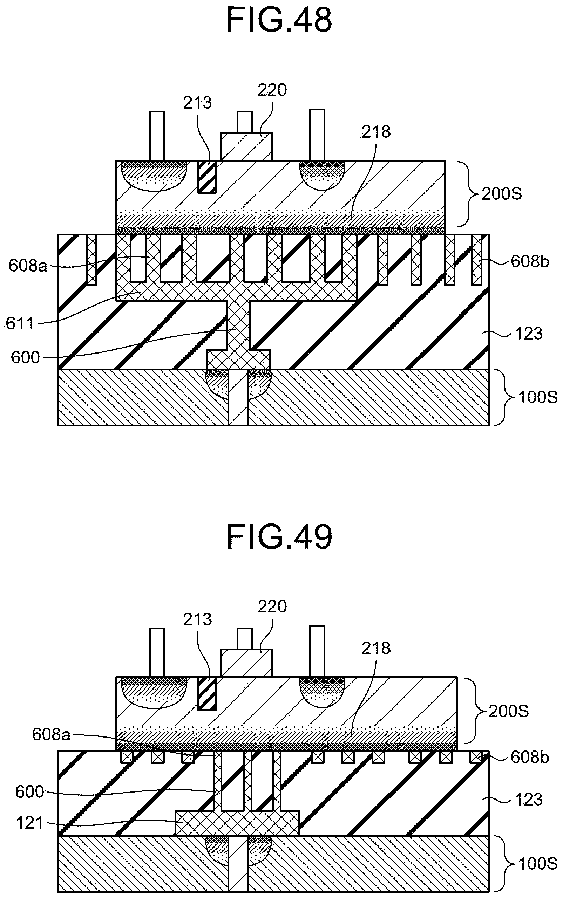

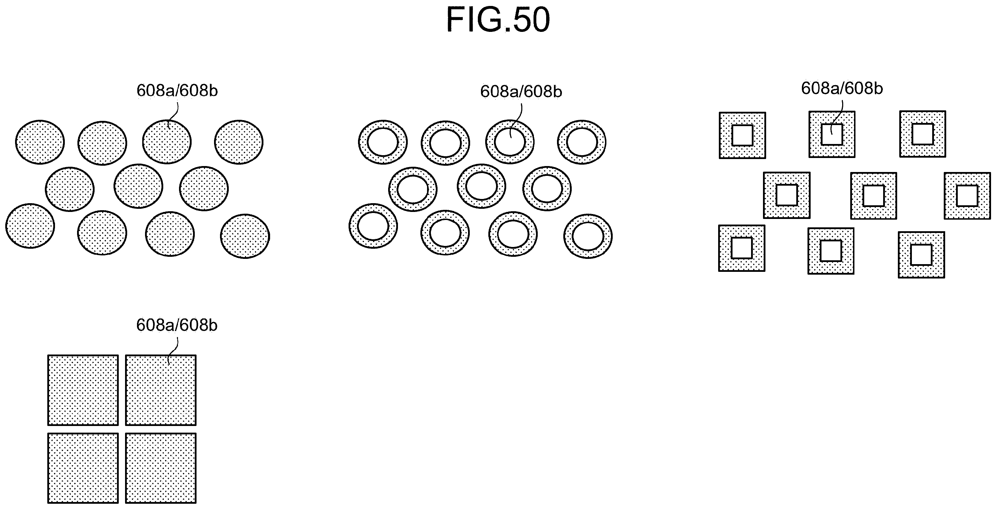

Next, a detailed configuration of an imaging device 1 according to the ninth embodiment of the present disclosure will be described with reference to FIGS. 48 to 50. FIGS. 48 and 49 are schematic diagrams illustrating a cross-sectional configuration of an example of a main part of the imaging device 1 according to the present embodiment, and FIG. 50 is a schematic diagram illustrating a planar configuration of an example of a main part of the imaging device 1 according to the present embodiment.

In the present embodiment, as illustrated in FIG. 48, a plurality of small pad units 608a and dummy pad units 608b not used for connection are provided. Then, the plurality of pad units 608a is connected to each other via a connection unit 611 and is electrically connected to the via 600. Alternatively, in the present embodiment, as illustrated in FIG. 49, a plurality of small pad units 608a and dummy pad units 608b not used for connection are provided. Each of the plurality of pad units 608a is electrically connected to the pad unit 121 by the via 600. In the present embodiment, the pad units 608a and 608b can be formed of a metal material that does not generate silicide, such as polysilicon (poly-Si) or copper (Cu). In the present embodiment, the pad unit 608b serving as a dummy (that is, other elements are not electrically connected) may not be provided.

In the present embodiment, the shapes of the pad units 608a and 608b in plan view are not limited, and as illustrated in FIG. 50, the pad units may have a circular shape, a rectangular shape, a ring shape, or a rectangular frame shape. Furthermore, although not illustrated, a triangular shape or a polygonal shape may be used. In addition, the arrangement thereof may also be arranged in a staggered pattern, and is not particularly limited. In the case of the frame-shaped pad units 608a and 608b, an insulating film made of silicon oxide (SiO₂) or the like is provided inside. In addition, the sizes of the pad units 608a and 608b in plan view are not particularly limited as long as dishing by CMP cannot occur.

According to the present embodiment, by providing the plurality of small pad units 608a, it is possible to reduce the density difference and to reduce the occurrence of dishing. In addition, in the present embodiment, by forming the dummy pad unit 608b not used for connection around the pad unit 608 used for connection, the density difference can be further reduced, and the occurrence of dishing can be further reduced. Furthermore, since the bonding between the first semiconductor substrate 100 and the second semiconductor substrate 200 proceeds uniformly by providing the dummy pad unit 608b, generation of voids between the first semiconductor substrate 100 and the second semiconductor substrate 200 can be avoided. As a result, according to the present embodiment, the first semiconductor substrate 100 and the second semiconductor substrate 200 can be easily bonded. Therefore, according to the present embodiment, it is possible to electrically connect the via 600 and the pad unit 608a and to reduce an increase in contact resistance. Furthermore, in the present embodiment, by electrically connecting the via 600 and the back surface of the second semiconductor substrate 200 via the plurality of pad units 608a, even if a connection failure occurs in one pad unit 608a, the contact resistance can be reduced while the connection between the via 600 and the back surface of the second semiconductor substrate 200 is maintained by the other pad units 608a.

### <10.3 Manufacturing Method>

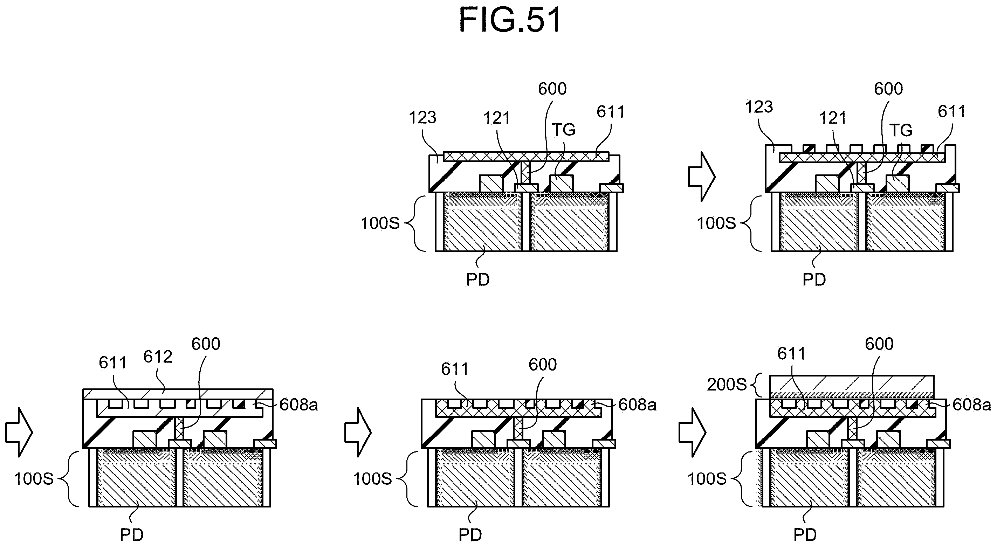

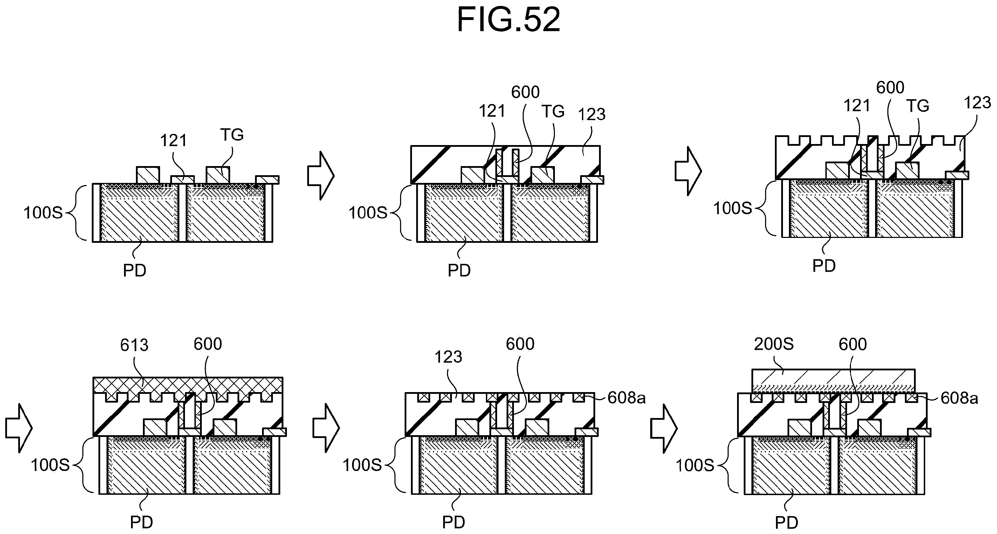

Next, a method of manufacturing the imaging device 1 of the present embodiment will be described with reference to FIGS. 51 and 52. FIGS. 51 and 52 are explanatory diagrams for explaining the method of manufacturing the imaging device 1 according to the present embodiment.

First, as described with reference to FIGS. 14A to 14E, when the first semiconductor substrate 100 (specifically, the via 600 and the interlayer insulating film 123) is formed and the connection unit 611 made of polysilicon (poly-Si) is formed thereon, a form as illustrated in the upper left side of FIG. 51 is obtained. Note that the connection unit 611 may be formed simultaneously when another wiring layer is formed. Next, in the present embodiment, as illustrated in the upper right side of FIG. 51, a silicon oxide (SiO₂) film 123 is formed on the connection unit 611, and patterning is performed.

Next, as illustrated in the lower left side of FIG. 51, a film 612 made of polysilicon (poly-Si) is formed on the silicon oxide film 123. At this time, polysilicon is deposited so as to be embedded in a groove provided in the silicon oxide film 123. Furthermore, as illustrated second from the lower left side of FIG. 51, the film 612 protruding from the silicon oxide film 123 is removed by CMP to form the pad units 608a and 608b. Then, as illustrated in the lower right side of FIG. 51, the second semiconductor substrate 200 is bonded to the first semiconductor substrate 100.

In the present embodiment, it is also possible to use a manufacturing method as illustrated in FIG. 52. First, as described with reference to FIG. 14A, the pad unit 121 and the like are formed on the first semiconductor substrate 100, and a form as illustrated in the upper left side of FIG. 52 is obtained. Next, in the present embodiment, as illustrated second from the upper left side of FIG. 52, the interlayer insulating film 123 is formed, and the via 600 is formed in the interlayer insulating film 123.

Next, as illustrated in the upper right side of FIG. 52, a silicon oxide film is further formed on the interlayer insulating film 123, and patterning is performed.

Next, as illustrated in the lower left side of FIG. 52, a film 613 made of polysilicon (poly-Si) is formed on the interlayer insulating film 123. At this time, polysilicon is deposited so as to be embedded in a groove (trench) provided in the interlayer insulating film 123. Furthermore, as illustrated second from the lower left side of FIG. 52, the film 613 protruding from the interlayer insulating film 123 is removed by CMP to form the pad units 608a and 608b. Then, as illustrated in the lower right side of FIG. 52, the second semiconductor substrate 200 is bonded to the first semiconductor substrate 100.

### <<11. Tenth Embodiment>>

### <11.1 Background>

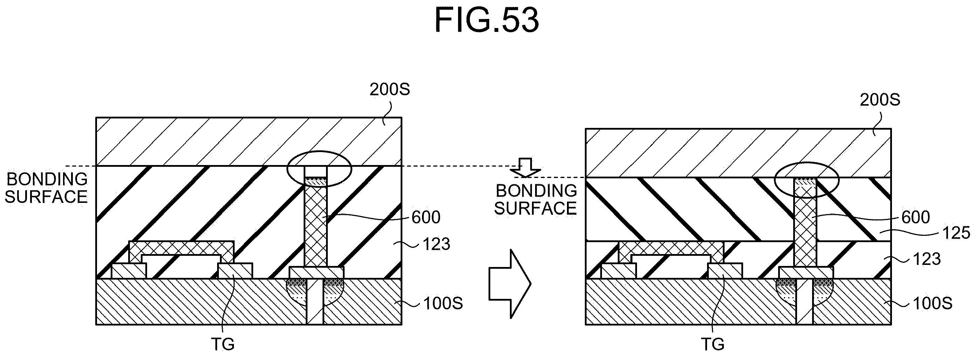

First, a background and an outline of a tenth embodiment of the present disclosure will be described with reference to FIG. 53. FIG. 53 is a schematic diagram for explaining the tenth embodiment of the present disclosure.

As illustrated on the left side of FIG. 53, as described above, the via 600 can be formed, for example, by forming a trench in the interlayer insulating film 123 such as silicon oxide (SiO₂), embedding polysilicon so as to embed the trench, and removing polysilicon protruding from the trench by CMP. However, when the upper surface of the via 600 is recessed (recess) by CMP, it becomes difficult to electrically reliably connect via 600 and the back surface of the second semiconductor substrate 200. In addition, even if the via 600 and the back surface of the second semiconductor substrate 200 can be electrically connected to each other, since there is a void on the upper surface of the via 600 due to dishing, it is inevitable that the contact resistance increases.

Therefore, in the tenth embodiment of the present disclosure, as illustrated on the right side of FIG. 53, a bonding film 125 made of a highly shrinkable film is formed between the first semiconductor substrate 100 and the second semiconductor substrate 200. At the time of bonding the first semiconductor substrate 100 and the second semiconductor substrate 200, the bonding film 125 contracts, so that a recess between the via 600 and the back surface of the second semiconductor substrate 200 can be absorbed, and the via 600 and the back surface of the second semiconductor substrate 200 can be electrically connected. Hereinafter, details of the present embodiment will be described.

### <11.2 Embodiment>

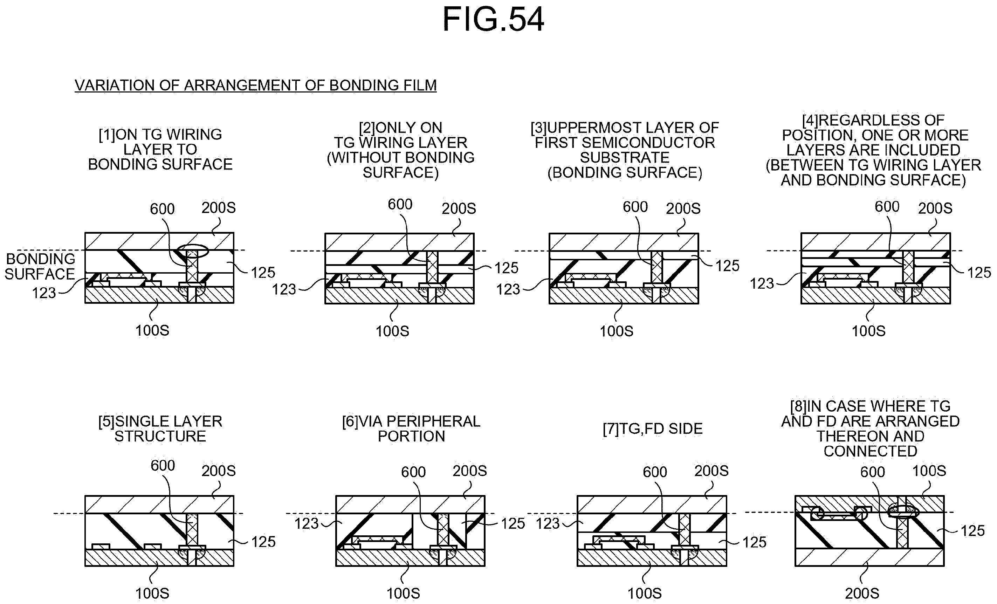

Next, a detailed configuration of an imaging device 1 according to the tenth embodiment of the present disclosure will be described with reference to FIGS. 53 and 54. FIG. 54 is a schematic diagram illustrating a cross-sectional configuration of an example of a main part of the imaging device 1 according to the present embodiment.

In the present embodiment, as illustrated on the right side of FIG. 53, the bonding film 125 made of a highly shrinkable film is formed between the interlayer insulating film 123 of the first semiconductor substrate 100 and the second semiconductor substrate 200. The bonding film 125 is preferably formed of a film having a low film formation temperature, and is preferably a film that contracts at 800 °C, for example. Specifically, the bonding film 125 can be formed from a film having a film density of 2.0 g/cm² or less, and specifically, for example, can be formed from spin on glass (SOG) or non-doped silicate glass (NSG) with low density. Furthermore, the bonding film 125 can be formed from a film having a film density of 1.5 g/cm² or less and a dielectric constant of 3 or less, and specifically, for example, can be formed of Porus-SiO₂ or a low-dielectric constant material (low-κ material or the like). In addition, by using a film having a low dielectric constant for the bonding film 125, it is possible to reflect light and improve the light efficiency of the PD. Furthermore, in the present embodiment, the bonding film 125 is not limited to a single-layer film, and may be a laminated film made of a plurality of different materials.

In the present embodiment, various positions can be selected as the position where the bonding film 125 is provided as illustrated in FIG. 54. For example, as shown in [1], the bonding film 125 may be between the interlayer insulating film 123 and the second semiconductor substrate 200. Furthermore, as illustrated in [2], the bonding film 125 may be provided on a wiring layer that connects TGs. In this case, a film having good bondability can be installed on the bonding surface between the first semiconductor substrate 100 and the second semiconductor substrate 200. Furthermore, as illustrated in [3], the bonding film 125 may be provided under the back surface of the second semiconductor substrate 200. In this case, contraction of the bonding film 125 due to the heat treatment can be effectively obtained. Furthermore, as illustrated in [4], the bonding film 125 may be at any position as long as it is between the first semiconductor substrate 100 and the second semiconductor substrate 200.

Furthermore, in the present embodiment, when the bonding film 125 contracts, stress is applied to the wiring between the TGs, and there is a risk of deformation or breakage of the wiring. Therefore, if there is no wiring connecting the TGs, the bonding film 125 may be formed as a single-layer film between the first semiconductor substrate 100 and the second semiconductor substrate 200 as illustrated in [5]. Furthermore, as illustrated in [6], the bonding film 125 may be provided on the entire periphery of the via 600 (the entire height direction of the via 600) or a part thereof (a part of the height direction of the via 600). Further, as shown in [7], the bonding film 125 may be provided on the semiconductor layer 100S (TD, FD) side. Furthermore, as illustrated in [8], the bonding film 125 can be provided between the first semiconductor substrate 100 and the second semiconductor substrate 200 even if the positional relationship between the first semiconductor substrate 100 and the second semiconductor substrate 200 is reversed.

### <11.3 Manufacturing Method>

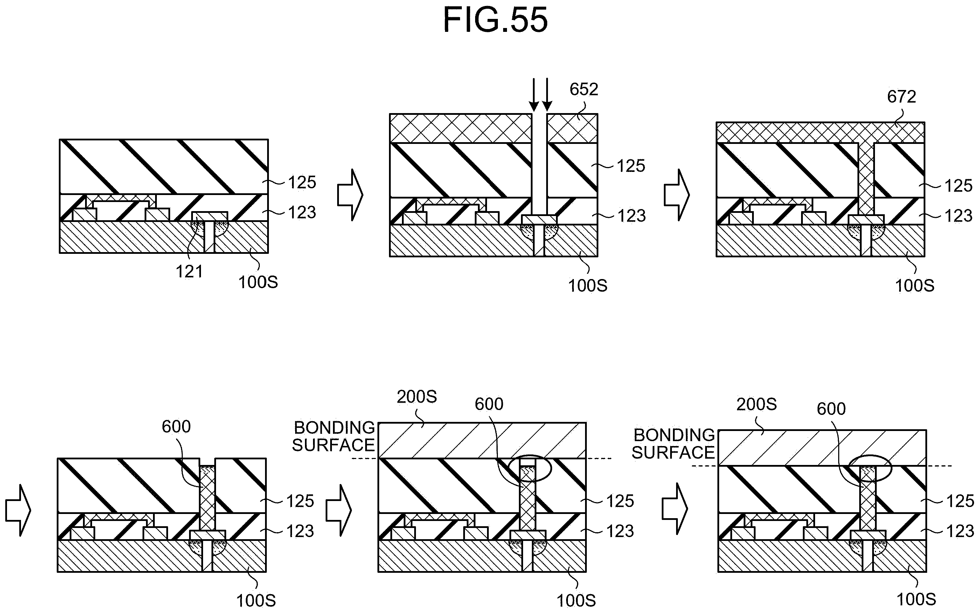

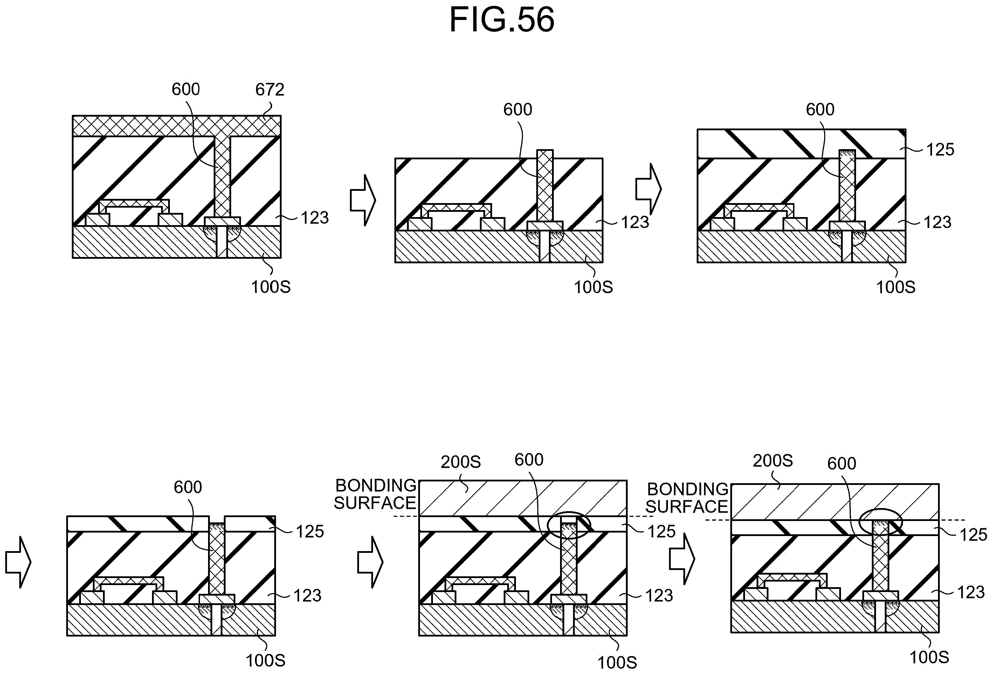

Next, a method of manufacturing the imaging device 1 of the present embodiment will be described with reference to FIGS. 55 and 56. FIGS. 55 and 56 are explanatory diagrams for explaining the method of manufacturing the imaging device 1 according to the present embodiment.

First, as described with reference to FIGS. 14A and 14B, the pad unit 121 and the like are formed on the first semiconductor substrate 100, and the interlayer insulating film 123 and the bonding film 125 are formed thereon, thereby obtaining a form as illustrated in the upper left side of FIG. 55. Next, in the present embodiment, as illustrated second from the upper left side of FIG. 55, a resist 652 is formed on the bonding film 125, patterning is performed by photolithography, and wet etching is performed according to the pattern, thereby forming a hole for the via 600.

Next, as illustrated in the upper left side of FIG. 55, a film 672 made of polysilicon is formed so as to embed holes. At this time, it is preferable to form a film at a temperature of 500 °C or lower. Furthermore, as illustrated in the upper right side of FIG. 55, the film 672 protruding from the bonding film 125 is removed by CMP to form the via 600.

Furthermore, as illustrated second from the lower left side of FIG. 55, the first semiconductor substrate 100 and the second semiconductor substrate 200 are bonded. At this time, in order to reduce degassing and generation of voids, it is preferable to perform bonding in vacuum. Next, as illustrated in the lower right side of FIG. 55, by performing heat treatment after bonding, the bonding film 125 contracts to absorb the recess between the via 600 and the back surface of the second semiconductor substrate 200, and the via 600 and the back surface of the second semiconductor substrate 200 can be electrically connected.

In the present embodiment, it is also possible to use a manufacturing method as illustrated in FIG. 56. First, as described with reference to FIGS. 14A to 14E, a hole is formed in the interlayer insulating film 123 on the first semiconductor substrate 100, the film 672 made of polysilicon is formed so as to embed the hole, and the via 600 is formed. In this way, a form as illustrated in the upper left side of FIG. 56 is obtained. At this time, it is preferable to form a film at a temperature of 500 °C or lower.

Next, as illustrated second from the upper left side of FIG. 56, the film 672 and the interlayer insulating film 123 are removed by using CMP, so that the upper surface of a via 5600 protrudes from the interlayer insulating film 123. Then, as illustrated in the upper right side of FIG. 56, the bonding film 125 is formed on the via 600. Furthermore, as illustrated in the lower left side of FIG. 56, the bonding film 125 is planarized using CMP.

Furthermore, as illustrated second from the lower left side of FIG. 56, the first semiconductor substrate 100 and the second semiconductor substrate 200 are bonded. At this time, in order to reduce degassing and generation of voids, it is preferable to perform bonding in vacuum. Next, as illustrated in the lower right side of FIG. 56, by performing heat treatment after bonding, the bonding film 125 contracts to absorb the recess between the via 600 and the back surface of the second semiconductor substrate 200, and the via 600 and the back surface of the second semiconductor substrate 200 can be electrically connected.

### <<12. Eleventh Embodiment>>

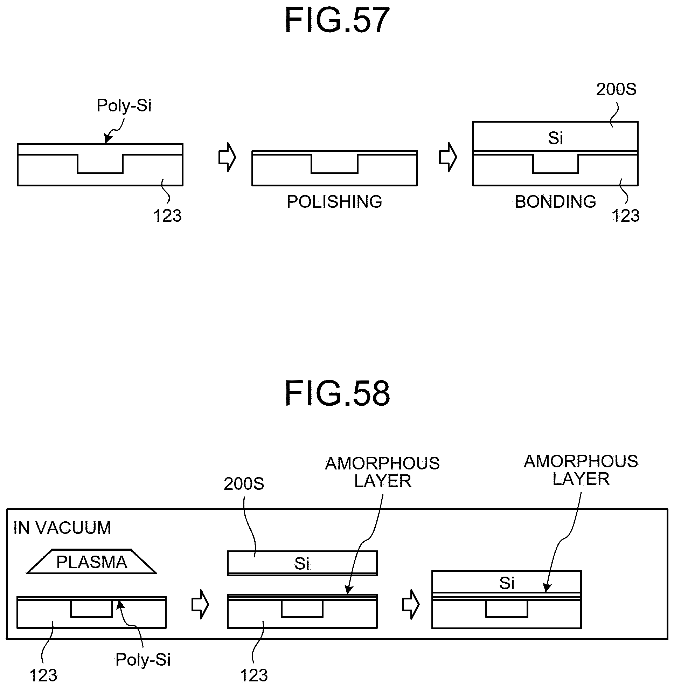

First, a background and an outline of an eleventh embodiment of the present disclosure will be described with reference to FIGS. 57 and 58. FIGS. 57 and 58 are schematic diagrams for explaining the present embodiment.

As described above, the via 600 can be formed, for example, by forming a trench in the interlayer insulating film 123 such as silicon oxide (SiO₂), embedding polysilicon so as to embed the trench, and removing the polysilicon protruding from the trench by CMP. However, when the upper surface of the via 600 is recessed (recess) by CMP, it becomes difficult to electrically connect via 600 and the back surface of the second semiconductor substrate 200. In addition, even if the via 600 and the back surface of the second semiconductor substrate 200 can be electrically connected to each other, since there is a void due to dishing, the contact resistance increases. Furthermore, as described above, a natural oxide film is generated on the back surface of the second semiconductor substrate 200 by being activated by plasma and exposed to the atmosphere. Thus, this natural oxide film increases the contact resistance between the via 600 and the back surface of the second semiconductor substrate 200.

Therefore, in the present embodiment, as illustrated in FIG. 57, polysilicon is left on the interlayer insulating film 123 around the via 600 at the time of polishing the upper surface of the via 600. By leaving polysilicon in the periphery, it is possible to reduce the occurrence of recesses due to the polishing rate difference on the upper surface of the via 600 and to electrically connect the via 600 and the back surface of the second semiconductor substrate 200. The film thickness of the polysilicon remaining in the periphery is preferably about several nm.

Furthermore, in the present embodiment, as illustrated in FIG. 58, the process from activation of polysilicon by plasma to bonding is performed in vacuum. Specifically, polysilicon is activated by plasma to generate amorphous silicon (bonding film) on the surface. Then, by bonding the generated amorphous silicon, it is possible to prevent formation of an oxide film on the bonding surface. When the oxide film is processed in vacuum, voids and the like are likely to be generated, and thus the bonding strength may be deteriorated.

Note that the present embodiment is the same as the above-described embodiments except that polysilicon is left on the interlayer insulating film 123 around the via 600 as described above and that the process from activation of polysilicon by plasma to bonding is performed in vacuum, and thus the detailed description of a manufacturing method and the like is omitted here.

### <<13. Twelfth Embodiment>>

### <13.1 Background>

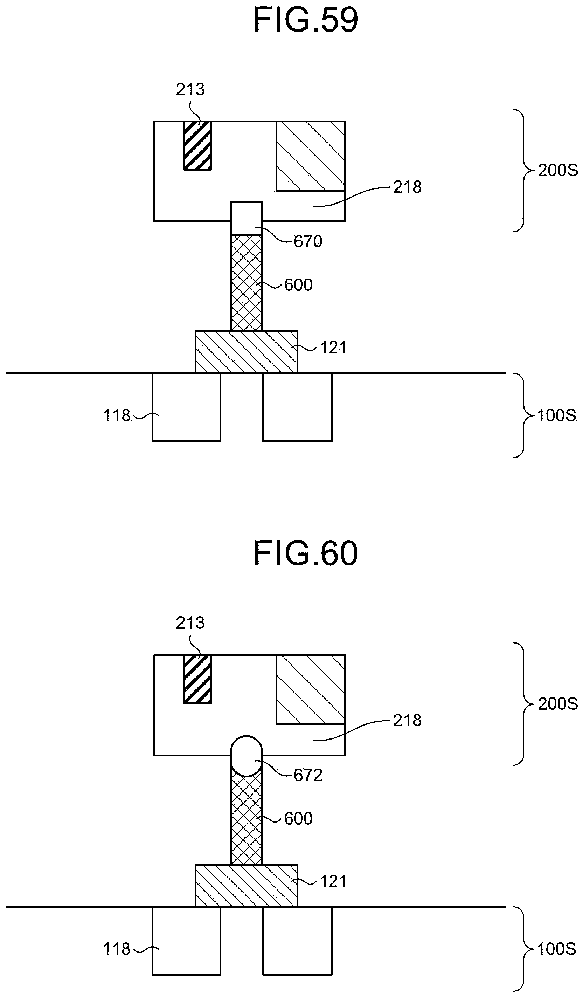

First, a background and an outline of a twelfth embodiment of the present disclosure will be described with reference to FIGS. 59 and 60. FIGS. 59 and 60 are schematic diagrams illustrating a cross-sectional configuration of an example of a main part of an imaging device 1 according to the present embodiment.

As described repeatedly, in the first embodiment described above, it is important that the via 600 and the well region 218 on the back surface (second surface) side of the semiconductor layer 200S of the second semiconductor substrate 200 are electrically connected. However, since a natural oxide film may be present on the back surface of the second semiconductor substrate 200 and the upper surface of the via 600, the contact resistance between the via 600 and the back surface of the second semiconductor substrate 200 may increase. Specifically, the via 600 is formed of polysilicon, and the second semiconductor substrate 200 is formed of single crystal silicon, and these are naturally oxidized by being exposed to the atmosphere.

Therefore, in the twelfth embodiment of the present disclosure, in order to reduce an increase in contact resistance due to the oxide film as described above, the oxide film is reduced, and in addition, a compound with silicon is formed in order to prevent the oxide film. Specifically, in the present embodiment, as illustrated in FIG. 59, a bonding film 670 made of a metal having high reducibility and easily forming silicide is formed on the upper surface of the via 600, and the first semiconductor substrate 100 and the second semiconductor substrate 200 are bonded. Then, the metal in the bonding film 670 reduces the surrounding oxide film and further forms a silicide together with the surrounding silicon by heat treatment for bonding and forming a transistor in the second semiconductor substrate 200. That is, in the present embodiment, as illustrated in FIG. 60, a bonding film 672 made of silicide instead of an oxide film is present between the via 600 and the back surface of the second semiconductor substrate 200. Therefore, in the present embodiment, the contact resistance between the via 600 and the back surface of the second semiconductor substrate 200 can be reduced. Hereinafter, details of the present embodiment will be described.

### <13.2 Embodiment>

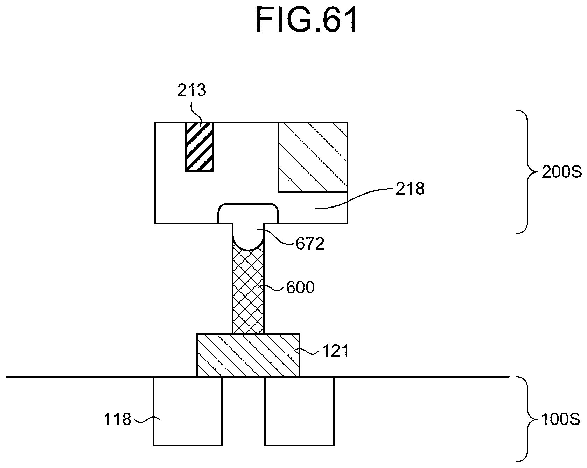

Next, a detailed configuration of an imaging device 1 according to the twelfth embodiment of the present disclosure will be described with reference to FIGS. 59 to 61. FIG. 61 is a schematic diagram illustrating a cross-sectional configuration of an example of a main part of the imaging device 1 according to the present embodiment.

As described above, in the present embodiment, as illustrated in FIG. 59, the bonding film 670 between the via 600 and the back surface of the second semiconductor substrate 200 is provided to bond the first semiconductor substrate 100 and the second semiconductor substrate 200. The bonding film 670 is formed of a high melting point metal material having high reducibility and capable of easily forming a silicide without adversely affecting the transistor of the second semiconductor substrate 200. For example, the bonding film 670 can be formed of Ti (titanium), cobalt (Co), nickel (Ni), tungsten (W), molybdenum (Mo), or the like. In particular, since titanium has a large effect of reducing the oxide film, the bonding film 670 is preferably formed of titanium.

Furthermore, in the present embodiment, by applying an oxide semiconductor (for example, indium gallium zinc oxide (IGZO) or the like) to the transistor of the second semiconductor substrate 200, it is possible to avoid applying a high temperature when the transistor is formed. In such a case, the bonding film 670 may not be formed of a high melting point metal material, and can be formed of, for example, copper (Cu).

Then, in the present embodiment, as illustrated in FIG. 60, the first semiconductor substrate 100 and the second semiconductor substrate 200 are bonded, and a transistor is formed on the second semiconductor substrate 200. At that time, since the metal in the bonding film 670 reduces the surrounding oxide film and further forms silicide together with the surrounding silicon, the bonding film 672 made of silicide is generated between the via 600 and the back surface of the second semiconductor substrate 200 instead of the oxide film. Therefore, in the present embodiment, since the oxide film is reduced and the bonding film 672 made of silicide is generated, the contact resistance between the via 600 and the back surface of the second semiconductor substrate 200 can be reduced.

Note that, in the present embodiment, as illustrated in FIG. 61, the bonding film 672 made of silicide may greatly spread on the back surface side of the second semiconductor substrate 200, and a region where silicide is generated may be wide as long as other elements are not affected. In this way, the bonding strength between the first semiconductor substrate 100 and the second semiconductor substrate 200 can be further improved. Furthermore, in the present embodiment, in addition to the bonding film 672 for connecting the via 600 and the back surface of the second semiconductor substrate 200, a dummy bonding film 672 not related to electrical conduction may be provided at a location other than the via 600. By providing such a dummy bonding film 672, silicide is generated by the bonding film 672, and thus the bonding strength between the first semiconductor substrate 100 and the second semiconductor substrate 200 can be further increased.

### <13.3 Manufacturing Method>

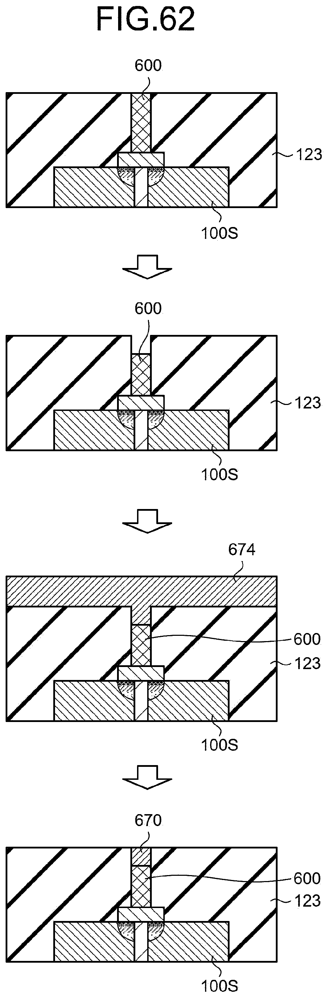

Next, a method of manufacturing the imaging device 1 of the present embodiment will be described with reference to FIG. 62. FIG. 62 is an explanatory diagram for explaining the method of manufacturing the imaging device 1 according to the present embodiment.

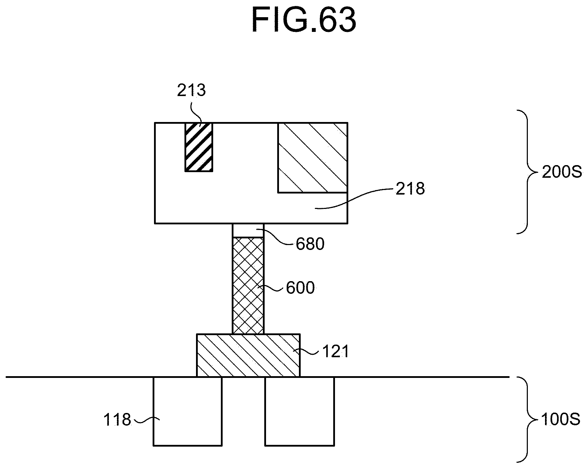

First, as illustrated in the upper part of FIG. 62, the via 600 is formed on the first semiconductor substrate 100 side. Since the method for forming the via 600 has been described above, the details thereof will be omitted. Next, as illustrated second from the top in FIG. 63, the upper portion of the via 600 is etched to form a recess. For example, dry etching, wet etching, or the like can be used for forming the recess. In the present embodiment, a recess may be formed at the same time when polysilicon protruding from the interlayer insulating film 123 is removed at the time of forming the via 600. At this time, the recess can be formed by increasing the overpolish by CMP by utilizing the selection ratio between the oxide film of the interlayer insulating film 123 and the polysilicon of the via 600. In the present embodiment, the depth of the recess may be 1 nm or more, and is preferably 10 nm or more from the viewpoint of manufacturing variations.

Next, as illustrated in third from the upper part of FIG. 62, a film 674 made of a high melting point metal material is formed on the interlayer insulating film 123 and the via 600 by CVD, ALD, or the like. The film thickness of the film 674 only needs to be equal to or larger than the depth of the recess because the recess only needs to be embedded. Next, the film 674 protruding from the recess is removed by CMP to obtain a form as illustrated in the lower part of FIG. 62. Further, the second semiconductor substrate 200 is bonded, but since the subsequent steps are always performed, the description thereof is omitted here.

### <<14. Thirteenth Embodiment>>

### <14.1 Background>

As described above, in the first embodiment described above, it is important that the via 600 and the well region 218 on the back surface (second surface) side of the semiconductor layer 200S of the second semiconductor substrate 200 are electrically connected. However, if the via 600 is formed of polysilicon, polysilicon may be oxidized in the middle of the manufacturing process, and thus the contact resistance between the via 600 and the back surface of the second semiconductor substrate 200 may increase.

Therefore, in the thirteenth embodiment of the present disclosure, a cap film made of a material having low resistance even when oxidized is provided on the upper surface of the via 600. With this configuration, according to the present embodiment, it is possible to reduce an increase in contact resistance between the via 600 and the back surface of the second semiconductor substrate 200. Hereinafter, details of the present embodiment will be described.

### <14.2 Embodiment>

Next, a detailed configuration of an imaging device 1 according to the thirteenth embodiment of the present disclosure will be described with reference to FIG. 63. FIG. 63 is a schematic diagram illustrating a cross-sectional configuration of an example of a main part of the imaging device 1 according to the present embodiment.

In the present embodiment, as illustrated in FIG. 63, a cap film (bonding film) 680 made of a material having low resistance even when oxidized is provided on the upper surface of the via 600. Specifically, in the present embodiment, the cap film 680 is formed of a metal having low resistance even when oxidized, and/or a conductive oxide. Examples of such a metal include titanium (Ti), ruthenium (Ru), rhenium (Re), tungsten (W), molybdenum (Mo), and cobalt (Co). Furthermore, examples of the conductive compound include indium tin oxide (InSnO), zinc oxide (ZnO), indium zinc oxide (ZnInO), zinc aluminum oxide (ZnAlO), zinc germanium oxide (ZnGaO), and the like. Furthermore, in the present embodiment, the cap film 680 is not limited to being formed by one layer film made of the above-described material, and may be formed as a multilayer film by stacking two or more kinds of films selected from the above-described materials. Further, in the present embodiment, the film thickness of the cap film 680 may be about several nm to several 10 nm.

### <14.3 Manufacturing Method>

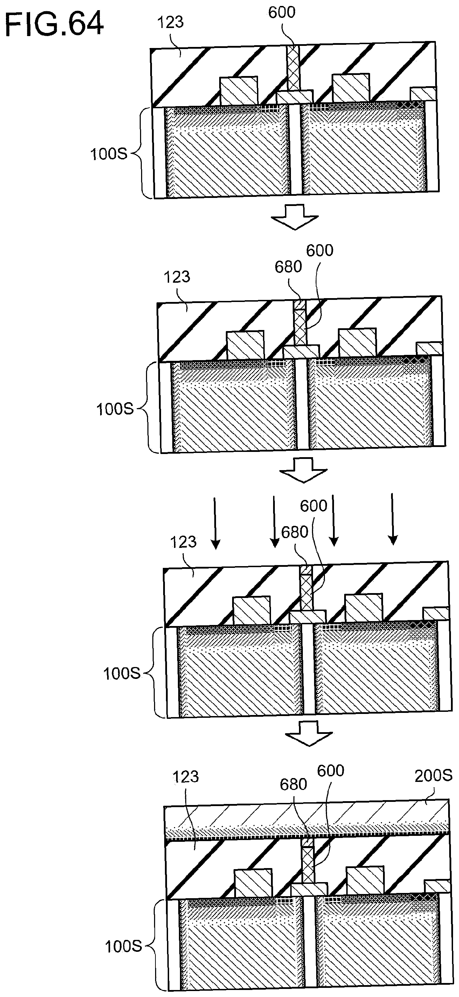

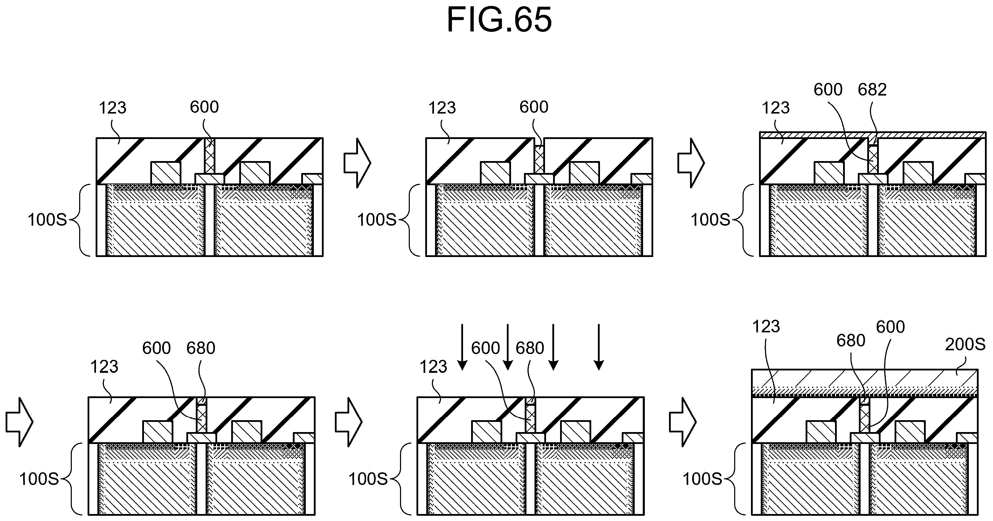

Next, a method of manufacturing the imaging device 1 of the present embodiment will be described with reference to FIGS. 64 and 65. FIGS. 64 and 65 are explanatory diagrams for explaining the method of manufacturing the imaging device 1 according to the present embodiment.

First, as illustrated in the upper part of FIG. 64, the via 600 made of polysilicon is formed on the first semiconductor substrate 100 side. Since the method for forming the via 600 has been described above, the details thereof will be omitted. Next, as illustrated in the second from the upper part of FIG. 64, the cap film 680 can be formed by forming a film of ruthenium (Ru) or the like on the upper surface of the via 600 using Area Selective Deposition (ASD) on the upper surface of the via 600. ASD is a type of thermal ALD, and for example, ruthenium oxide is adsorbed and reduced on the upper surface of the via 600 made of polysilicon, whereby a ruthenium film can be formed. Note that, on the interlayer insulating film 123 made of silicon oxide (SiO₂), the ruthenium film formation speed is extremely slow as compared with the silicon field, so that ruthenium can be selectively deposited on the upper surface of the via 600 made of polysilicon.

Then, as illustrated third from the upper part of FIG. 64, a process of activating the surface of the second semiconductor substrate 200 is performed. Examples of the activation processing include plasma treatment. At this time, even when the cap film 680 is oxidized by the activation processing, since the resistance value is low, an increase in contact resistance between the via 600 and the back surface of the second semiconductor substrate 200 can be reduced. Furthermore, as illustrated in the lower part of FIG. 64, the second semiconductor substrate 200 is bonded.

In the present embodiment, as illustrated in FIG. 65, other manufacturing methods can be used. First, as illustrated in the upper left side of FIG. 65, the via 600 made of polysilicon is formed on the first semiconductor substrate 100 side. Next, as illustrated second from the upper left side in FIG. 65, the upper portion of the via 600 is etched to form a recess. For example, dry etching, wet etching, or the like can be used for forming the recess.

Next, as illustrated in the upper right side of FIG. 65, a film 682 made of a metal or a conductive oxide film is formed on the interlayer insulating film 123 and the via 600 by ALD, sputtering, or the like. Specifically, ALD is preferably used in the case of titanium (Ti) or rhenium (Re), and sputtering is preferably used in the case of tungsten (W), molybdenum (Mo), cobalt (Co), indium tin oxide (InSnO), zinc oxide (ZnO), indium zinc oxide (ZnInO), zinc aluminum oxide (ZnAlO), and zinc germanium oxide (ZnGaO).

Next, as illustrated in the lower left side of FIG. 65, the film 682 protruding from the recess is removed by CMP to form the cap film 680. Then, as illustrated second from the lower left side of FIG. 65, a process of activating the surface of the second semiconductor substrate 200 is performed. Examples of the activation processing include plasma treatment. At this time, even when the cap film 680 is oxidized by the activation processing, since the resistance value is low, an increase in contact resistance between the via 600 and the back surface of the second semiconductor substrate 200 can be reduced. Further, as illustrated in the upper right side of FIG. 65, the second semiconductor substrate 200 is bonded.

### <<15. Fourteenth Embodiment>>

### <15.1 Background>

In the embodiment of the present disclosure described above, it is important that the via 600 and the well region 218 on the back surface (second surface) side of the semiconductor layer 200S of the second semiconductor substrate 200 are electrically connected with a low contact resistance. However, before the first semiconductor substrate 100 and the second semiconductor substrate 200 are bonded, a natural oxide film may be generated on the back surface of the second semiconductor substrate 200. Then, since the natural oxide film is present between the via 600 and the back surface of the second semiconductor substrate 200 after bonding, the contact resistance between the via 600 and the back surface of the second semiconductor substrate 200 increases. Therefore, in order to reduce the contact resistance, it is conceivable to bond the first semiconductor substrate 100 and the second semiconductor substrate 200 after performing the processing of removing the natural oxide film on the back surface of the second semiconductor substrate 200. However, if such natural oxide film removal processing is performed, the contact resistance between the via 600 and the back surface of the second semiconductor substrate 200 is reduced, but the bonding strength between the entire back surface of the second semiconductor substrate 200 and the upper surface of the interlayer insulating film 123 is deteriorated. In other words, when the natural oxide film is removed and bonding is performed, the bonding strength between the first semiconductor substrate 100 and the second semiconductor substrate 200 is deteriorated.

Therefore, in the fourteenth embodiment of the present disclosure, a protrusion (not illustrated) protruding upward is provided on the upper surface of the via 600 before being bonded to the second semiconductor substrate 200. Then, in the present embodiment, when the first semiconductor substrate 100 and the second semiconductor substrate 200 are bonded, the natural oxide film on the back surface of the second semiconductor substrate 200 is broken by the protrusion, and the protrusion located at the tip of the via 600 and the semiconductor layer 200S of the second semiconductor substrate 200 are directly bonded. Therefore, in the present embodiment, the contact resistance between the via 600 and the back surface of the second semiconductor substrate 200 can be reduced without deteriorating the bonding strength between the first semiconductor substrate 100 and the second semiconductor substrate 200. Hereinafter, details of the present embodiment will be described.

### <15.2 Embodiment>

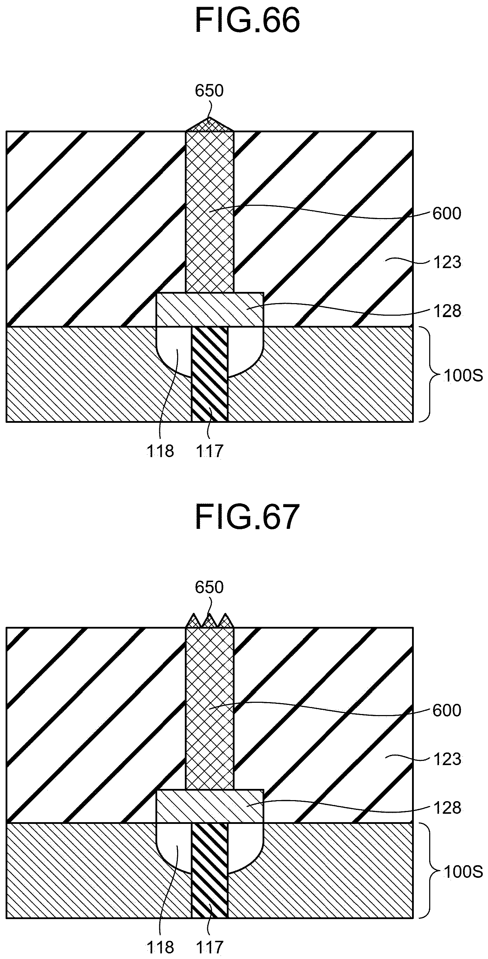

First, a configuration example of a protrusion 650 according to the present embodiment will be described with reference to FIGS. 66 and 67. FIGS. 66 and 67 are schematic diagrams illustrating a configuration of an example of a main part of the first semiconductor substrate 100 according to the present embodiment.

In the present embodiment, as illustrated in FIG. 66, the protrusion 650 protruding upward is provided on the upper surface of the via 600 before being bonded to the second semiconductor substrate 200. Specifically, in the present embodiment, as illustrated in FIG. 66, the protrusion 650 may have an acute-angle pointed tip, or only the most distal end of the protrusion 650 may be flat, and there is no particular limitation.

Furthermore, in the present embodiment, as illustrated in FIG. 67, a plurality of protrusions 650 may be provided on the upper surface of the via 600. In the present embodiment, when the plurality of protrusions 650 are provided, the height, size, and the like of each protrusion 650 may be different from each other. In such a case, it is possible to easily form the plurality of protrusions 650 by performing a process of intentionally deteriorating the flatness of the upper surface of the via 600 on the upper surface.

In the present embodiment, the protrusion 650 may be formed of polysilicon similarly to the main body (columnar portion) of the via 600, or may be formed of a metal material such as tungsten (W).

Since the protrusion 650 according to the present embodiment is provided on the via 600 having a diameter of about 100 nm, the protrusion has a very small size. Therefore, even when one or a plurality of such protrusions 650 are provided on the upper surface of the via 600, the bonding strength between the second semiconductor substrate 200 and the first semiconductor substrate 100 is not greatly affected.

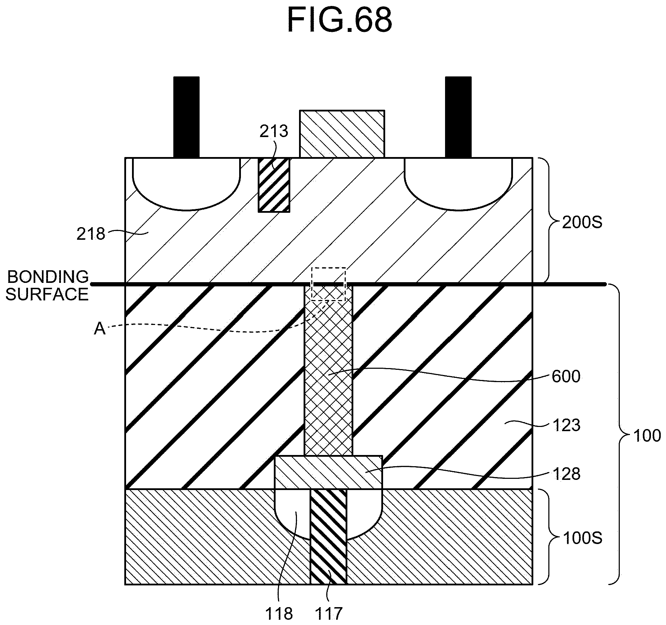

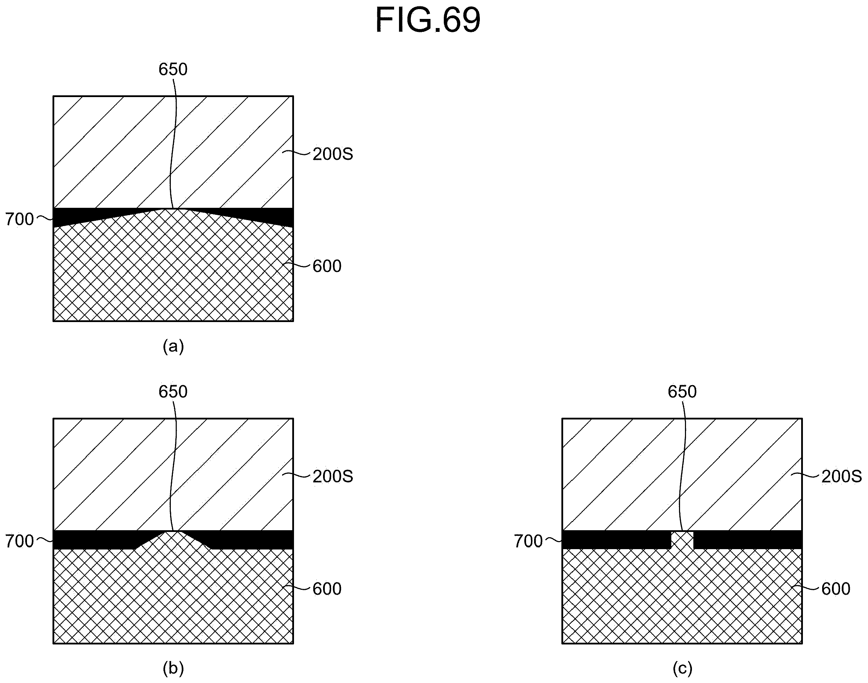

Further, a bonding state between the via 600 and the second semiconductor substrate 200 after bonding the first semiconductor substrate 100 and the second semiconductor substrate 200 will be described in detail with reference to FIGS. 68 to 71. FIG. 68 is a schematic diagram illustrating a configuration of an example of a main part of the imaging device 1 according to the present embodiment, and FIGS. 69 to 71 are enlarged views of region A in FIG. 68.

In the present embodiment, in manufacturing the imaging device 1, as illustrated in FIG. 68, the first semiconductor substrate 100 and the second semiconductor substrate 200 (only the semiconductor layer 200S is illustrated in the drawing) are bonded. At this time, due to the bonding pressure at the time of bonding, the natural oxide film existing on the back surface of the second semiconductor substrate 200 is broken at the tip of the protrusion 650 of the via 600. Therefore, the protrusion 650 located at the tip of the via 600 and the semiconductor layer 200S of the second semiconductor substrate 200 are directly bonded. Therefore, in the present embodiment, the contact resistance between the via 600 and the back surface of the second semiconductor substrate 200 can be reduced.

Here, a case where the protrusion 650 is formed of polysilicon will be considered. The hardness of the natural oxide film is about 10 GPa, the hardness of the silicon substrate is about 185 Ga, and the hardness of the polysilicon is 130 to 170 GPa. Therefore, since the natural oxide film is very soft as compared with the polysilicon or silicon substrate, the natural oxide film can be broken by the protrusion 650 of the via 600 by the bonding pressure at the time of bonding. Note that the bonding strength between the first semiconductor substrate 100 and the second semiconductor substrate 200 is assumed to be about 2 N (when the bonding pressure is insufficient, an external load may be applied). In addition, in the measurement by the nanoindenter, it is known that the silicon oxide film is displaced by about 1 nm by the pushing of 1 mN, and since the film thickness of the natural oxide film is about 0.5 to 1 nm, as a result of performing calculation by Young's modulus using these data, it has been found that it is sufficiently possible to break through the natural oxide film by the protrusion 650.

In addition, even when the natural oxide film cannot be completely broken by the protrusion 650, the tip of the protrusion 650 having a small contact surface is pressed against the back surface of the second semiconductor substrate 200, and a strong pressure is locally applied. Therefore, the natural oxide film existing between the via 600 and the back surface of the second semiconductor substrate 200 is expected to be very thin. Then, when the natural oxide film becomes very thin, a tunneling effect of a current occurs, so that it is possible to reduce the contact resistance between the via 600 and the back surface of the second semiconductor substrate 200. That is, in the present embodiment, at least the tip of the protrusion 650 may be in contact with the back surface of the second semiconductor substrate 200 or embedded in the second semiconductor substrate 200.

Specifically, in a case where the via 600 has one protrusion 650, as illustrated in FIG. 69, when the first semiconductor substrate 100 and the second semiconductor substrate 200 are bonded, the cross section of the protrusion 650 has a trapezoidal, substantially triangular, or substantially rectangular shape that breaks through the natural oxide film 700 between the via 600 and the second semiconductor substrate 200.

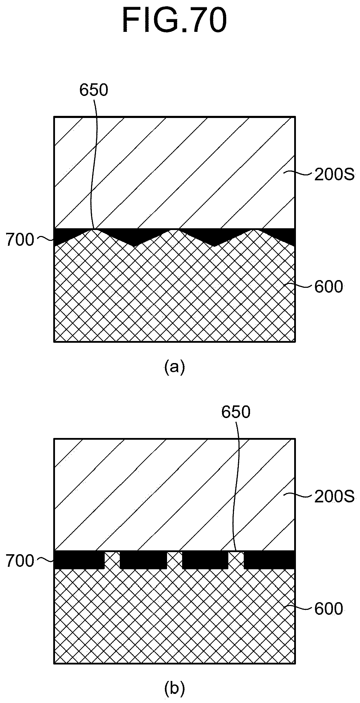

In addition, in a case where the via 600 has a plurality of protrusions 650, as illustrated in FIG. 70, when the first semiconductor substrate 100 and the second semiconductor substrate 200 are bonded, the cross section of each protrusion 650 has a trapezoidal, substantially triangular, or substantially rectangular shape that breaks through the natural oxide film 700 between the via 600 and the second semiconductor substrate 200.

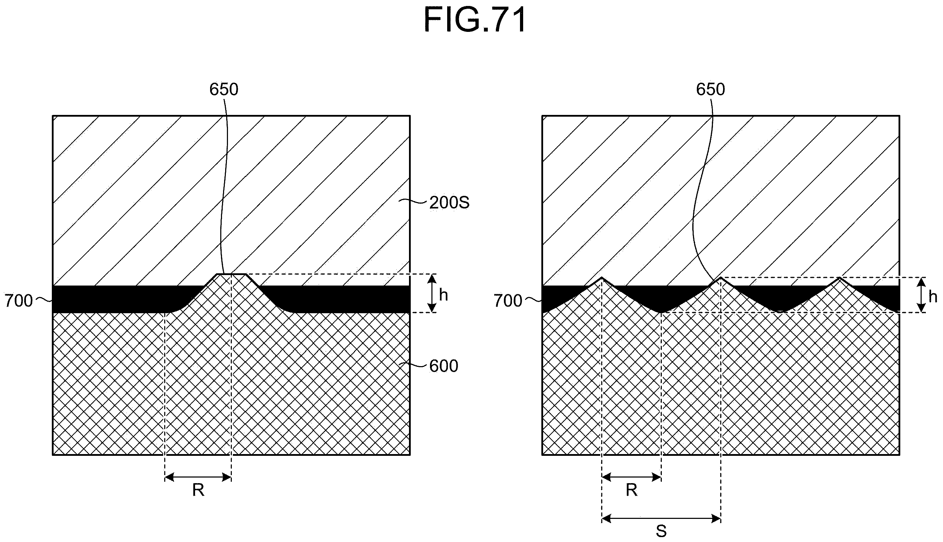

Furthermore, as illustrated in FIG. 71, in the present embodiment, the height h of the protrusion 650 is preferably 50 nm or less. In addition, in a case where a plurality of the protrusions 650 is provided, the interval s between the centers of the protrusions 650 is preferably 2R or less when the radius of the main body (columnar portion) of the via 600 is R. Furthermore, the area of the contact surface where the tip of the protrusion 650 and the second semiconductor substrate 200 are in contact with each other is preferably 1/2 or less with respect to the area A of the upper surface of the main body (columnar portion) of the via 600.

### <15.3 Manufacturing Method>

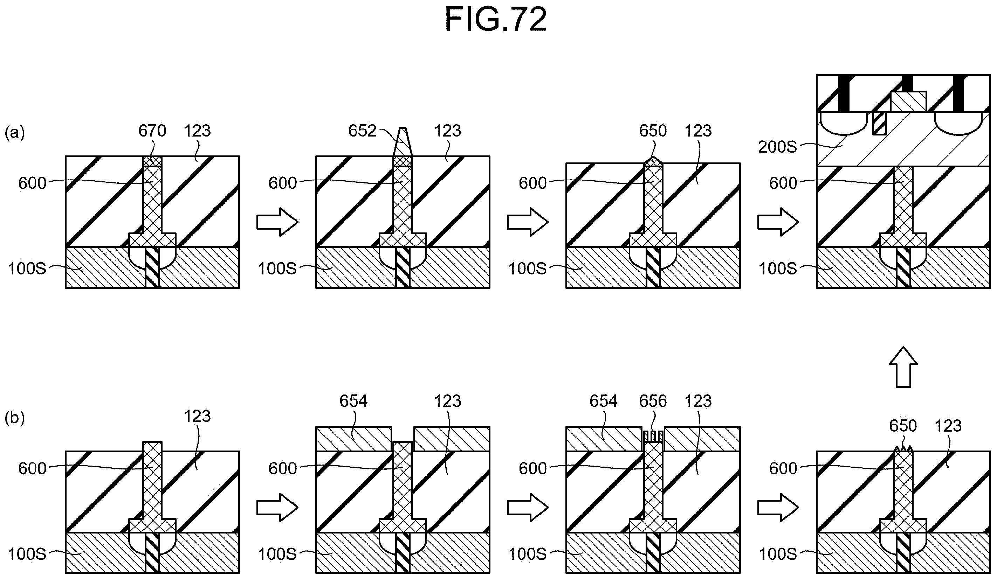

Next, a manufacturing method according to the present embodiment will be described with reference to FIG. 72. FIG. 72 is a schematic diagram for explaining the method of manufacturing the imaging device 1 according to the present embodiment.

First, a manufacturing method in a case where the via 600 has one protrusion 650 illustrated in the upper part of FIG. 72 is described. First, as illustrated in the upper left side of FIG. 72, after a main body (columnar portion) of the via 600 is formed, the film 670 is formed on the upper surface of the via 600 using a metal material such as polysilicon or tungsten. Next, as illustrated second from the upper left side of FIG. 72, the resist 652 is formed on the film 670, and the shape of the resist 652 is tapered by defocus exposure of lithography or registry flow.

Then, as illustrated third from the upper left side of FIG. 72, the film 670 is etched while the upper surface of the interlayer insulating film 123 is etched by dry etching, and thus the tip of the film 670 is made pointed to form the protrusion 650. At this time, by adding O₂ gas and performing dry etching, the resist 652 can be processed while being retracted, so that the tip of the protrusion 650 can be formed into a more acute angle shape.

Then, after the protrusion 650 is formed, the first semiconductor substrate 100 and the second semiconductor substrate 200 are bonded as illustrated in the upper right side of FIG. 72. At the time of bonding, since the protrusion 650 breaks through the natural oxide film 700 on the back surface of the second semiconductor substrate 200, contact resistance between the via 600 and the back surface of the second semiconductor substrate 200 can be reduced.

Next, a manufacturing method in a case where the via 600 has a plurality of protrusions 650 illustrated in the lower part of FIG. 72 will be described. First, as illustrated in the lower left side of FIG. 72, after the main body (columnar portion) of the via 600 is formed, the upper surface of the interlayer insulating film 123 is slightly retracted by chemical mechanical polish (CMP) or dry etching, and the upper surface of the main body of the via 600 is slightly protruded from the interlayer insulating film 123.

Next, as illustrated second from the lower left side of FIG. 72, a resist 654 having a hole that exposes the upper surface of the main body of the via 600 is formed by lithography. Then, as illustrated third from the lower left side of FIG. 72, a fine dot pattern 656 of 30 nm or less is formed on the upper surface of the main body of the via 600 exposed from the resist 654 using a directed self-assembly (DSA) (Templated DSA). DSA is a technique capable of forming a fine pattern in a self-aligned manner because a polymer resin is self-assembled to cause phase separation.

Then, as illustrated in the lower right side of FIG. 72, by removing the upper surface of the main body of the via 600 by about several nm to several 10 nm according to the dot pattern 656 by dry etching, the upper surface becomes rough, and a plurality of fine protrusions 650 can be formed. Similarly to the above, by adding O2 gas and performing dry etching, the dot pattern 656 can be processed while being retracted, and thus the tip of each protrusion 650 can be formed into a more acute angle shape. Furthermore, as described above, after the plurality of protrusions 650 is formed, the first semiconductor substrate 100 and the second semiconductor substrate 200 are bonded as illustrated in the upper right side of FIG. 72. At the time of bonding, since the protrusion 650 breaks through the natural oxide film 700 on the back surface of the second semiconductor substrate 200, contact resistance between the via 600 and the back surface of the second semiconductor substrate 200 can be reduced.

### <15.4 Modification>

Next, a modification of the present embodiment will be described. In the present modification, in order to further reduce the contact resistance between the via 600 and the back surface of the second semiconductor substrate 200, the protrusion 650 formed of polysilicon is formed so as to contain impurities at a higher concentration than that of the main body of the via 600. Here, the impurity contained in the protrusion 650 is, for example, a p-type (first conductivity type) impurity such as boron (B).

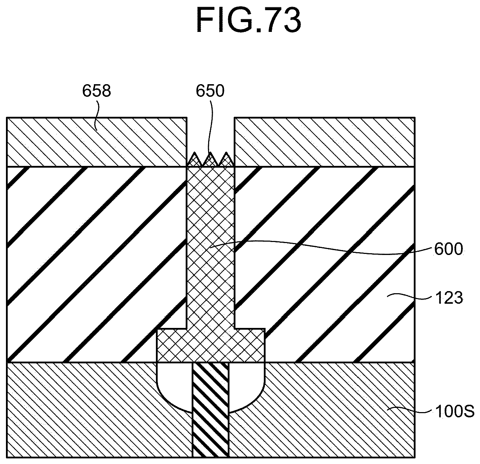

Next, a manufacturing method according to the present modification will be described with reference to FIG. 73. FIG. 73 is an explanatory diagram for explaining a manufacturing method according to a modification of the present embodiment.

First, similarly to the manufacturing method of the present embodiment, after the main body (columnar portion) of the via 600 is formed, the upper surface of the interlayer insulating film 123 is slightly retracted by CMP or dry etching, and the upper surface of the main body of the via 600 is slightly protruded from the interlayer insulating film 123. Next, a mask 658 having a hole that exposes the upper surface of the main body of the via 600 is formed using lithography or the like.

Then, in the present modification, as illustrated in FIG. 73, In-situ Dope selective Epi growth is performed on the upper surface of the main body of the via 600 exposed from the mask 658, and the protrusion 650 made of polysilicon heavily doped with impurities is grown. The impurity concentration of the protrusion 650 is preferably about 10²⁰ to 10¹¹ pieces/cm³. The impurity concentration of the main body portion of the via 600 is about 10¹⁹ pieces/cm³. Further, according to the Epi growth, the height of the formed protrusion 650 can be controlled to about several nm to several tens nm.

Furthermore, as described above, after the plurality of protrusions 650 is formed, the first semiconductor substrate 100 and the second semiconductor substrate 200 are bonded. At the time of bonding, since the protrusion 650 breaks through the natural oxide film 700 on the back surface of the second semiconductor substrate 200, contact resistance between the via 600 and the back surface of the second semiconductor substrate 200 can be reduced. Furthermore, in the present modification, since the protrusion 650 contains high-concentration impurities, the contact resistance can be further reduced.

Furthermore, in the present modification, the protrusion 650 may be formed using a technique other than the Epi growth described above. Specifically, as described above, after the main body (columnar portion) of the via 600 is formed, the upper surface of the interlayer insulating film 123 is slightly retracted by CMP or dry etching, and the upper surface of the main body of the via 600 is slightly protruded from the interlayer insulating film 123. Next, the mask 658 having a hole that exposes the upper surface of the main body of the via 600 is formed using lithography or the like. Then, impurities are implanted into the upper surface of the main body of the via 600 exposed from the mask 658 using a gas cluster ion beam (GCIB) or ion implantation (II). At this time, since impurities are implanted, the upper surface of the main body of the via 600 becomes slightly rough, and irregularities of about several nm to several 10 nm are generated, and thus the plurality of protrusions 650 can be formed. As described above, the impurity concentration of the protrusion 650 is preferably about 10²⁰ to 10¹¹ pieces/cm³.

### <<16. Fifteenth Embodiment>>

### <16.1 Background>

As described above, in the embodiment of the present disclosure described above, it is important that the via 600 and the well region 218 on the back surface (second surface) side of the semiconductor layer 200S of the second semiconductor substrate 200 are electrically connected with a low contact resistance. However, before the first semiconductor substrate 100 and the second semiconductor substrate 200 are bonded, a natural oxide film may be generated on the back surface of the second semiconductor substrate 200. Then, since the natural oxide film 700 is present between the via 600 and the back surface of the second semiconductor substrate 200 after bonding, the contact resistance between the via 600 and the back surface of the second semiconductor substrate 200 increases. Therefore, in the above-described embodiment, the protrusion 650 made of a metal material or the like is provided on the upper surface of the via 600 on the second semiconductor substrate 200 side. Then, when the first semiconductor substrate 100 and the second semiconductor substrate 200 are bonded, since the protrusion 650 can break through the natural oxide film 700, the via 600 is directly electrically connected to the semiconductor layer 200S of the second semiconductor substrate 200.

However, in such a form, since the metal material of the protrusion and the silicon of the semiconductor layer 200S of the second semiconductor substrate 200 are directly bonded, a Schottky barrier occurs, and there is a possibility that the contact resistance between the via 600 and the back surface of the second semiconductor substrate 200 cannot be reduced. Note that such a phenomenon is not limited to the above-described embodiment in which the protrusion 650 is provided, and can occur even in other embodiments as long as the via 600 is formed of a metal material and the via 600 and the semiconductor layer 200S are directly bonded.

Therefore, in the fifteenth embodiment of the present disclosure, the via 600 is formed of polysilicon or a metal material, and a bonding thin film or a stacked layer made of a high-κ insulating film having a high relative dielectric constant is further formed between the via 600 and the back surface of the second semiconductor substrate 200. That is, in the present embodiment, a contact having a metal-insulator-semiconductor (MIS) structure is adopted in electrical connection between the via 600 and the back surface (second surface) of the second semiconductor substrate 200. According to the present embodiment, by adopting the MIS structure, the contact resistance can be reduced as compared with a contact by direct bonding between the via 600 made of a metal material and silicon of the semiconductor layer 200S.

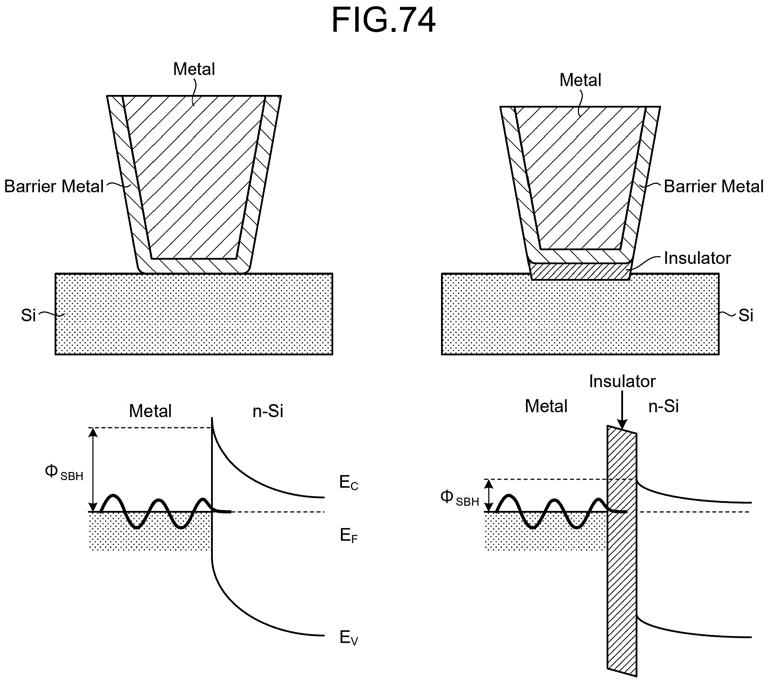

Hereinafter, the principle by which the contact resistance can be reduced by the MIS structure will be described with reference to FIG. 74. FIG. 74 is a schematic diagram for explaining the present embodiment, and specifically, the left side illustrates a basic structure of a direct contact in which metal and silicon are directly connected and an energy band diagram thereof, and the right side illustrates a basic structure of a contact based on a MIS structure and an energy band diagram thereof. Note that the basic structure of the contact illustrated in FIG. 74 is a structure for description and is different from the structure of the via 600 according to the present embodiment.

First, in the case of a direct contact in which a metal and silicon (semiconductor) are directly connected as illustrated on the left side of FIG. 74, electrons leak from the metal to the semiconductor side, so that the bending of the band increases, and thus a Schottky barrier having a high barrier (a portion high in the drawing) is generated at the bonding portion between the metal and the semiconductor. Then, such a Schottky barrier prevents the flow of current, and the contact resistance increases.

On the other hand, as illustrated on the right side of FIG. 74, in the case of a contact having a MIS structure in which a thin insulating film is formed between metal and silicon (semiconductor), electron leakage from the metal to the semiconductor side is prevented by the thin insulating film, and the band is not greatly bent. Therefore, a Schottky barrier having a high barrier does not occur at the bonding portion. Therefore, even though there is a thin insulating film, a current easily flows as compared with a direct contact. As a result, the contact having the MIS structure can reduce the contact resistance as compared with the direct contact. Note that details of the barrier metal illustrated in FIG. 74 will be described later.

### <16.2 Embodiment>

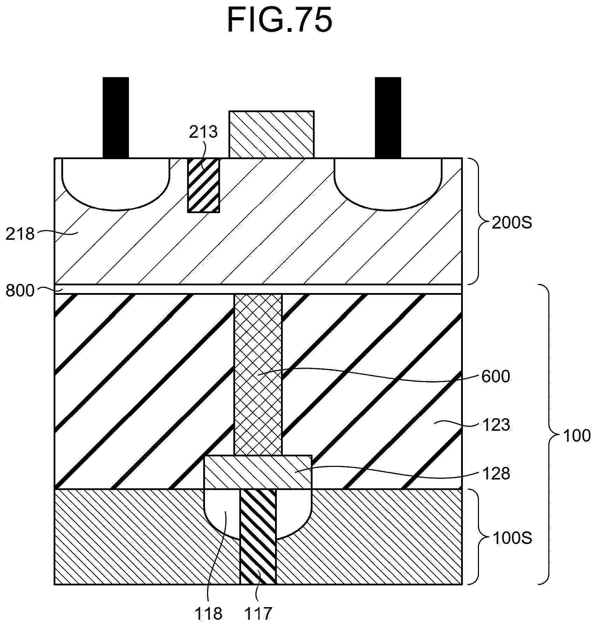

Next, a detailed configuration of an imaging device 1 according to the present embodiment will be described with reference to FIG. 75. FIG. 75 is a schematic diagram illustrating a configuration of an example of a main part of the imaging device 1 according to the present embodiment.

The via 600 according to the present embodiment is formed of, for example, a metal material such as titanium (Ti), titanium nitride (TiN), tungsten (W), or aluminum (Al). Furthermore, in the present embodiment, the via 600 may be formed of polysilicon. In this case, in particular, the contact has a SIS (Semiconductor-Insulator-Semiconductor) structure.

Furthermore, in the present embodiment, as illustrated in FIG. 75, a bonding thin film 800 including a high-κ insulating film having a high relative dielectric constant is provided between the via 600 and the back surface of the second semiconductor substrate 200. In the present embodiment, the bonding thin film 800 may be provided at least between the via 600 and the back surface (second surface) of the second semiconductor substrate 200. Specifically, in the present embodiment, the bonding thin film 800 may cover a part of the back surface of the second semiconductor substrate 200 or may cover the entire back surface.

In the present embodiment, the bonding thin film 800 may be, for example, a single-layer film made of a high-κ insulating film having a high relative dielectric constant. For example, the bonding thin film 800 can be formed of titanium oxide (TiO₂), hafnium oxide (HfO₂), aluminum oxide (Al₂O₃), zirconium oxide (ZrO₂), lanthanum oxide (La₂O₃), or the like. In the present embodiment, in order to reduce an increase in contact resistance due to the insulating film while obtaining an effect of reducing electron leakage from the metal to the semiconductor, the film thickness of the bonding thin film 800 is preferably about 1 to 3 nm when the bonding thin film 800 is formed of a single-layer film.

Furthermore, in the present embodiment, the bonding thin film 800 can also be formed by, for example, stacking a plurality of layers in which different types of high-κ insulating films having high relative dielectric constant are stacked. For example, the bonding thin film 800 can be formed by stacking hafnium oxide (HfO₂), aluminum oxide (Al₂O₃), zirconium oxide (ZrO₂), and lanthanum oxide (La₂O₃) having a film thickness of about 0.5 to 1 nm as the first layer and titanium oxide (TiO₂) having a film thickness of about 1 to 3 nm as the second layer from the via 600 side toward the second semiconductor substrate 200. The insulating film of the first layer functions as the barrier metal illustrated in FIG. 39 and prevents the movement of the metal species from the via 600 even when a high temperature is applied during manufacturing, so that heat resistance can be improved. Note that, even when the bonding thin film 800 is formed by stacking, in order to reduce an increase in contact resistance due to the insulating film while obtaining an effect of reducing electron leakage from the metal to the semiconductor, the film thickness of each layer of the bonding thin film 800 is preferably the film thickness of the above-described value.

Note that, in FIG. 75, the bonding thin film 800 is provided between the via 600 and the back surface of the second semiconductor substrate 200, but the present embodiment is not limited thereto, and may be provided between the via 600 and the front surface (first surface) of the semiconductor layer 100S of the first semiconductor substrate 100. That is, in the present embodiment, the bonding thin film 800 may be provided only between the via 600 and the second semiconductor substrate 200, may be provided only between the via 600 and the first semiconductor substrate 100, or may be provided both between the via 600 and the second semiconductor substrate 200 and between the via 600 and the first semiconductor substrate 100.

As described above, according to the present embodiment, by adopting the contact having the MIS structure (including the SIS structure), the contact resistance can be reduced as compared with the direct contact.

### <<17. Summary>>

As described above, according to the embodiments and modifications of the present disclosure, since the through electrode 121E penetrating the semiconductor layer 200S and the insulating region surrounding the periphery thereof are not provided, the use of the region of the semiconductor layer 200S is not limited. As a result, according to the present embodiment, since the degree of freedom of the layout of the second semiconductor substrate 200 on the semiconductor layer 200S is improved, the imaging device 1 can be further downsized and miniaturized.

Furthermore, in the embodiment of the present disclosure described above, the semiconductor substrate is not necessarily a silicon substrate, and may be another substrate (for example, a silicon on insulator (SOI) substrate, a SiGe substrate, or the like). The semiconductor substrate may have a semiconductor structure or the like formed on such various substrates.

Note that, in the embodiment of the present disclosure described above, the conductivity types of the semiconductor substrates, the semiconductor regions, and the like described above may be reversed, and for example, the present embodiment can be applied to the imaging device 1 using holes as signal charges.

That is, in the embodiment of the present disclosure described above, the imaging device 1 having the photodiode PD in which the first conductivity type is p-type, the second conductivity type is n-type, and electrons are used as signal charges has been described, but the embodiment of the present disclosure is not limited to such an example. For example, the embodiment of the present disclosure can be applied to the imaging device 1 including the photodiode PD in which the first conductivity type is n-type, the second conductivity type is p-type, and holes are used as signal charges.

Furthermore, the imaging device 1 according to the embodiment of the present disclosure is not limited to an imaging device that captures an image as an image in which distribution of the amount of incident light of visible light is detected. For example, the present embodiment can be applied to an imaging device that captures a distribution of incident amounts of infrared rays, X-rays, particles, or the like as an image, or an imaging device (physical quantity distribution detection device) such as a fingerprint detection sensor that detects a distribution of other physical quantities such as pressure and capacitance and captures the distribution as an image. Furthermore, the embodiment of the present disclosure is not limited to being applied to the imaging device 1, and may be applied to various semiconductor devices used in other applications.

Furthermore, in the embodiment of the present disclosure, examples of a method of forming each layer, each film, each element, and the like described above include physical vapor deposition (PVD), chemical vapor deposition (CVD), and the like. Examples of the PVD method include a vacuum vapor deposition method using resistance heating or high frequency heating, an electron beam (EB) vapor deposition method, various sputtering methods (magnetron sputtering method, RF (Radio Frequency)-DC (Direct Current) coupled bias sputtering method, ECR (Electron Cyclotron Resonance) sputtering method, counter target sputtering method, high frequency sputtering method, and the like), an ion plating method, a laser ablation method, a molecular beam epitaxy (MBE) method, and a laser transfer method. Examples of the CVD method include a plasma CVD method, a thermal CVD method, a metal organic (MO)-CVD method, and a photo CVD method. Further, other methods include an electrolytic plating method, an electroless plating method, and a spin coating method; immersion method; cast method; micro-contact printing; drop cast method; various printing methods such as a screen printing method, an inkjet printing method, an offset printing method, a gravure printing method, and a flexographic printing method; stamping method; spray method; various coating methods such as an air doctor coater method, a blade coater method, a rod coater method, a knife coater method, a squeeze coater method, a reverse roll coater method, a transfer roll coater method, a gravure coater method, a kiss coater method, a cast coater method, a spray coater method, a slit orifice coater method, and a calendar coater method. Examples of a patterning method of each layer include chemical etching such as shadow mask, laser transfer, and photolithography, and physical etching using ultraviolet rays, laser, or the like. In addition, examples of the planarization technique include a CMP method, a laser planarization method, and a reflow method. That is, the imaging device 1 according to the embodiment of the present disclosure can be easily and inexpensively manufactured using an existing semiconductor device manufacturing process.

Furthermore, each step in the manufacturing methods according to the embodiments of the present disclosure described above may not necessarily be processed in the described order. For example, each step may be processed in an appropriately changed order. Furthermore, the method used in each step may not necessarily be performed according to the described method, and may be performed by other methods.

Further, the embodiments of the present disclosure can be implemented by combining some or all of the embodiments with each other.

### <<18. Application Example>>

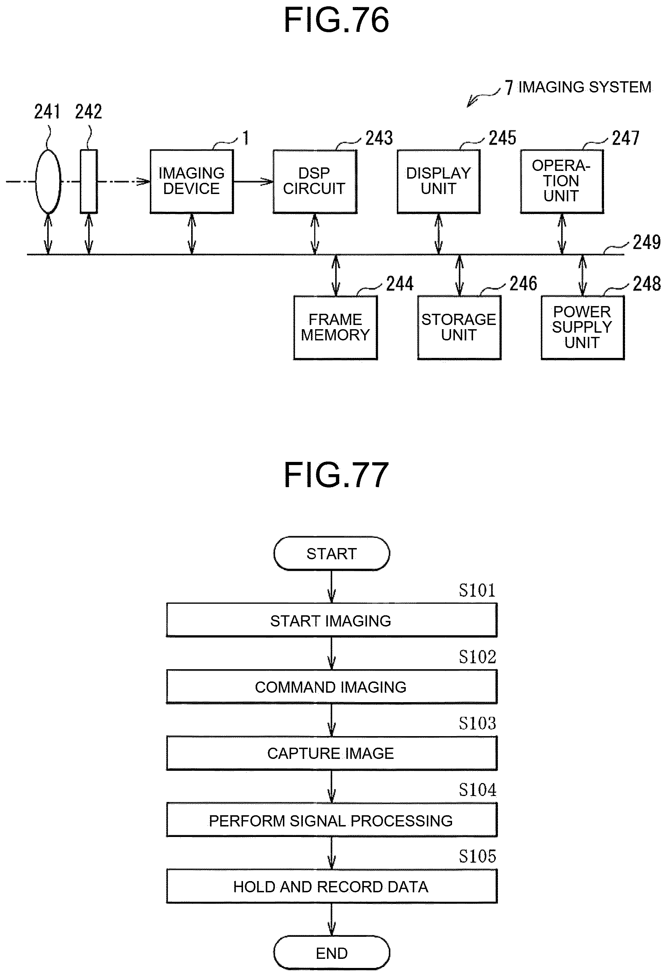

FIG. 76 illustrates an example of a schematic configuration of an imaging system 7 including the imaging device 1 according to an embodiment of the present disclosure.

The imaging system 7 is, for example, an electronic device such as an imaging device such as a digital still camera or a video camera, or a portable terminal device such as a smartphone or a tablet terminal. The imaging system 7 can include, for example, the imaging device 1 according to the embodiment of the present disclosure, a DSP circuit 243, a frame memory 244, a display unit 245, a storage unit 246, an operation unit 247, and a power supply unit 248. For example, in the imaging system 7, the imaging device 1 according to the embodiment of the present disclosure, the DSP circuit 243, the frame memory 244, the display unit 245, the storage unit 246, the operation unit 247, and the power supply unit 248 are connected to each other via a bus line 249. Hereinafter, each functional unit included in the imaging system 7 will be described.

As described above, the imaging device 1 according to the embodiment of the present disclosure can output image data according to incident light. The DSP circuit 243 is a signal processing circuit that processes a signal (image data) output from the imaging device 1 according to the embodiment of the present disclosure. The frame memory 244 can temporarily store the image data processed by the DSP circuit 243 in units of frames. The display unit 245 includes, for example, a panel type display device such as a liquid crystal panel or an organic electro luminescence (EL) panel, and can display a moving image or a still image captured by the imaging device 1 according to the embodiment of the present disclosure. Furthermore, the storage unit 246 can record image data of a moving image or a still image captured by the imaging device 1 according to the embodiment of the present disclosure in a recording medium such as a semiconductor memory or a hard disk. The operation unit 247 can issue operation commands for various functions of the imaging system 7 in accordance with an operation by the user. The power supply unit 248 can appropriately supply various power sources serving as operation power sources of the imaging device 1 according to the embodiment of the present disclosure, the DSP circuit 243, the frame memory 244, the display unit 245, the storage unit 246, and the operation unit 247 to these supply targets.

Next, an imaging procedure in the imaging system 7 will be described.

FIG. 77 illustrates an example of a flowchart of an imaging operation in the imaging system 7. The user instructs start of imaging by operating the operation unit 247 (step S101). Then, the operation unit 247 transmits an imaging command to the imaging device 1 (step S102). Upon receiving the imaging command, the imaging device 1 (specifically, the system control circuit 36) executes imaging by a predetermined imaging method (step S103).

The imaging device 1 outputs image data obtained by imaging to the DSP circuit 243. Here, the image data is data for all the pixels of the pixel signal generated on the basis of the charge temporarily held in the floating diffusion FD. The DSP circuit 243 performs predetermined signal processing (for example, a noise reduction process) based on the image data input from the imaging device 1 (step S104). The DSP circuit 243 causes the frame memory 244 to store the image data subjected to predetermined signal processing, and the frame memory 244 causes the storage unit 246 to store the image data (step S105). In this manner, imaging in the imaging system 7 is performed.

In the present application example, the imaging device 1 according to the embodiment of the present disclosure is applied to the imaging system 7. According to the embodiment of the present disclosure, since the imaging device 1 can be downsized or made high in definition, it is possible to provide the small or high definition imaging system 7.

### Reference Signs List

1 IMAGING DEVICE
7 IMAGING SYSTEM
100, 200, 300 SUBSTRATE
100S, 200S, 300S SEMICONDUCTOR LAYER
100T, 200T, 300T WIRING LAYER
111, 117B INSULATING FILM
112 FIXED CHARGE FILM
113 FIRST PINNING REGION
114 n-TYPE SEMICONDUCTOR REGION
115 p-WELL LAYER
116 SECOND PINNING REGION
117 PIXEL ISOLATION UNIT
117A LIGHT SHIELDING FILM
118, 211, 218 WELL REGION
119, 123, 222 INTERLAYER INSULATING FILM
120, 121, 608, 608a, 608b PAD UNIT
120C CONNECTION VIA
120E, 121E THROUGH ELECTRODE
122, 221 PASSIVATION FILM
124, 125 BONDING FILM
201, 202, 301, 302 CONTACT UNIT
201R, 202R, 301R, 302R CONTACT REGION
210 PIXEL CIRCUIT
212 INSULATING REGION
213 ELEMENT ISOLATION REGION
218V CONNECTION UNIT
220 GATE ELECTRODE
222 FIN
230 NON-DOPED REGION
232 HIGH CONCENTRATION REGION
270 ALIGNMENT MARK
243 DSP CIRCUIT
244 FRAME MEMORY
245 DISPLAY UNIT
246 STORAGE UNIT
247 OPERATION UNIT
248 POWER SUPPLY UNIT
249 BUS LINE
401 LIGHT RECEIVING LENS
510A INPUT UNIT
510B OUTPUT UNIT
511 INPUT TERMINAL
512 INPUT CIRCUIT UNIT
513 INPUT AMPLITUDE CHANGING UNIT
514 INPUT DATA CONVERSION CIRCUIT UNIT
515 OUTPUT DATA CONVERSION CIRCUIT UNIT
516 OUTPUT AMPLITUDE CHANGING UNIT
517 OUTPUT CIRCUIT UNIT
518 OUTPUT TERMINAL
520 ROW DRIVE UNIT
530 TIMING CONTROL UNIT
539 PIXEL SHARING UNIT
540 PIXEL ARRAY UNIT
541, 541A, 541B, 541C, 541D PIXEL
542 ROW DRIVE SIGNAL LINE
543 VERTICAL SIGNAL LINE
544 POWER SUPPLY LINE
550 COLUMN SIGNAL PROCESSING UNIT
560 IMAGE SIGNAL PROCESSING UNIT
600 VIA
600a THROUGH HOLE
602 POLYSILICON
604 COLUMN
606 CONNECTION PAD UNIT
609, 612, 613, 670, 674, 682 FILM
610 GROOVE
611 CONNECTION UNIT
620 CAVITY
622 VOID
630 CENTRAL PORTION
632 OUTER PERIPHERAL PORTION
632a BOTTOM PORTION
634 EMBEDDED FILM
650 PROTRUSION
652, 654 RESIST
656 DOT PATTERN
658 MASK
670, 672, 750, 752, 760 BONDING FILM
680 CAP FILM
700 NATURAL OXIDE FILM
762 POLYSILICON FILM
800 BONDING THIN FILM

## Claims

1. An imaging device (1) comprising:
a first semiconductor substrate (100) provided with a photoelectric conversion element (PD);
a second semiconductor substrate (200) stacked on the first semiconductor substrate (100) with an interlayer insulating film (123) interposed therebetween, the second semiconductor substrate being provided with a pixel circuit (210) that reads out charges generated in the photoelectric conversion element (PD) as a pixel signal; and
a via (600) that penetrates the interlayer insulating film (123) and electrically connects a first surface of the first semiconductor substrate (100) facing the second semiconductor substrate (200) and at least a part of a second surface of the second semiconductor substrate (200) facing the first surface.

2. The imaging device (1) according to claim 1, wherein a first well region (118) provided in the first semiconductor substrate (100) and a second well region (218) located on a part of the second surface in the second semiconductor substrate (200) contain impurities having a same conductivity type.

3. The imaging device (1) according to claim 2, wherein
the second well region (218) includes a first region (232) and a second region (218), and
the concentration of the impurity in the first region (232) is higher than that in the second region (218).

4. The imaging device (1) according to any one of claims 2 to 4, wherein the second semiconductor substrate (200) has a non-doped region (230) not containing the impurities on the second surface side, the imaging device (1) further comprising a fully depleted transistor having a channel located in the non-doped region (230).

5. The imaging device (1) according to any one of claims 2 to 4, wherein the second semiconductor substrate (200) has an insulating film region (212) on the second surface side.

6. The imaging device (1) according to claim 2, further comprising:
one or a plurality of bonding films (124;125) provided between the second semiconductor substrate (200) and the via (600), wherein
at least one of the bonding films (124;125;750) contains the impurities having the same conductivity type as the first well region (118) and the second well region (218).

7. The imaging device (1) according to claim 6, wherein
the bonding film (124;125) containing the impurities is made of BSG or PSG, or wherein
the bonding film (124;125) containing the impurities is made of polysilicon or amorphous silicon and the bonding film (124;125) containing the impurities is provided so as to be embedded in the second surface of the second semiconductor substrate (200), or wherein
the impurity concentration in the second substrate decreases from the second surface side along the stacking direction.

8. The imaging device according to claim 2, further comprising:
a bonding film (125) provided between the second semiconductor substrate (200) and the via (600), wherein
the bonding film (124;125) is made of a conductive oxide film and a metal film or a silicide film.

9. The imaging device (1) according to claim 6 or 7, wherein the via (600) is made of polysilicon or amorphous silicon containing the impurities having the same conductivity type as the first well region (118) and the second well region (218), and wherein the impurity concentration of the via (600) increases from the first surface side along the stacking direction.

10. The imaging device (1) according to claim 2, wherein an upper surface of the via (600) located on the second surface side has a protrusion protruding to the second semiconductor substrate (200).

11. The imaging device (1) according to claim 10, wherein
at least a tip of the protrusion is in contact with the second surface of the second semiconductor substrate (200) or embedded in the second semiconductor substrate (200), and/or wherein
an upper surface of the via (600) has a plurality of the protrusions, and/or wherein
the via (600) includes the impurities having the same conductivity type as the first well region (118) and the second well region (218), and the impurity concentration of the protrusion is higher than the impurity concentration of the via (600).

12. The imaging device (1) according to any one of claims 1 to 11, further comprising a first pad unit (121) provided on the first surface of the first semiconductor substrate (100) and electrically connected to the via (600), and/or further comprising a second pad unit (608) provided on the second surface of the second semiconductor substrate (200) and electrically connected to the via (600).

13. The imaging device (1) according to claim 1, wherein
the via (600) includes:
a plurality of columns (604) penetrating a part of the interlayer insulating film (123); and
one or a plurality of connection pad units (606) provided in the interlayer insulating film (123) and electrically connecting the columns (604) to each other.

14. The imaging device (1) according to claim 1, wherein
the via (600) includes:
a central portion (630) extending in a direction substantially perpendicular to the first surface of the first semiconductor substrate (100); and
an outer peripheral portion provided so as to surround the central portion (630).

15. A method of manufacturing an imaging device (1), the method comprising:
stacking an interlayer insulating film (123) on a first semiconductor substrate (100) provided with a photoelectric conversion element (PD);
forming a through hole (600a) in the interlayer insulating film (123);
embedding polysilicon in the through hole (600a);
removing a portion of the embedded polysilicon protruding from the through hole (600a); and
attaching a second semiconductor substrate (200) on the interlayer insulating film (123) in which the through hole (600a) has been formed, the second semiconductor substrate being provided with a pixel circuit (210) that reads out charges generated in the photoelectric conversion element (PD) as a pixel signal.

## Patentansprüche

1. Bildgebungsvorrichtung (1), umfassend:
ein erstes Halbleitersubstrat (100), das mit einem photoelektrischen Wandlerelement (PD) versehen ist;
ein zweites Halbleitersubstrat (200), das auf das erste Halbleitersubstrat (100) gestapelt ist, wobei ein Zwischenschicht-Isolierfilm (123) dazwischen angeordnet ist, wobei das zweite Halbleitersubstrat mit einer Pixelschaltung (210) versehen ist, die in dem photoelektrischen Wandlerelement (PD) erzeugte Ladungen als ein Pixelsignal ausliest; und
eine Durchkontaktierung (600), die den Zwischenschicht-Isolierfilm (123) durchdringt und eine erste Oberfläche des ersten Halbleitersubstrats (100), die dem zweiten Halbleitersubstrat (200) zugewandt ist, und mindestens einen Teil einer zweiten Oberfläche des zweiten Halbleitersubstrats (200), die der ersten Oberfläche zugewandt ist, elektrisch verbindet.

2. Bildgebungsvorrichtung (1) nach Anspruch 1, worin ein erster Wannenbereich (118), der in dem ersten Halbleitersubstrat (100) bereitgestellt ist, und ein zweiter Wannenbereich (218), der sich auf einem Teil der zweiten Oberfläche in dem zweiten Halbleitersubstrat (200) befindet, Verunreinigungen mit demselben Leitfähigkeitstyp enthalten.

3. Bildgebungsvorrichtung (1) nach Anspruch 2, wobei
der zweite Wannenbereich (218) einen ersten Bereich (232) und einen zweiten Bereich (218) einschließt, und
die Konzentration der Verunreinigung in dem ersten Bereich (232) höher ist als die in dem zweiten Bereich (218).

4. Bildgebungsvorrichtung (1) nach einem der Ansprüche 2 bis 4, wobei das zweite Halbleitersubstrat (200) einen nicht dotierten Bereich (230) aufweist, der die Verunreinigungen auf der Seite der zweiten Oberfläche nicht enthält, wobei die Bildgebungsvorrichtung (1) ferner einen vollständig verarmten Transistor umfasst, der einen Kanal aufweist, der sich in dem nicht dotierten Bereich (230) befindet.

5. Bildgebungsvorrichtung (1) nach einem der Ansprüche 2 bis 4, wobei das zweite Halbleitersubstrat (200) einen Isolierfilmbereich (212) auf der Seite der zweiten Oberfläche aufweist.

6. Bildgebungsvorrichtung (1) nach Anspruch 2, ferner umfassend:
einen oder eine Vielzahl von Bondingfilmen (124; 125), die zwischen dem zweiten Halbleitersubstrat (200) und der Durchkontaktierung (600) bereitgestellt sind, wobei
mindestens einer der Bondingfilme (124; 125; 750) die Verunreinigungen mit demselben Leitfähigkeitstyp wie der erste Wannenbereich (118) und der zweite Wannenbereich (218) enthält.

7. Bildgebungsvorrichtung (1) nach Anspruch 6, wobei
der Bondingfilm (124; 125), der die Verunreinigungen enthält, aus BSG oder PSG hergestellt ist, oder wobei
der Bondingfilm (124; 125), der die Verunreinigungen enthält, aus Polysilicium oder amorphem Silicium hergestellt ist, und der Bondingfilm (124; 125), der die Verunreinigungen enthält, so bereitgestellt ist, dass er in die zweite Oberfläche des zweiten Halbleitersubstrats (200) eingebettet ist, oder wobei
die Verunreinigungskonzentration in dem zweiten Substrat von der Seite der zweiten Oberfläche aus entlang der Stapelrichtung abnimmt.

8. Bildgebungsvorrichtung nach Anspruch 2, ferner umfassend:
einen Bondingfilm (125), der zwischen dem zweiten Halbleitersubstrat (200) und der Durchkontaktierung (600) bereitgestellt ist, wobei
der Bondingfilm (124; 125) aus einem leitfähigen Oxidfilm und einem Metallfilm oder einem Silizidfilm hergestellt ist.

9. Bildgebungsvorrichtung (1) nach Anspruch 6 oder 7, wobei die Durchkontaktierung (600) aus Polysilicium oder amorphem Silicium hergestellt ist, das die Verunreinigungen mit demselben Leitfähigkeitstyp wie der erste Wannenbereich (118) und der zweite Wannenbereich (218) enthält, und wobei die Verunreinigungskonzentration der Durchkontaktierung (600) von der Seite der ersten Oberfläche aus entlang der Stapelrichtung zunimmt.

10. Bildgebungsvorrichtung (1) nach Anspruch 2, wobei eine obere Oberfläche der Durchkontaktierung (600), die sich auf der Seite der zweiten Oberfläche befindet, einen Vorsprung aufweist, der zu dem zweiten Halbleitersubstrat (200) vorsteht.

11. Bildgebungsvorrichtung (1) nach Anspruch 10, wobei
mindestens eine Spitze des Vorsprungs in Kontakt mit der zweiten Oberfläche des zweiten Halbleitersubstrats (200) steht oder in das zweite Halbleitersubstrat (200) eingebettet ist, und/oder wobei
eine obere Oberfläche der Durchkontaktierung (600) eine Vielzahl der Vorsprünge aufweist, und/oder wobei
die Durchkontaktierung (600) die Verunreinigungen mit demselben Leitfähigkeitstyp wie der erste Wannenbereich (118) und der zweite Wannenbereich (218) einschließt, und die Verunreinigungskonzentration des Vorsprungs höher ist als die Verunreinigungskonzentration der Durchkontaktierung (600).

12. Bildgebungsvorrichtung (1) nach einem der Ansprüche 1 bis 11, ferner umfassend eine erste Pad-Einheit (121), die auf der ersten Oberfläche des ersten Halbleitersubstrats (100) bereitgestellt ist und elektrisch mit der Durchkontaktierung (600) verbunden ist, und/oder ferner umfassend eine zweite Pad-Einheit (608), die auf der zweiten Oberfläche des zweiten Halbleitersubstrats (200) bereitgestellt ist und elektrisch mit der Durchkontaktierung (600) verbunden ist.

13. Bildgebungsvorrichtung (1) nach Anspruch 1, wobei
die Durchkontaktierung (600) einschließt:
eine Vielzahl von Säulen (604), die einen Teil des Zwischenschicht-Isolierfilms (123) durchdringen; und
eine oder eine Vielzahl von Verbindungspad-Einheiten (606), die in dem Zwischenschicht-Isolierfilm (123) bereitgestellt sind und die Säulen (604) elektrisch miteinander verbinden.

14. Bildgebungsvorrichtung (1) nach Anspruch 1, wobei
die Durchkontaktierung (600) einschließt:
einen zentralen Abschnitt (630), der sich in einer Richtung erstreckt, die im Wesentlichen senkrecht zu der ersten Oberfläche des ersten Halbleitersubstrats (100) verläuft; und
einen äußeren Umfangsabschnitt, der so bereitgestellt ist, dass er den zentralen Abschnitt (630) umgibt.

15. Verfahren zum Herstellen einer Bildgebungsvorrichtung (1), wobei das Verfahren umfasst:
Stapeln eines Zwischenschicht-Isolierfilms (123) auf einem ersten Halbleitersubstrat (100), das mit einem photoelektrischen Wandlerelement (PD) versehen ist;
Bilden eines Durchgangslochs (600a) in dem Zwischenschicht-Isolierfilm (123);
Einbetten von Polysilicium in das Durchgangsloch (600a);
Entfernen eines Abschnitts des eingebetteten Polysiliciums, der aus dem Durchgangsloch (600a) herausragt; und
Befestigen eines zweiten Halbleitersubstrats (200) auf dem Zwischenschicht-Isolierfilm (123), in dem das Durchgangsloch (600a) gebildet wurde, wobei das zweite Halbleitersubstrat mit einer Pixelschaltung (210) versehen wird, die in dem photoelektrischen Wandlerelement (PD) erzeugte Ladungen als ein Pixelsignal ausliest.

## Revendications

1. Dispositif d'imagerie (1) comprenant :
un premier substrat semi-conducteur (100) fourni avec un élément de conversion photoélectrique (PD) ;
un second substrat semi-conducteur (200) empilé sur le premier substrat semi-conducteur (100) avec un film isolant intercouche (123) interposé entre les deux, le second substrat semi-conducteur étant fourni avec un circuit de pixel (210) qui lit les charges générées dans l'élément de conversion photoélectrique (PD) sous la forme d'un signal de pixel ; et
un via (600) qui traverse le film isolant intercouche (123) et relie électriquement une première surface du premier substrat semi-conducteur (100) faisant face au second substrat semi-conducteur (200) et au moins une partie d'une seconde surface du second substrat semi-conducteur (200) faisant face à la première surface.

2. Dispositif d'imagerie (1) selon la revendication 1, dans lequel une première région de puits (118) située dans le premier substrat semi-conducteur (100) et une seconde région de puits (218) située sur une partie de la seconde surface dans le second substrat semi-conducteur (200) contiennent des impuretés ayant le même type de conductivité.

3. Dispositif d'imagerie (1) selon la revendication 2, dans lequel
la seconde région de puits (218) comprend une première région (232) et une seconde région (218), et
la concentration de l'impureté dans la première région (232) est supérieure à celle de la seconde région (218).

4. Dispositif d'imagerie (1) selon l'une quelconque des revendications 2 à 4, dans lequel le second substrat semi-conducteur (200) a une région non dopée (230) ne contenant pas les impuretés sur le second côté de la surface, le dispositif d'imagerie (1) comprenant en outre un transistor entièrement appauvri ayant un canal situé dans la région non dopée (230).

5. Dispositif d'imagerie (1) selon l'une quelconque des revendications 2 à 4, dans lequel le second substrat semi-conducteur (200) a une région de film isolant (212) sur la seconde face de la surface.

6. Dispositif d'imagerie (1) selon la revendication 2, comprenant en outre :
un ou une pluralité de films de liaison (124 ;125) fournis entre le second substrat semi-conducteur (200) et le via (600), dans lequel
au moins un des films de liaison (124 ;125 ;750) contient les impuretés ayant le même type de conductivité que la première région de puits (118) et la seconde région de puits (218).

7. Dispositif d'imagerie (1) selon la revendication 6, dans lequel
le film de liaison (124 ;125) contenant les impuretés est constitué de BSG ou de PSG, ou dans lequel
le film de liaison (124 ;125) contenant les impuretés est en polysilicium ou en silicium amorphe et le film de liaison (124 ;125) contenant les impuretés est fourni de manière à être incorporé dans la seconde surface du second substrat semi-conducteur (200), ou dans lequel
la concentration d'impuretés dans le second substrat diminue à partir du second côté de la surface le long de la direction d'empilement.

8. Dispositif d'imagerie selon la revendication 2, comprenant en outre :
un film de liaison (125) placé entre le second substrat semi-conducteur (200) et le via (600), dans lequel
le film de liaison (124 ;125) est constitué d'un film d'oxyde conducteur et d'un film métallique ou d'un film de siliciure.

9. Dispositif d'imagerie (1) selon la revendication 6 ou 7, dans lequel le via (600) est fait de polysilicium ou de silicium amorphe contenant des impuretés ayant le même type de conductivité que la première région de puits (118) et la seconde région de puits (218), et dans lequel la concentration d'impuretés du via (600) augmente à partir du côté de la première surface le long de la direction d'empilement.

10. Dispositif d'imagerie (1) selon la revendication 2, dans lequel une surface supérieure du via (600) situé sur le second côté de la surface présente une protubérance faisant saillie sur le second substrat semi-conducteur (200).

11. Dispositif d'imagerie (1) selon la revendication 10, dans lequel
au moins une pointe de la protubérance est en contact avec la seconde surface du second substrat semi-conducteur (200) ou incorporée dans le second substrat semi-conducteur (200), et/ou dans lequel
une surface supérieure du via (600) comporte une pluralité de protubérances, et/ou dans lequel
le via (600) comporte des impuretés ayant le même type de conductivité que la première région de puits (118) et la seconde région de puits (218), et la concentration d'impuretés de la protubérance est supérieure à la concentration d'impuretés du via (600).

12. Dispositif d'imagerie (1) selon l'une quelconque des revendications 1 à 11, comprenant en outre une première unité de tampon (121) fournie sur la première surface du premier substrat semi-conducteur (100) et connectée électriquement au via (600), et/ou comprenant en outre une seconde unité de tampon (608) placée sur la seconde surface du second substrat semi-conducteur (200) et connectée électriquement au via (600).

13. Dispositif d'imagerie (1) selon la revendication 1, dans lequel
le via (600) comporte :
une pluralité de colonnes (604) pénétrant dans une partie du film isolant intercalaire (123) ; et
une ou une pluralité d'unités de tampon de connexion (606) fournies dans le film isolant intercalaire (123) et reliant électriquement les colonnes (604) les unes aux autres.

14. Dispositif d'imagerie (1) selon la revendication 1, dans lequel
le via (600) comporte :
une partie centrale (630) s'étendant dans une direction sensiblement perpendiculaire à la première surface du premier substrat semi-conducteur (100) ; et
une partie périphérique extérieure fournie de manière à entourer la partie centrale (630).

15. Procédé de fabrication d'un dispositif d'imagerie (1), le procédé comprenant :
l'empilement d'un film isolant intercouche (123) sur un premier substrat semi-conducteur (100) fourni avec un élément de conversion photoélectrique (PD) ;
la formation d'un trou traversant (600a) dans le film isolant intercalaire (123) ;
l'incorporation du polysilicium dans le trou traversant (600a) ;
le retrait d'une partie du polysilicium incorporé dépassant du trou traversant (600a) ; et
la fixation d'un second substrat semi-conducteur (200) sur le film isolant intercouche (123) dans lequel le trou traversant (600a) a été formé, le second substrat semi-conducteur étant fourni avec un circuit de pixel (210) qui lit les charges générées dans l'élément de conversion photoélectrique (PD) sous la forme d'un signal de pixel.
